# EUROPEAN PATENT APPLICATION

(11) **EP 4 496 448 A1**
(43) Date of publication of application: **22.01.2025**
(21) Application number: 24166002.6
(22) Date of filing: 25.03.2024
(51) Int. Cl.: H10B 12/00

(54) **SEMICONDUCTOR DEVICE AND METHOD OF FABRICATING THE SAME**

(30) Priority: 19.07.2023 KR 20230094022
(71) Applicant: Samsung Electronics Co., Ltd., Suwon-si, Gyeonggi-do 16677 (KR)
(72) Inventor: KANG, Minju, 16677 Suwon-si (KR); KIM, Jongmin, 16677 Suwon-si (KR); PARK, SangJae, 16677 Suwon-si (KR); PARK, Sohyun, 16677 Suwon-si (KR); LEE, Kiseok, 16677 Suwon-si (KR)
(74) Representative: Marks & Clerk LLP

(57) **Abstract**

A semiconductor device includes a first active pattern including a first edge portion and a second edge portion spaced apart from the first edge portion in a first direction, a first word line between the first edge portion and the second edge portion and extending in a second direction intersecting the first direction, a bit line on the first edge portion and extending in a third direction intersecting the first direction and the second direction, and a storage node contact on the second edge portion, where the first edge portion includes a first top surface and a second top surface, and the second top surface of the first edge portion is closer to the second edge portion than the first top surface of the first edge portion.

## Description

### BACKGROUND

Example embodiments of the present disclosure relate to a semiconductor device and a method of fabricating the same.

Due to the small-size, multifunctional, and/or low-cost characteristics of semiconductor devices, semiconductor devices are increasing in importance in the electronic industry. Semiconductor devices may be classified into a semiconductor memory device for storing data, a semiconductor logic device for processing data, and a hybrid semiconductor device including both of memory logic elements, etc.

Due to increasing demand for electronic devices with a fast speed and/or low power consumption, the semiconductor device may require a fast operating speed and/or a low operating voltage. To satisfy the requirement, it may be required to increase an integration density of the semiconductor device.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments of the disclosure provide a method of easily fabricating a highly-integrated semiconductor device and a semiconductor device fabricated thereby.

One or more example embodiments of the disclosure provide a semiconductor device with improved electrical and reliability characteristics and a method of fabricating the same.

Additional aspects will be set forth in part in the description which follows and, in part, will be apparent from the description, or may be learned by practice of the presented embodiments.

According to an aspect of an example embodiment, a semiconductor device may include a first active pattern including a first edge portion and a second edge portion spaced apart from the first edge portion in a first direction, a first word line between the first edge portion and the second edge portion and extending in a second direction intersecting the first direction, a bit line on the first edge portion and extending in a third direction intersecting the first direction and the second direction, and a storage node contact on the second edge portion, where the first edge portion includes a first top surface and a second top surface, the second top surface of the first edge portion is closer to the second edge portion than the first top surface of the first edge portion, and the first top surface of the first edge portion is at a level that is higher than a level of the second top surface of the first edge portion.

According to an aspect of an example embodiment, a semiconductor device may include a first active pattern including a first edge portion and a second edge portion spaced apart from the first edge portion in a first direction, a word line between the first edge portion and the second edge portion and extending in a second direction intersecting the first direction, a bit line on the first edge portion and extending in a third direction intersecting the first direction and the second direction, and a storage node contact on the second edge portion, where the first edge portion includes an upper portion and a lower portion and the upper portion of the first edge portion is recessed in the second direction such that a width of the upper portion of the first edge portion in the second direction is less than a width of the lower portion of the first edge portion in the second direction.

According to an aspect of an example embodiment, a semiconductor device may include an active pattern including a first edge portion and a second edge portion spaced apart from the first edge portion in a first direction, a word line between the first edge portion and the second edge portion and extending in a second direction intersecting the first direction, a bit line on the first edge portion and extending in a third direction intersecting the first direction and the second direction, and a storage node contact on the second edge portion, where the first edge portion includes a first side surface and a second side surface, the second side surface of the first edge portion is closer to the second edge portion than the first side surface of the first edge portion, the first side surface of the first edge portion has a linear profile, and the second side surface of the first edge portion has a stepwise profile.

At least some of the above and other features of the invention are set out in the claims.

### BRIEF DESCRIPTION

The above and other aspects, features, and advantages of certain example embodiments of the present disclosure will be more apparent from the following description taken in conjunction with the accompanying drawings, in which:
FIG. 1A is a plan view illustrating a semiconductor device according to one or more embodiments of the disclosure;
FIG. 1B is an enlarged plan view illustrating a portion of the semiconductor device of FIG. 1A according to one or more embodiments of the disclosure;
FIGS. 2A to 2E are cross-sectional views corresponding to lines A-A', B-B', C-C', D-D', and E-E' of FIG. 1A, respectively, according to one or more embodiments of the disclosure;
FIGS. 3A to 3F are plan views illustrating semiconductor devices according to one or more embodiments of the disclosure;
FIG. 4 is a cross-sectional view corresponding to the line C-C' of FIG. 1A according to one or more embodiments of the disclosure;
FIG. 5 is a plan view illustrating a semiconductor device according to one or more embodiments of the disclosure;
FIGS. 6A to 6D are cross-sectional views corresponding to lines A-A', B-B', C-C', and D-D' of FIG. 5, respectively, according to one or more embodiments of the disclosure;
FIGS. 7A and 7B are cross-sectional views corresponding to the lines B-B' and D-D' of FIG. 1A, respectively, according to one or more embodiments of the disclosure;
FIG. 8 is a plan view illustrating a semiconductor device according to one or more embodiments of the disclosure;
FIGS. 9A and 9B are cross-sectional views corresponding to lines D-D' and E-E' of FIG. 8, respectively, according to one or more embodiments of the disclosure;
FIGS. 10A and 10B are cross-sectional views corresponding to the lines D-D' and E-E' of FIG. 1A, according to one or more embodiments of the disclosure;
FIG. 11 is a plan view illustrating a semiconductor device according to one or more embodiments of the disclosure;
FIGS. 12A to 12D are cross-sectional views corresponding to lines A-A', B-B', D-D', and E-E' of FIG. 11, respectively, according to one or more embodiments of the disclosure;
FIG. 13 is a plan view illustrating a semiconductor device according to one or more embodiments of the disclosure;
FIGS. 14A to 14E are cross-sectional views corresponding to lines A-A', B-B', C-C', D-D', and E-E' of FIG. 13, respectively, according to one or more embodiments of the disclosure;
FIG. 15 is a plan view illustrating a semiconductor device according to one or more embodiments of the disclosure;
FIGS. 16A to 16D are cross-sectional views corresponding to lines A-A', B-B', C-C', and D-D' of FIG. 15, respectively, according to one or more embodiments of the disclosure;
FIG. 17 is a cross-sectional view corresponding to the line A-A' of FIG. 15, according to one or more embodiments of the disclosure;
FIG. 18 is a plan view illustrating a semiconductor device according to one or more embodiments of the disclosure;
FIGS. 19A to 19E are cross-sectional views corresponding to lines A-A', B-B', C-C', D-D', and E-E' of FIG. 18, respectively, according to one or more embodiments of the disclosure;
FIG. 20 is a plan view illustrating a semiconductor device according to one or more embodiments of the disclosure;
FIG. 21 is a cross-sectional view corresponding to a line A-A' of FIG. 20, according to one or more embodiments of the disclosure;
FIGS. 22 to 33E are diagrams illustrating a method of fabricating a semiconductor device, according to one or more embodiments of the disclosure;
FIGS. 34 to 39C are diagrams illustrating a method of fabricating a semiconductor device, according to one or more embodiments of the disclosure;
FIG. 40 is a cross-sectional view illustrating a method of fabricating a semiconductor device, according to one or more embodiments of the disclosure;
FIGS. 41 to 44D are diagrams illustrating a method of fabricating a semiconductor device, according to one or more embodiments of the disclosure;
FIGS. 45A and 45B are diagrams illustrating a method of fabricating a semiconductor device, according to one or more embodiments of the disclosure;
FIGS. 46 and 47 are diagrams illustrating a method of fabricating a semiconductor device, according to one or more embodiments of the disclosure;
FIGS. 48 to 51C are diagrams illustrating a method of fabricating a semiconductor device, according to one or more embodiments of the disclosure;
FIGS. 52A to 52E are diagrams illustrating a method of fabricating a semiconductor device, according to one or more embodiments of the disclosure;
FIGS. 53 to 56C are diagrams illustrating a method of fabricating a semiconductor device, according to one or more embodiments of the disclosure;
FIGS. 57 and 58 are diagrams illustrating a method of fabricating a semiconductor device, according to one or more embodiments of the disclosure; and
FIGS. 59A to 59C are diagrams illustrating a method of fabricating a semiconductor device, according to one or more embodiments of the disclosure.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper", "middle", "lower" may refer to relative positions along a particular direction (e.g. a vertical direction). A height position maybe a position along the vertical direction. Various directions (e.g. vertical direction, horizontal direction, etc.) may be defined relative to the structure of the devices described herein. For instance, a vertical direction may be defined perpendicular to a bottom surface of a substrate. It will be appreciated that these directions do not necessarily imply any particular orientation of the device in use.

The terms "first", "second", third" may be used to describe various elements but the elements are not limited by the terms and a "first element" may be referred to as a "second element". Alternatively or additionally, the terms "first", "second", "third", etc. may be used to distinguish components from each other and do not limit the present disclosure. For example, the terms "first", "second", "third", etc. may not necessarily involve an order or a numerical meaning of any form.

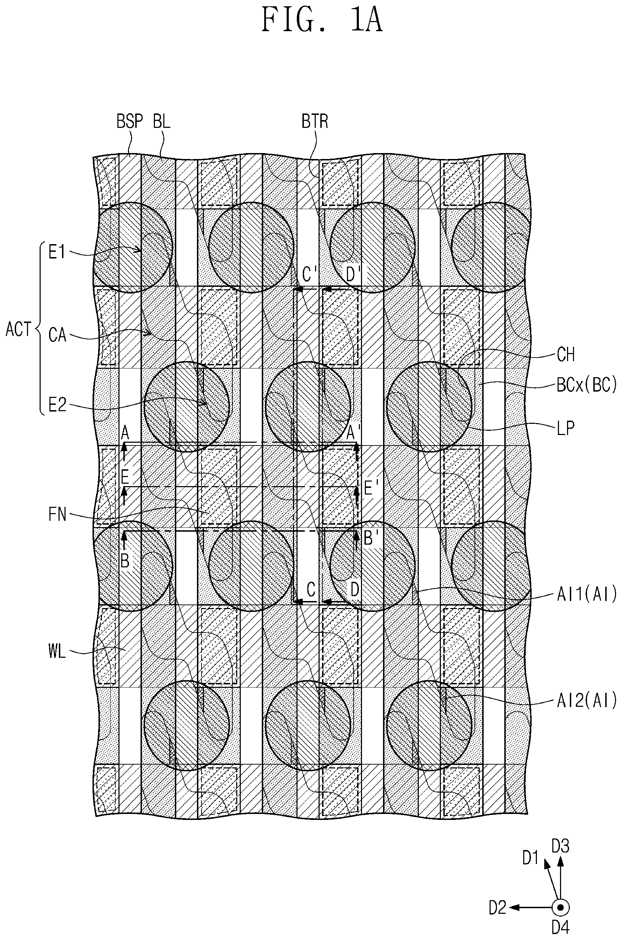

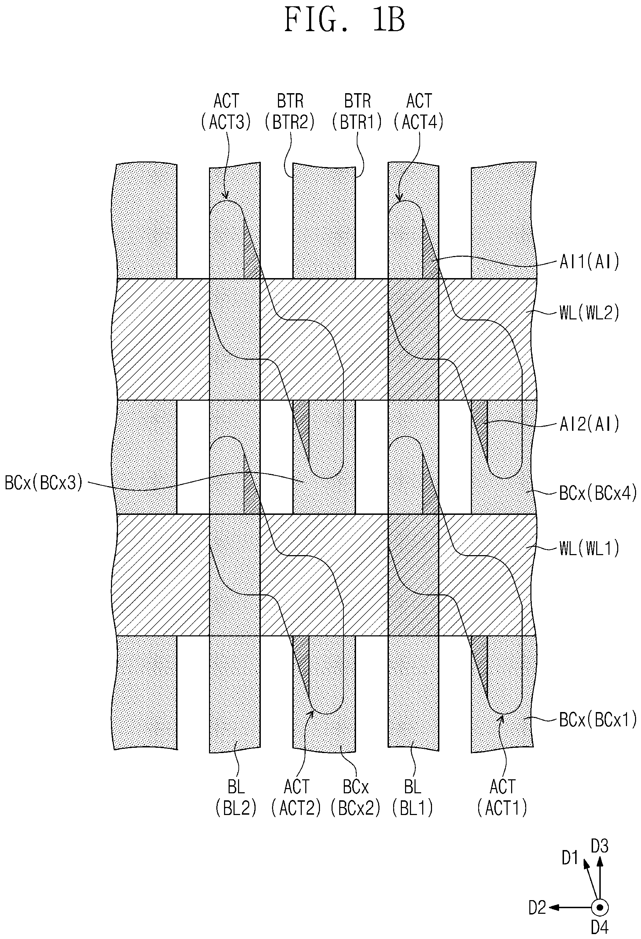

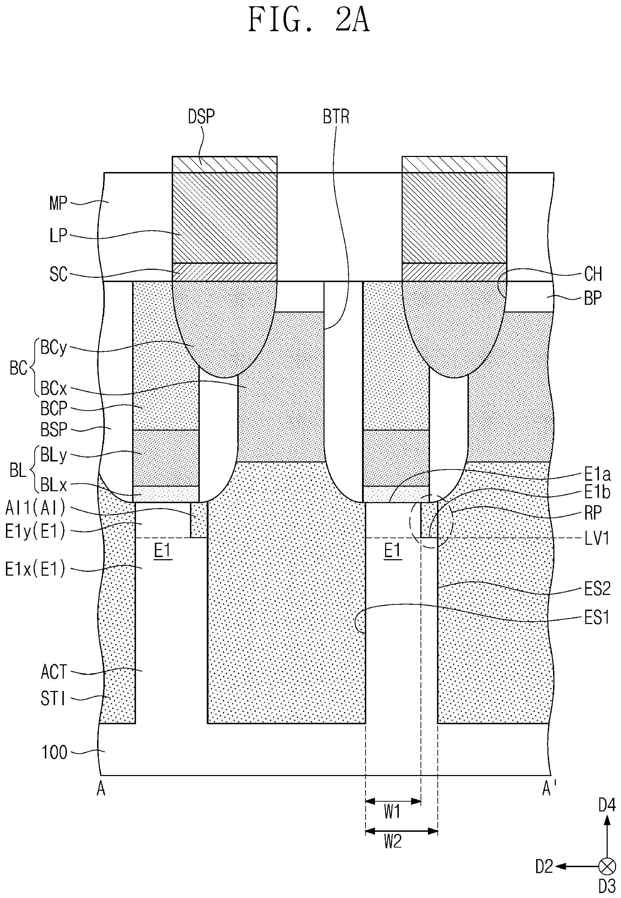

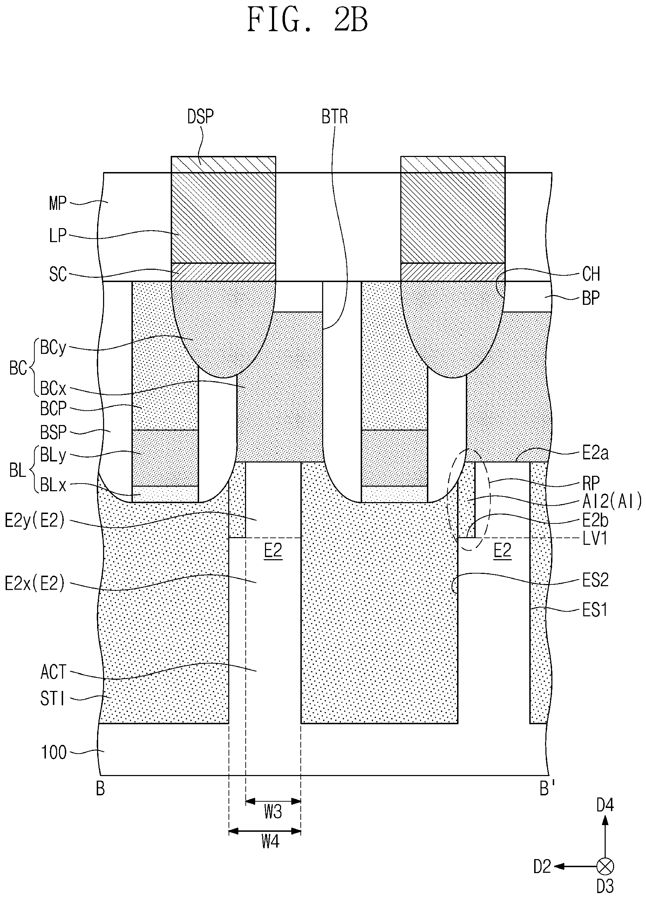

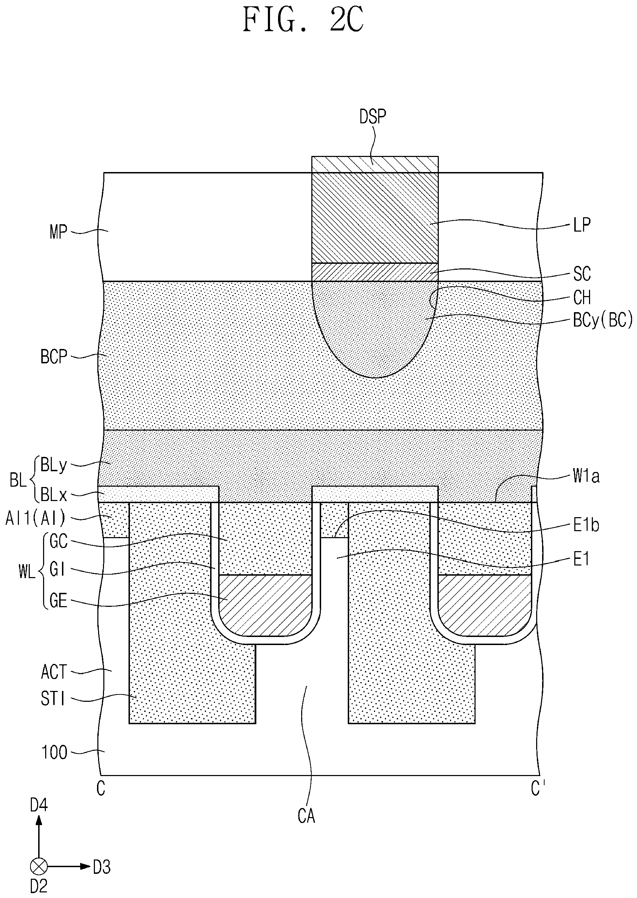

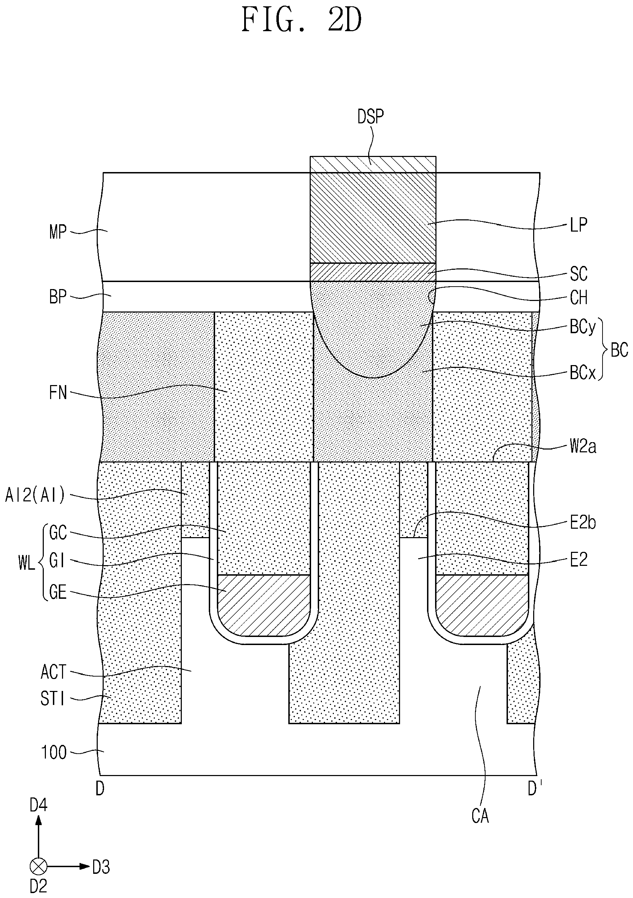

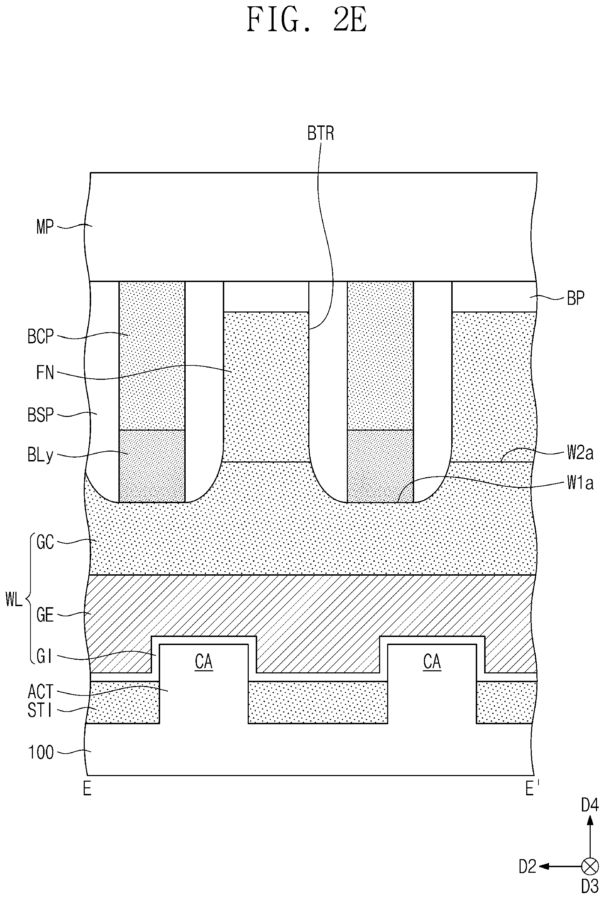

FIG. 1A is a plan view illustrating a semiconductor device according to one or more embodiments of the disclosure. FIG. 1B is an enlarged plan view illustrating a portion of the semiconductor device of FIG. 1A according to one or more embodiments of the disclosure. FIGS. 2A to 2E are cross-sectional views corresponding to lines A-A', B-B', C-C', D-D', and E-E' of FIG. 1A, respectively, according to one or more embodiments of the disclosure.

Referring to FIGS. 1A and 2A to 2E, a substrate 100 may be provided. The substrate 100 may be a semiconductor substrate (e.g., a silicon wafer, a germanium wafer, or a silicon-germanium wafer).

A device isolation pattern STI may be disposed in or on the substrate 100 to define an active pattern ACT. In an embodiment, a plurality of active patterns ACT may be provided. The active patterns ACT may include portions of the substrate 100 enclosed by the device isolation pattern STI. The term "substrate 100" may refer to the remaining portion of the substrate 100, excluding the afore-described portions of the substrate 100, unless otherwise stated. The device isolation pattern STI may be formed of or include at least one insulating material (e.g., silicon oxide (SiO₂) and silicon nitride (SiN)). The device isolation pattern STI may be a single layer, which is made of a single material, or a composite layer including two or more materials.

Each of the active patterns ACT may be a pattern that is elongated in a first direction D1 parallel to a bottom surface of the substrate 100. The active patterns ACT may be spaced apart from each other in a second direction D2 and a third direction D3, which are parallel to the bottom surface of the substrate 100 and are non-parallel to each other (e.g. intersect each other). The first, second, and third directions D1, D2, and D3 may not be parallel to each other (e.g. intersect each other). The active patterns ACT may protrude in a fourth direction D4 (e.g. a vertical direction) that is perpendicular to the bottom surface of the substrate 100. The fourth direction D4 may define a height direction for the semiconductor device. Accordingly, components or features that are located further along the fourth direction D4 (e.g. further from the substrate 100) that components or features may be considered "higher" than those other components or features. In an embodiment, the active pattern ACT may be formed of or include silicon (e.g., single-crystalline silicon).

The active pattern ACT may include a first edge portion E1 and a second edge portion E2, which are spaced apart from each other in the first direction D1, and a center portion CA therebetween. The first and second edge portions E1 and E2 may be end portions of the active pattern ACT, which are opposite to each other in the first direction D1. The center portion CA may be provided below a word line WL, which is disposed to cross the active pattern ACT and will be described below. The word line WL may be positioned vertically above the center portion CA of the active pattern ACT. The center portions CA of the active patterns ACT may be spaced apart from each other in the second and third directions D2 and D3.

Each of the first and second edge portions E1 and E2 and the center portion CA may include impurity regions that are doped with impurities (e.g., n- or p-type impurities). The impurity region may be used as one of the source, drain, and channel regions of a transistor.

The active patterns ACT, which are adjacent to each other, may be disposed side by side in one of the second and third directions D2 and D3 or opposite directions of the second and third directions D2 and D3. The expression "adjacent ones of the active patterns ACT are disposed side by side in a specific direction" may indicate that the first edge portions E1 of the active patterns ACT, which are adjacent to each other, are arranged in the specific direction.

Referring to FIG. 1B, a first active pattern ACT1, a second active pattern ACT2, a third active pattern ACT3, and a fourth active pattern ACT4 may be disposed. The first active pattern ACT1 and the second active pattern ACT2, which are next to each other, may be arranged side by side in the second direction D2. The fourth active pattern ACT4 and the third active pattern ACT3, which are next to each other, may be arranged side by side in the second direction D2. The first active pattern ACT1 and the fourth active pattern ACT4, which are next to each other, may be arranged side by side in the third direction D3. The second active pattern ACT2 and the third active pattern ACT3, which are next to each other, may be arranged side by side in the third direction D3.

The second edge portion E2 of the fourth active pattern ACT4, the first edge portion E1 of the first active pattern ACT1, the second edge portion E2 of the third active pattern ACT3, and the first edge portion E1 of the second active pattern ACT2 may be sequentially disposed in the second direction D2. The first edge portion E1 of the first active pattern ACT1 may be interposed between the second edge portion E2 of the fourth active pattern ACT4 and the second edge portion E2 of the third active pattern ACT3. The second edge portion E2 of the third active pattern ACT3 may be interposed between the first edge portion E1 of the first active pattern ACT1 and the first edge portion E1 of the second active pattern ACT2.

According to an embodiment of the disclosure, since the active patterns ACT are disposed side by side as described above, the disposition of elements in the semiconductor device may be simplified. Accordingly, a patterning process, which is performed to fabricate a semiconductor device, may have reduced difficulty and consequently the semiconductor device may be more easily fabricated. In addition, since the elements can be disposed in a relatively simple manner, an integration density of the semiconductor device may also be increased.

Referring back to FIGS. 1A and 2A to 2E, the first edge portion E1 of the active pattern ACT may have a first top surface E1a and a second top surface E1b, which is located at a level lower than the first top surface E1a. The second top surface E1b of the first edge portion E1 may be closer to the second edge portion E2 than the first top surface E1a. The second edge portion E2 may have a first top surface E2a and a second top surface E2b, which is located at a level lower than the first top surface E2a. The second top surface E2b of the second edge portion E2 may be closer to the first edge portion E1 than the first top surface E2a. The first top surface E1a of the first edge portion E1 may be located at a level lower than the first top surface E2a of the second edge portion E2. The second top surface E1b of the first edge portion E1 may be located at substantially the same level as the second top surface E2b of the second edge portion E2.

The first edge portion E1 of the active pattern ACT may have a first side surface ES1 and a second side surface ES2, which is closer to the second edge portion E2 than the first side surface ES1 of the first edge portion E1. The second edge portion E2 of the active pattern ACT may have a first side surface ES1 and a second side surface ES2, which is closer to the first edge portion E1 than the first side surface ES1 of the second edge portion E2. The first side surface ES1 of each of the first and second edge portions E1 and E2 may have a linear profile (e.g. may be straight). In an embodiment, the first side surface ES1 of each of the first and second edge portions E1 and E2 may linearly extend toward the substrate 100. In an embodiment, the first side surface ES1 of each of the first and second edge portions E1 and E2 may run parallel to the fourth direction D4. The second side surface ES2 of each of the first and second edge portions E1 and E2 may have a stepwise profile (e.g. may include a step). The second side surface ES2 of the first edge portion E1 may include the second top surface E1b of the first edge portion E1. The second side surface ES2 of the second edge portion E2 may include the second top surface E2b of the second edge portion E2. Each of the first and second edge portions E1 and E2 may have a concave portion RP (otherwise known as a recessed portion), due to the stepwise profile. The concave portions RP of the first and second edge portions E1 and E2 may be concave in directions that are opposite to each other. The concave portions RP may be indents or recesses. The indents of the first and second edge portions E1 and E2 may face away from each other. The indents of the first and second edge portions E1 and E2 may be in opposite direction.

Each of the first and second edge portions E1 and E2 of the active pattern ACT may include an upper portion E1y or E2y and a lower portion E1x or E2x. The upper and lower portions E1y and E1x of the first edge portion E1 may be two separate portions that are connected without an interface therebetween, and the upper and lower portions E2y and E2x of the second edge portion E2 may be two separate portions that are connected without an interface therebetween.

The upper portion E1y of the first edge portion E1 may be recessed (e.g. deeply recessed) in the second direction D2, as compared to the lower portion E1x of the first edge portion E1. That is, a width of the upper portion E1y of the first edge portion E1 in the second direction D2 may be less than the width of the lower portion E1x of the first edge portion E1 in the second direction D2. The upper portion E2y of the second edge portion E2 may be recessed (e.g. deeply recessed) in a direction opposite to the second direction D2, as compared to the lower portion E2x of the second edge portion E2. That is, a width of the upper portion E2y of the second edge portion E2 in a direction opposite to the second direction D2 may be less than the width of the lower portion E2x of the second edge portion E2 in the direction opposite to the second direction D2. A top surface of the upper portion E1y of the first edge portion E1 may include the first top surface E1a of the first edge portion E1. A top surface of the lower portion E1x of the first edge portion E1 may include the second top surface E1b of the first edge portion E1. A top surface of the upper portion E2y of the second edge portion E2 may include the first top surface E2a of the second edge portion E2. A top surface of the lower portion E2x of the second edge portion E2 may include the second top surface E2b of the second edge portion E2.

The concave portion RP of the first edge portion E1 may be defined by the upper portion E1y and the second top surface E1b of the first edge portion E1. The concave portion RP of the second edge portion E2 may be defined by the upper portion E2y and the second top surface E2b of the second edge portion E2.

The upper and lower portions E1y and E1x of the first edge portion E1 may contact each other at a first level LV1. The upper and lower portions E2y and E2x of the second edge portion E2 may contact each other at the first level LV1. When measured in the second direction D2, a width W1 of the upper portion E1y of the first edge portion E1 at the first level LV1 may be smaller than a width W2 of the lower portion E1x at the first level LV1. When measured in the second direction D2, a width W3 of the upper portion E2y of the second edge portion E2 at the first level LV1 may be smaller than a width W4 of the lower portion E2x at the first level LV1.

According to an embodiment of the disclosure, the upper portion E1y of the first edge portion E1 of the active pattern ACT may be recessed in the second direction D2, as compared to the lower portion E1x of the first edge portion E1. That is, a width of the upper portion E1y of the first edge portion E1 in the second direction D2 may be less than the width of the lower portion E1x of the first edge portion E1 in the second direction D2. Thus, the first edge portion E1 may be placed relatively far from a storage node contact BC, which will be described below, and in this case, an interference issue between the first edge portion E1 and the storage node contact BC may be prevented. In addition, the upper portion E2y of the second edge portion E2 of the active pattern ACT may be recessed in the opposite direction of the second direction D2, as compared to the lower portion E2x of the second edge portion E2. That is, a width of the upper portion E2y of the second edge portion E2 in a direction opposite to the second direction D2 may be less than the width of the lower portion E2x of the second edge portion E2 in the direction opposite to the second direction D2. Thus, the second edge portion E2 may be placed relatively far from a bit line BL, which will be described below, and in this case, it an interference issue between the second edge portion E2 and the bit line BL may be prevented. As a result, the electrical and reliability characteristics of the semiconductor device may be improved.

An active insulating pattern AI may be provided on the first and second edge portions E1 and E2 of the active pattern ACT. The active insulating pattern AI may include a first active insulating pattern AI1 on the first edge portion E1 and a second active insulating pattern AI2 on the second edge portion E2. As an example, the active insulating pattern AI may contact the device isolation pattern STI without an interface therebetween, but the disclosure is not limited to this example.

The first active insulating pattern AI1 may fill the concave portion RP of the first edge portion E1. The first active insulating pattern AI1 may be provided on the top surface E1b of the lower portion E1x of the first edge portion E1 and the side surface of the upper portion E1y of the first edge portion E1. The first active insulating pattern AI1 may be interposed between the lower portion E1x of the first edge portion E1 and the bit line BL.

The second active insulating pattern AI2 may fill the concave portion RP of the second edge portion E2. The second active insulating pattern AI2 may be provided on the top surface E2b of the lower portion E2x of the second edge portion E2 and the side surface of the upper portion E2y of the second edge portion E2. The second active insulating pattern AI2 may be interposed between the lower portion E2x of the second edge portion E2 and the storage node contact BC.

The active insulating pattern AI may be formed of or include an insulating material. As an example, the active insulating pattern AI may be formed of or include at least one of silicon oxide (SiO₂) and silicon nitride (SiN).

The word line WL may be disposed to cross the active patterns ACT and the device isolation pattern STI. The word line WL may be interposed between the first active insulating pattern AI1 on the first edge portion E1 of the active pattern ACT and the second active insulating pattern AI2 on the second edge portion E2 of the active pattern ACT. In an embodiment, a plurality of word lines WL may be provided. The word lines WL may extend in the second direction D2 and may be spaced apart from each other in the third direction D3. The word line WL may be provided on the center portion CA of the active pattern ACT and between the first and second edge portions E1 and E2. The center portion CA may be a portion of the active pattern ACT that is placed below the word line WL. The first edge portion E1 may be a protruding portion of the active pattern ACT that extends from the center portion CA in the third direction D3. The second edge portion E2 may be another protruding portion of the active pattern ACT that extends from the center portion CA in a direction opposite to the third direction D3. Each word line WL may extend in the second direction D2 to cross the center portions CA of the active patterns ACT, which are arranged side by side in the second direction D2.

Each of the word lines WL may include a gate electrode GE, a gate dielectric pattern GI, and a gate capping pattern GC. The gate electrode GE may penetrate the active patterns ACT and the device isolation pattern STI in the second direction D2. The gate dielectric pattern GI may be interposed between the gate electrode GE and the active patterns ACT and between the gate electrode GE and the device isolation pattern STI. The gate capping pattern GC may be provided on the gate electrode GE to cover or at least partially cover a top surface of the gate electrode GE. The gate electrode GE may include a conductive material. As an example, the gate electrode GE may be a single layer, which is made of a single material, or a composite layer including two or more materials. The gate dielectric pattern GI may be formed of or include at least one of silicon oxide (SiO₂) or a high-k dielectric material. The high-k dielectric material may be defined as a material having a dielectric constant higher than that of silicon oxide. In an embodiment, the gate capping pattern GC may be formed of or include silicon nitride (SiN).

The word line WL may have a first top surface W1a and a second top surface W2a. The first top surface W1a of the word line WL may be a portion of the top surface of the word line WL, which is placed below the bit line BL, and the second top surface W2a may be another portion of the top surface of the word line WL. The second top surface W2a of the word line WL may be placed below a fence pattern FN, which will be described below. The first and second top surfaces W1a and W2a of the word line WL may be located at different levels from each other. The first top surface W1a of the word line WL may be located at a level lower than the second top surface W2a. The first top surface W1a of the word line WL may be located at substantially the same level as the first top surface E1a of the first edge portion E1 of the active pattern ACT. The second top surface W2a of the word line WL may be located at substantially the same level as the first top surface E2a of the second edge portion E2.

Referring to FIG. 1B, a first word line WL1 and a second word line WL2 may be provided to be spaced apart from each other in the third direction D3. The first word line WL1 may be provided on the center portion CA of the first active pattern ACT1 and the center portion CA of the second active pattern ACT2 and may extend in the second direction D2. The second word line WL2 may be provided on the center portion CA of the fourth active pattern ACT4 and the center portion CA of the third active pattern ACT3 and may extend in the second direction D2. The second edge portion E2 of the fourth active pattern ACT4, the first edge portion E1 of the first active pattern ACT1, the second edge portion E2 of the third active pattern ACT3, and the first edge portion E1 of the second active pattern ACT2 may be sequentially disposed in the second direction D2, between the first word line WL1 and the second word line WL2.

Referring back to FIGS. 1A and 2A to 2E, a lower storage node contact BCx may be provided on the second edge portion E2 of the active pattern ACT. For example, the lower storage node contact BCx may be interposed between the bit lines BL, which are adjacent to each other in the second direction D2, and between the fence patterns FN, which are adjacent to each other in the third direction D3. The lower storage node contact BCx may contact the second edge portion E2 of the active pattern ACT. The lower storage node contact BCx may be spaced apart from the second top surface E2b of the second edge portion E2 by the second active insulating pattern AI2. In an embodiment, the lower storage node contact BCx may be formed of or include at least one of silicon (e.g., impurity-doped polysilicon) and metallic materials (e.g., Ti, Mo, W, Cu, Al, Ta, Ru, Ir, and Co).

In an embodiment, a plurality of lower storage node contacts BCx may be provided. The lower storage node contacts BCx may be spaced apart from each other in the second and third directions D2 and D3. The lower storage node contacts BCx, which are adjacent to each other in the second direction D2, may be spaced apart from each other, with the bit line BL interposed therebetween. The lower storage node contacts BCx, which are adjacent to each other in the third direction D3, may be spaced apart from each other, with the fence pattern FN interposed therebetween.

Referring to FIG. 1B, a first lower storage node contact BCx1, a second lower storage node contact BCx2, a third lower storage node contact BCx3, and a fourth lower storage node contact BCx4 may be provided to be spaced apart from each other in the second and third directions D2 and D3. The first lower storage node contact BCx1, the second lower storage node contact BCx2, the third lower storage node contact BCx3, and the fourth lower storage node contact BCx4 may be sequentially disposed in a clockwise direction. The first lower storage node contact BCx1, the second lower storage node contact BCx2, the third lower storage node contact BCx3, and the fourth lower storage node contact BCx4 may be provided on the second edge portion E2 of the first active pattern ACT1, the second edge portion E2 of the second active pattern ACT2, the second edge portion E2 of the third active pattern ACT3, and the second edge portion E2 of the fourth active pattern ACT4, respectively. In a plan view, the third lower storage node contact BCx3 and the fourth lower storage node contact BCx4 may be interposed between the first word line WL1 and the second word line WL2. In a plan view, the second lower storage node contact BCx2 and the third lower storage node contact BCx3 may be interposed between a first bit line BL1 and a second bit line BL2, which will be described below.

Referring back to FIGS. 1A and 2A to 2E, the fence pattern FN may be provided on the word line WL. For example, the fence pattern FN may be interposed between the bit lines BL, which are adjacent to each other in the second direction D2, and between the lower storage node contacts BCx, which are adjacent to each other in the third direction D3. A bottom surface of the fence pattern FN may be located at a level higher than a bottom surface of the bit line BL.

In an embodiment, a plurality of fence patterns FN may be provided. The fence patterns FN may be spaced apart from each other in the second and third directions D2 and D3. The fence patterns FN, which are adjacent to each other in the second direction D2, may be spaced apart from each other, with the bit line BL interposed therebetween. The fence patterns FN, which are adjacent to each other in the third direction D3, may be spaced apart from each other, with the lower storage node contact BCx interposed therebetween. In an embodiment, the fence pattern FN may be formed of or include at least one of silicon oxide (SiO₂), silicon nitride (SiN), silicon oxycarbide (SiOC), or silicon oxycarbonitride (SiOCN).

A buffer pattern BP may cover or at least partially cover a top surface of the lower storage node contact BCx and a top surface of the fence pattern FN. The buffer pattern BP may be interposed between the bit lines BL, which are adjacent to each other in the second direction D2. The buffer pattern BP may be formed of or include at least one of silicon oxide, silicon nitride, and silicon oxynitride. The buffer pattern BP may be a single layer, which is made of a single material, or a composite layer including two or more materials. The buffer pattern BP may be a composite layer including a lower buffer pattern and an upper buffer pattern.

A bit line trench region BTR may be defined between the lower storage node contacts BCx, which are adjacent to each other in the second direction D2, and between the fence patterns FN. The bit line trench region BTR may extend in the third direction D3, on the first edge portion E1 of the active pattern ACT. An upper portion of the first edge portion E1 of the active pattern ACT may be recessed to a specific depth based on the bit line trench region BTR. The bit line trench region BTR may not overlap the second edge portion E2.

In an embodiment, a plurality of bit line trench regions BTR may be provided. The bit line trench regions BTR may be spaced apart from each other in the second direction D2. The bit line trench regions BTR, which are adjacent to each other in the second direction D2, may be spaced apart from each other, with the lower storage node contact BCx or the fence pattern FN interposed therebetween.

Referring to FIG. 1B, a first bit line trench region BTR1 and a second bit line trench region BTR2 may be provided to be spaced apart from each other in the second direction D2. The first bit line trench region BTR1 may be provided on the first edge portion E1 of the first active pattern ACT1 and the first edge portion E1 of the fourth active pattern ACT4 and may extend in the third direction D3. The second bit line trench region BTR2 may be provided on the first edge portion E1 of the second active pattern ACT2 and the first edge portion E1 of the third active pattern ACT3 and may extend in the third direction D3.

Referring back to FIGS. 1A and 2A to 2E, the bit line BL may be provided in the bit line trench region BTR and on the first edge portion E1 of the active pattern ACT. The bit line BL may contact the first edge portion E1 of the active pattern ACT. Thus, an electric resistance between the bit line BL and the first edge portion E1 of the active pattern ACT may be lowered, and as a result, the electrical characteristics of the semiconductor device may be improved. A bottom surface of the bit line BL may be located at a level lower than the first top surface E2a of the second edge portion E2 of the active pattern ACT. The bit line BL may be spaced apart from the second top surface E1b of the first edge portion E1 by the first active insulating pattern AI1. In an embodiment, a plurality of bit lines BL may be provided. The bit lines BL may be spaced apart from each other in the second direction D2 and may extend in the third direction D3.

The bit line BL may be a composite layer including two or more materials. As an example, the bit line BL may include a lower bit line BLx and an upper bit line BLy. The upper bit line BLy may extend in the third direction D3. The lower bit line BLx may be interposed between the first edge portion E1 and the upper bit line BLy.

As an example, the lower bit line BLx may include at least one of a first barrier pattern, which may be used to prevent the diffusion of a material in the upper bit line BLy, and a first silicide pattern, which may be used to improve a contact resistance property between the upper bit line BLy and the first edge portion E1. As an example, the lower bit line BLx may be formed of or include at least one of metal silicide materials (e.g., silicide materials containing Ti, Mo, W, Cu, Al, Ta, Ru, Ir, or Co) and metal nitride materials (e.g., nitride materials containing Ti, Mo, W, Cu, Al, Ta, Ru, Ir, or Co). The upper bit line BLy may be formed of or include at least one of metallic materials (e.g., Ti, Mo, W, Cu, Al, Ta, Ru, Ir, and Co).

Referring to FIG. 1B, the first bit line BL1 and the second bit line BL2 may be provided to be spaced apart from each other in the second direction D2. The first bit line BL1 may be provided in the first bit line trench region BTR1. The second bit line BL2 may be provided in the second bit line trench region BTR2. The first bit line BL1 may be provided on the first edge portion E1 of the first active pattern ACT1 and the first edge portion E1 of the fourth active pattern ACT4 and may extend in the third direction D3. The second bit line BL2 may be provided on the first edge portion E1 of the second active pattern ACT2 and the first edge portion E1 of the third active pattern ACT3 and may extend in the third direction D3. In a plan view, the second edge portion E2 of the second active pattern ACT2 and the second edge portion E2 of the third active pattern ACT3 may be interposed between the first bit line BL1 and the second bit line BL2.

A bit line capping pattern BCP may be provided in the bit line trench region BTR and on a top surface of the bit line BL. The bit line capping pattern BCP, along with the bit line BL, may extend in the third direction D3. In an embodiment, a plurality of bit line capping patterns BCP may be provided. The bit line capping patterns BCP may be spaced apart from each other in the second direction D2. The bit line capping pattern BCP may be composed of a single layer or a plurality of layers. As an example, the bit line capping pattern BCP may include a first capping pattern, a second capping pattern, and a third capping pattern, which are sequentially stacked. Each of the first to third capping patterns may be formed of or include silicon nitride (SiN). In an embodiment, the bit line capping pattern BCP may include four or more capping patterns that are stacked.

A bit line spacer BSP may be provided in the bit line trench region BTR and on a side surface of the bit line BL and a side surface of the bit line capping pattern BCP. The bit line spacer BSP may cover or at least partially cover the side surface of the bit line BL, the side surface of the bit line capping pattern BCP, and an inner side surface of the bit line trench region BTR. The bit line spacer BSP may further cover or at least partially cover a side surface of the lower storage node contact BCx. The bit line spacer BSP may extend in the third direction D3, on the side surface of the bit line BL. A top surface of the bit line spacer BSP may be located at substantially the same level as the top surface of the buffer pattern BP. In an embodiment, a plurality of bit line spacers BSP may be provided. The bit line spacers BSP may be spaced apart from each other in the second direction D2. In each bit line trench region BTR, two bit line spacers BSP, which are adjacent to each other in the second direction D2, may be spaced apart from each other with one of the bit lines BL interposed therebetween. The bit line spacer BSP may be formed of or include at least one of silicon oxide (SiO₂), silicon nitride (SiN), silicon oxycarbide (SiOC), and silicon oxycarbonitride (SiOCN). The bit line spacer BSP may be a single layer, which is made of a single material, or a composite layer including two or more materials.

A mold pattern MP may be provided on the buffer pattern BP, the bit line capping pattern BCP, and the bit line spacer BSP. The mold pattern MP may be provided to enclose a landing pad LP, which will be described below. The mold pattern MP may be interposed between the landing pads LP, which are adjacent to each other. In a plan view, the mold pattern MP may be provided to have a mesh shape with contact holes CH to be described below. The mold pattern MP may be formed of or include at least one of silicon oxide (SiO₂), silicon nitride (SiN), silicon oxycarbide (SiOC), and silicon oxycarbonitride (SiOCN).

The contact hole CH may be provided on the second edge portion E2 of the active pattern ACT. The contact hole CH may be provided to penetrate the mold pattern MP and the buffer pattern BP. An upper portion of the lower storage node contact BCx, an upper portion of the bit line capping pattern BCP, and an upper portion of the bit line spacer BSP may be recessed to a specific depth based on the contact hole CH. The contact hole CH may be further shifted from the lower storage node contact BCx in the second direction D2 or an opposite direction thereof. A portion of the contact hole CH may be positioned vertically above the bit line BL. A portion of the contact hole CH may be positioned vertically above the lower storage node contact BCx. In an embodiment, a plurality of contact holes CH may be provided. The contact holes CH may be linearly arranged in the second direction D2 and may be arranged in a zigzag shape in the third direction D3.

An upper storage node contact BCy may be provided in the contact hole CH. The upper storage node contact BCy may be provided on the lower storage node contact BCx and may contact the lower storage node contact BCx. The upper storage node contact BCy may be electrically connected to a corresponding one of the second edge portions E2 of the active patterns ACT through a corresponding one of the lower storage node contacts BCx. The upper storage node contact BCy may be further shifted from the lower storage node contact BCx in the second direction D2 or an opposite direction thereof. A portion of the upper storage node contact BCy may be positioned vertically above the bit line BL. The upper storage node contact BCy may contact the bit line capping pattern BCP and the bit line spacer BSP. The upper storage node contact BCy, along with the lower storage node contact BCx, may form the storage node contact BC. The lowermost surface of the upper storage node contact BCy may be located at a level lower than the top surface of the lower storage node contact BCx.

In an embodiment, a plurality of upper storage node contacts BCy may be provided. The upper storage node contacts BCy may be provided in the contact holes CH, respectively. The upper storage node contacts BCy may be spaced apart from each other in the second and third directions D2 and D3. The upper storage node contacts BCy may be linearly arranged in the second direction D2 and may be arranged in a zigzag shape in the third direction D3, similar to the contact hole CH.

The landing pad LP may be provided on the upper storage node contact BCy in the contact hole CH. The landing pad LP may be positioned vertically above the upper storage node contact BCy. The landing pads LP may be electrically and respectively connected to the second edge portions E2 of the active patterns ACT through the upper storage node contacts BCy and the lower storage node contacts BCx. In an embodiment, a plurality of landing pads LP may be provided. The landing pads LP may be spaced apart from each other in the second and third directions D2 and D3. The landing pad LP may be formed of or include at least one of metallic materials (e.g., Ti, Mo, W, Cu, Al, Ta, Ru, Ir, and Co). In an embodiment, a second silicide pattern SC may be further provided between the landing pad LP and the upper storage node contact BCy. The second silicide pattern SC may be formed of or include at least one metal silicide material (e.g., containing Ti, Mo, W, Cu, Al, Ta, Ru, Ir, and Co). In an embodiment, a second barrier pattern may be interposed between the landing pad LP and other elements to prevent a material in the landing pad LP from being diffused into the neighboring elements. As an example, the second barrier pattern may be formed of or include at least one of metal nitride materials (e.g., nitride materials containing Ti, Mo, W, Cu, Al, Ta, Ru, Ir, or Co).

A data storage pattern DSP may be provided on the landing pad LP. In an embodiment, a plurality of data storage patterns DSP may be provided. The data storage patterns DSP may be spaced apart from each other in the second and third directions D2 and D3. The data storage patterns DSP may be electrically and respectively connected to the second edge portions E2 of the active patterns ACT through the landing pads LP and the storage node contacts BC.

In an embodiment, the data storage pattern DSP may be a capacitor including a bottom electrode, a dielectric layer, and a top electrode. In this case, the semiconductor device may be a dynamic random access memory (DRAM) device. In an embodiment, the data storage pattern DSP may include a magnetic tunnel junction pattern. In this case, the semiconductor device may be a magnetic random access memory (MRAM) device. In an embodiment, the data storage pattern DSP may be formed of or include a phase-change material or a variable resistance material. In this case, the semiconductor device may be a phase-change random access memory (PRAM) device or a resistive random access memory (ReRAM) device. However, the disclosure is not limited to these examples, and the data storage pattern DSP may include various structures and/or materials configured to store data.

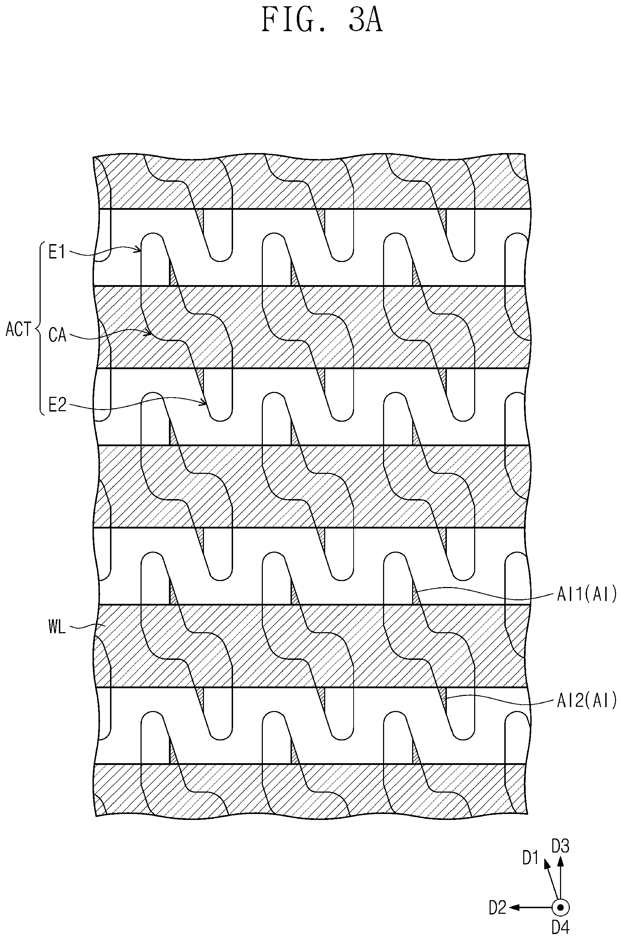

Hereinafter, other embodiments of the disclosure will be described in more detail with reference to FIGS. 3A to 21. In the following description, a previously-described element may be identified by the same reference number without repeating an overlapping description thereof, for concise description.

FIGS. 3A to 3F are plan views illustrating semiconductor devices according to one or more embodiments of the disclosure.

Referring to FIGS. 3A to 3F, the active pattern ACT may have various profiles, in a plan view. The active patterns ACT may be disposed in such a way that they are spaced apart from each other in the second and third directions D2 and D3 and have a profile elongated in the first direction D1. The first and second edge portions E1 and E2 of the active pattern ACT may or may not be symmetric (e.g. rotationally symmetric) about the center portion CA.

Referring to FIG. 3A, the profiles of the first and second edge portions E1 and E2 of the active pattern ACT may be symmetric (e.g. rotationally symmetric) about the center portion CA. In a plan view, the first edge portion E1 of the active pattern ACT may be a protruding portion that extends from the word line WL in the third direction D3, and the second edge portion E2 may be a protruding portion that extends from the word line WL in the opposite direction of the third direction D3. Each of the first and second edge portions E1 and E2 may have a shape elongated in a direction between the first and third directions D1 and D3. Due to the elongated shape of the first edge portion E1, a contact area between the first edge portion E1 and the bit line BL may be increased, and thus, a contact resistance therebetween may be improved. Similarly, due to the elongated shape of the second edge portion E2, a contact area between the second edge portion E2 and the storage node contact BC may be increased, and thus, a contact resistance therebetween may be improved.

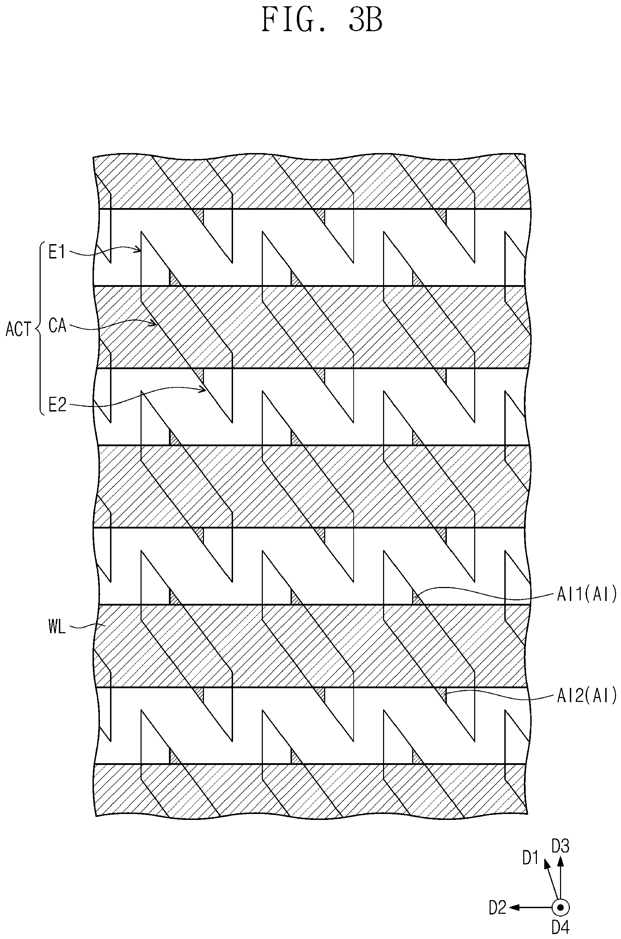

Referring to FIG. 3B, the profiles of the first and second edge portions E1 and E2 of the active pattern ACT may be symmetric (e.g. rotationally symmetric) about the center portion CA. The active pattern ACT may have a shape elongated in the first direction D1. The side surface of the active pattern ACT may have a substantially linear profile (e.g. may be straight in plan view). Thus, technical difficulties in a process of patterning the active pattern ACT may be reduced, and thus, the semiconductor device may be easily fabricated.

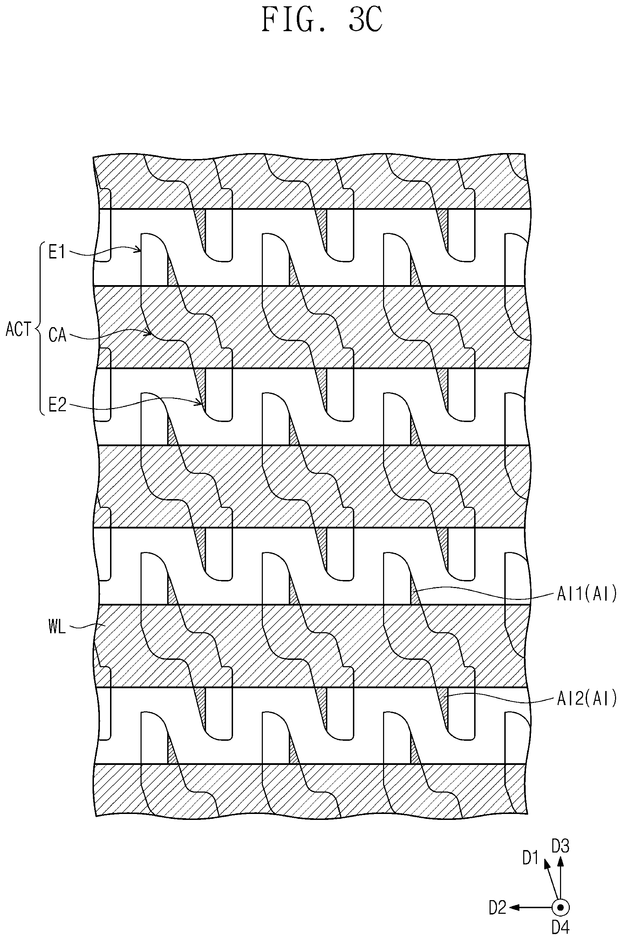

Referring to FIG. 3C, the profiles of the first and second edge portions E1 and E2 of the active pattern ACT may not be symmetric (e.g. rotationally symmetric) about the center portion CA. The second edge portion E2 of FIG. 3C may further include a protruding portion that extends in the opposite direction of the second direction D2, compared to the second edge portion E2 of FIG. 3A. In this case, a contact area between the second edge portion E2 and the storage node contact BC may be increased, and thus, a contact resistance property therebetween may be improved. The first edge portion E1 of FIG. 3C may further include a protruding portion that extends in the second direction D2, compared to the first edge portion E1 of FIG. 3A.

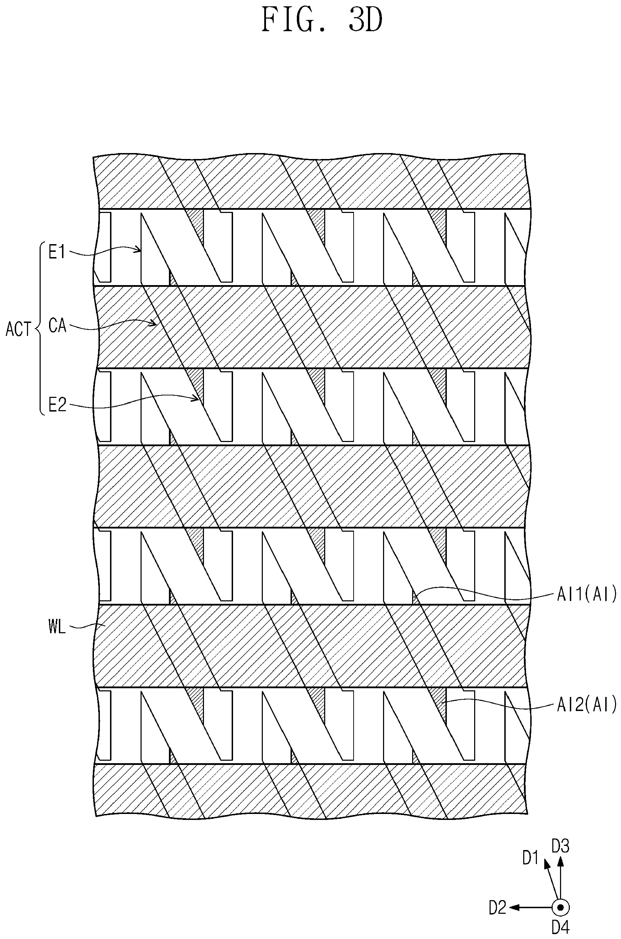

Referring to FIG. 3D, the profiles of the first and second edge portions E1 and E2 of the active pattern ACT may not be symmetric (e.g. rotationally symmetric) about the center portion CA. The second edge portion E2 of FIG. 3D may further include a protruding portion that extends in the opposite direction of the second direction D2, compared to the second edge portion E2 of FIG. 3B. In this case, a contact area between the second edge portion E2 and the storage node contact BC may be increased, and thus, a contact resistance property therebetween may be improved. The first edge portion E1 of FIG. 3D may further include a protruding portion that extends in the second direction D2, compared to the first edge portion E1 of FIG. 3B.

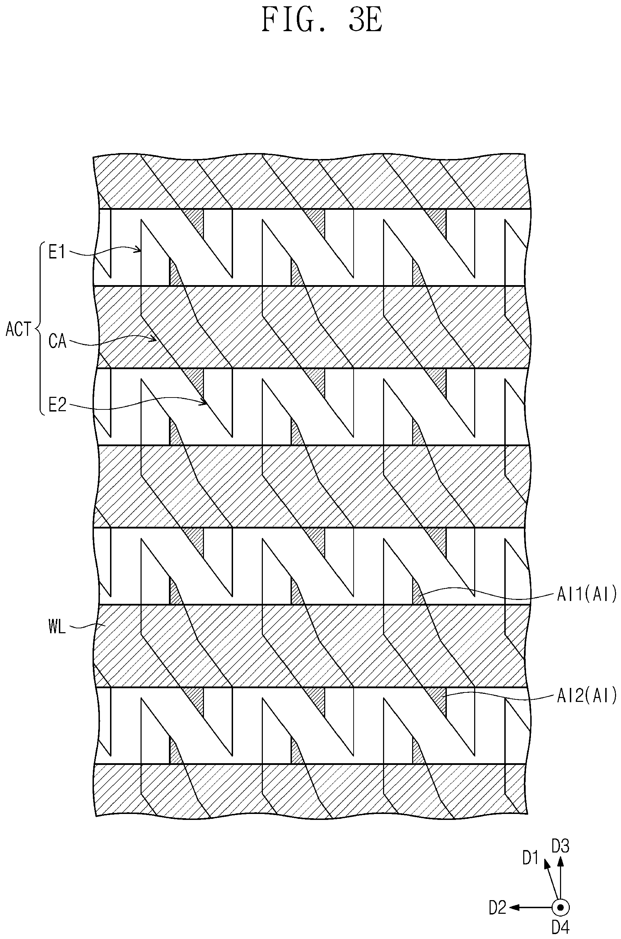

Referring to FIG. 3E, the profiles of the first and second edge portions E1 and E2 of the active pattern ACT may not be symmetric (e.g. rotationally symmetric) about the center portion CA. Compared to the first edge portion E1 of FIG. 3B, the first edge portion E1 of FIG. 3E may further include a protruding portion that extends in the third direction D3. In this case, a contact area between the first edge portion E1 and the bit line BL may be increased, and thus, a contact resistance property therebetween may be improved. The second edge portion E2 of FIG. 3E may further include a protruding portion that extends in the opposite direction of the third direction D3, compared to the second edge portion E2 of FIG. 3B.

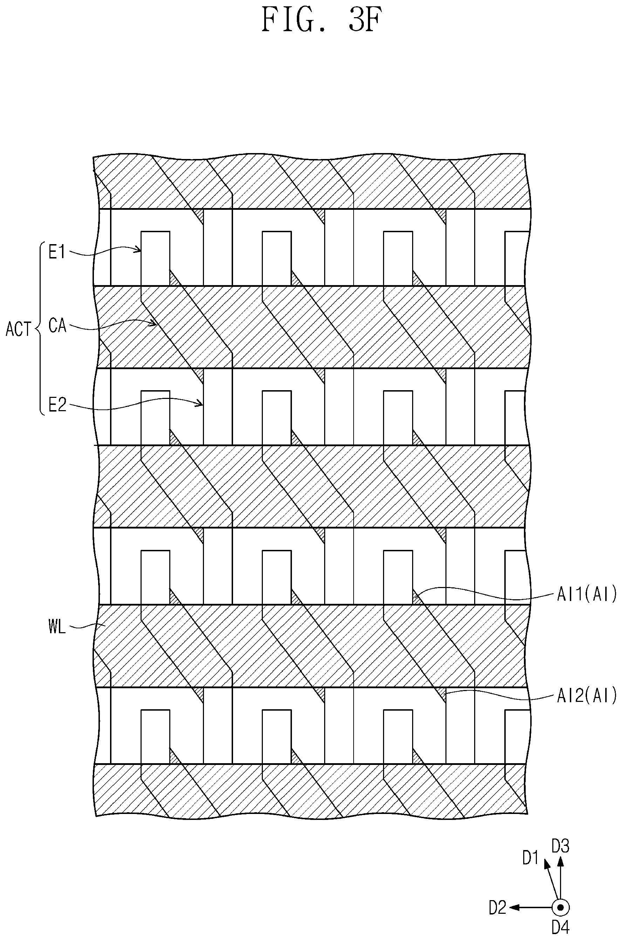

Referring to FIG. 3F, the profiles of the first and second edge portions E1 and E2 of the active pattern ACT may not be symmetric (e.g. rotationally symmetric) about the center portion CA. The first edge portion E1 of FIG. 3F may further include a protruding portion that extends in the third direction D3, compared to the first edge portion E1 of FIG. 3B. In this case, a contact area between the first edge portion E1 and the bit line BL may be increased, and thus, a contact resistance property therebetween may be improved. The second edge portion E2 of FIG. 3F may further include a protruding portion that extends in the opposite direction of the third direction D3, compared to the second edge portion E2 of FIG. 3B. In this case, a contact area between the second edge portion E2 and the storage node contact BC may be increased, and thus, a contact resistance property therebetween may be improved. A protruding length of the second edge portion E2 may be larger than a protruding length of the first edge portion E1.

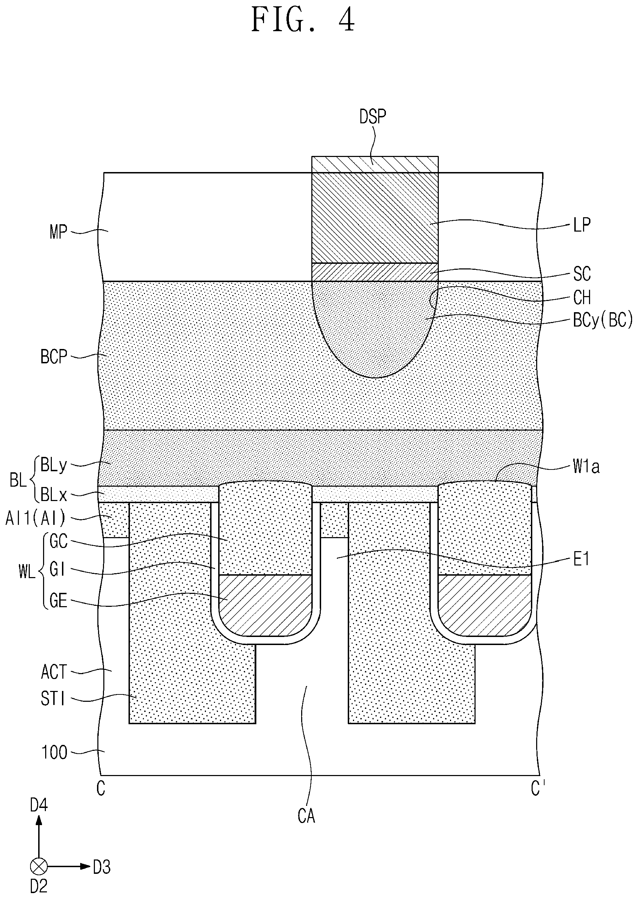

FIG. 4 is a cross-sectional view corresponding to the line C-C' of FIG. 1A according to one or more embodiments of the disclosure.

Referring to FIG. 4, the word line WL may extend into the bit line BL (e.g. extend in the fourth direction D4). In an embodiment, the gate capping pattern GC may also extend into the bit line BL. The gate capping pattern GC may be interposed between the lower bit lines BLx. The first top surface W1a of the word line WL (e.g., the top surface of the gate capping pattern GC) may be located at a level higher than a top surface of the lower bit line BLx. Thus, a distance between the upper bit line BLy and the gate electrode GE may be increased, and thus, an electrical interference issue between the upper bit line BLy and the gate electrode GE may be reduced. As a result, the electrical characteristics of the semiconductor device may be improved.

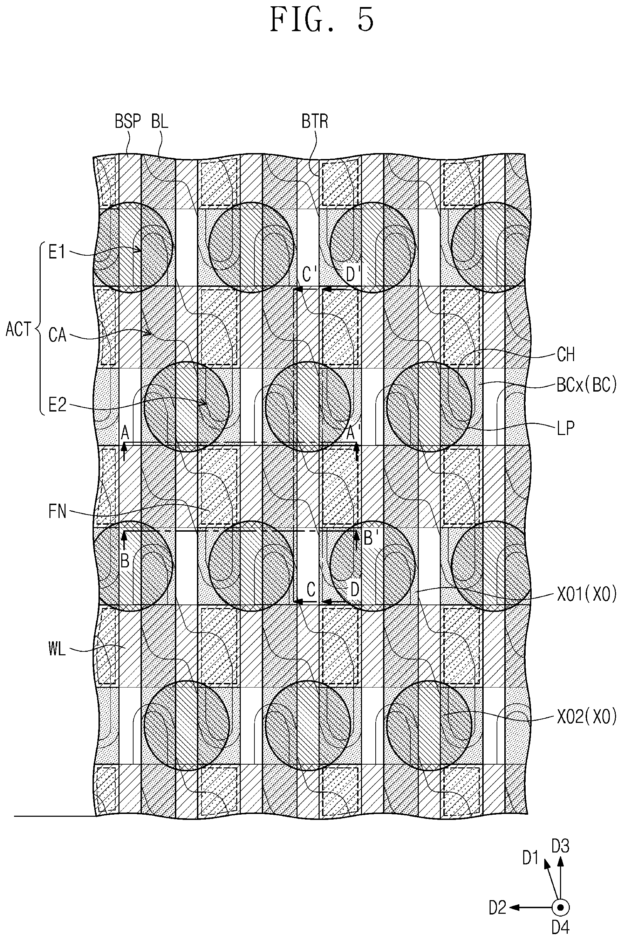

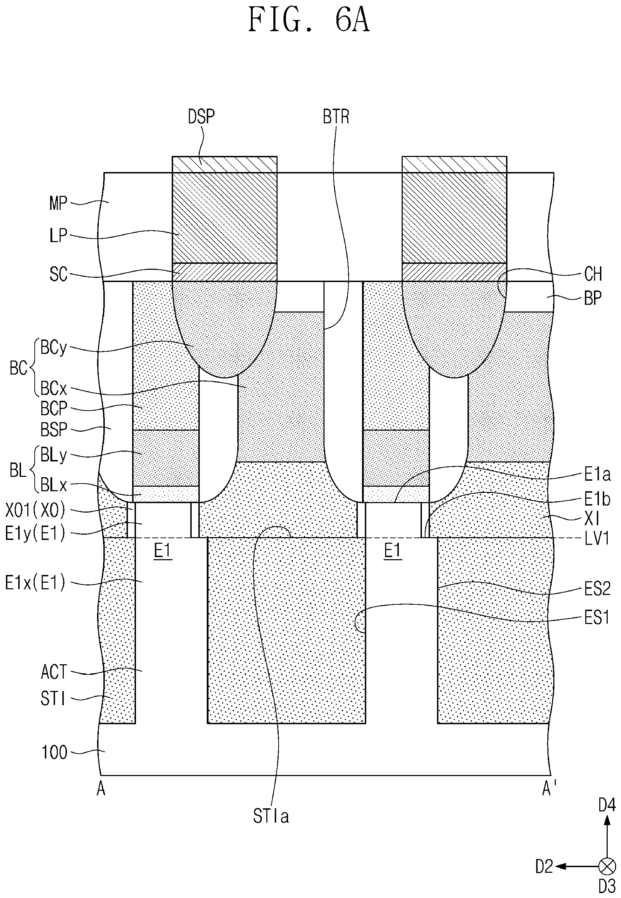

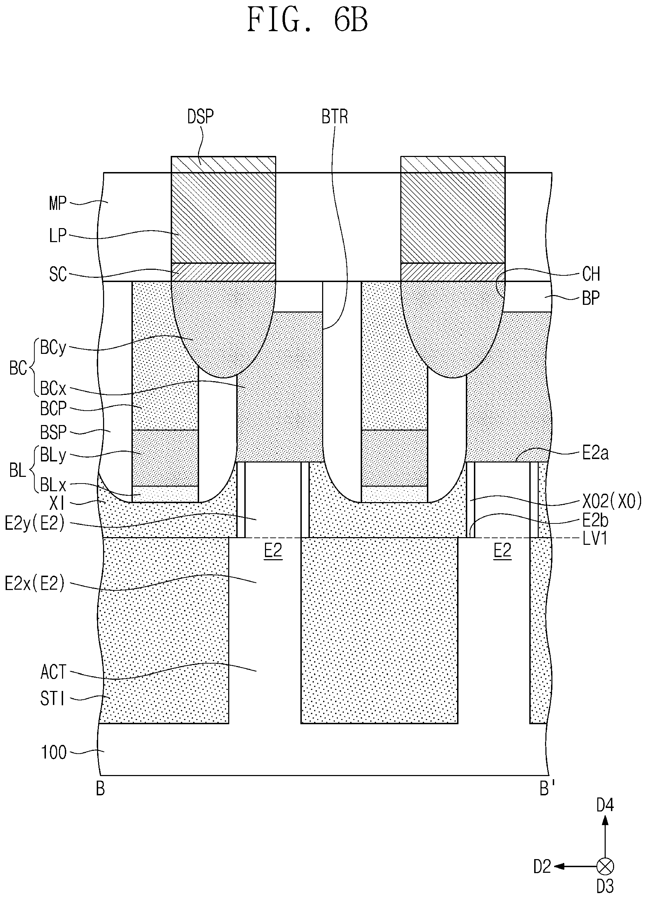

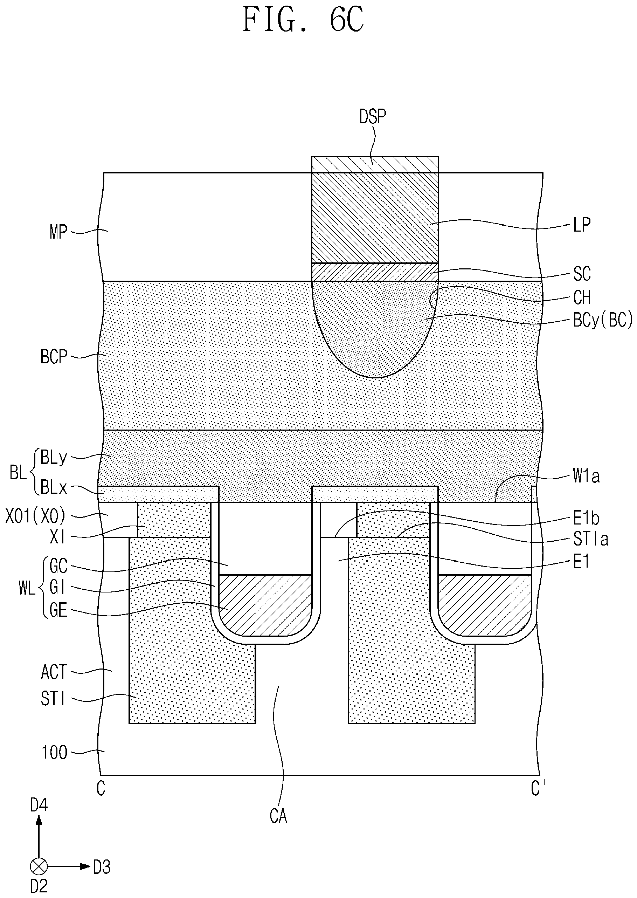

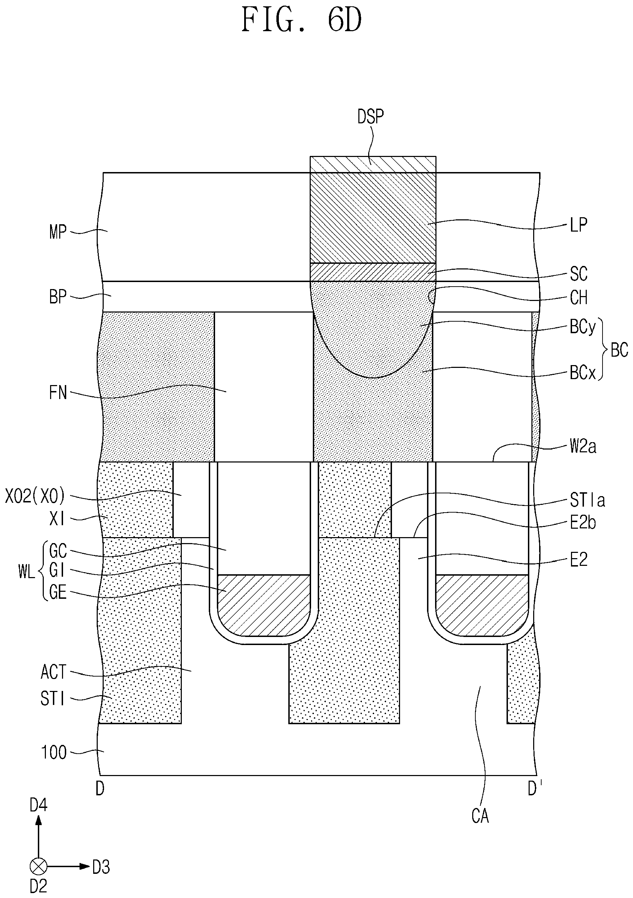

FIG. 5 is a plan view illustrating a semiconductor device according to one or more embodiments of the disclosure. FIGS. 6A to 6D are cross-sectional views corresponding to lines A-A', B-B', C-C', and D-D' of FIG. 5, respectively, according to one or more embodiments of the disclosure.

Referring to FIGS. 5 to 6D, the first top surfaces E1a and E2a of the first and second edge portions E1 and E2 of the active pattern ACT may be located at a level higher than the uppermost surface STIa of the device isolation pattern STI. The second top surfaces E1b and E2b of the first and second edge portions E1 and E2 of the active pattern ACT may be located at substantially the same level as the uppermost surface STIa of the device isolation pattern STI, but the disclosure is not limited to this example. For example, the second top surfaces E1b and E2b of the first and second edge portions E1 and E2 of the active pattern ACT may be located at a level that is higher or lower than the uppermost surface STIa of the device isolation pattern STI.

An active pad XO may be provided to cover and enclose side surfaces of the first and second edge portions E1 and E2 of the active pattern ACT. The active pad XO may include a first active pad XO1, which is provided to cover or at least partially cover the side surface of the first edge portion E1, and a second active pad XO2, which is provided to cover or at least partially cover the side surface of the second edge portion E2. The active pad XO may include an impurity region that is doped with impurities (e.g., n-type or p-type impurities). The impurity region of the active pad XO, along with the impurity region of the active pattern ACT, may be used as one of the source, drain, and channel regions of a transistor. Thus, the source or drain region of the transistor may have an increased area, in a plan view. The active pad XO may be formed of or include the same material as the active pattern ACT. As an example, the active pad XO may be formed of or include at least one of silicon (e.g., single crystalline silicon), germanium, or silicon-germanium.

A pad insulating pattern XI may be provided on the uppermost surface STIa of the device isolation pattern STI. The pad insulating pattern XI may be interposed between the first and second active pads XO1 and XO2. The pad insulating pattern XI may include an insulating material. As an example, the pad insulating pattern XI may be formed of or include at least one of silicon oxide (SiO₂) and silicon nitride (SiN).

The bit line BL may contact the first active pad XO1. The bit line BL may be electrically connected to the first active pad XO1 and the first edge portion E1 of the active pattern ACT. Since the first active pad XO1 is provided, a contact area between the bit line BL and the source or drain region may be increased, and thus, a contact resistance therebetween may be improved.

The lower storage node contact BCx may contact the second active pad XO2. The storage node contact BC may be electrically connected to the second active pad XO2 and the second edge portion E2 of the active pattern ACT. Since the second active pad XO2 is provided, a contact area between the storage node contact BC and the source or drain region may be increased, and thus, a contact resistance therebetween may be improved.

In an embodiment, the active pattern ACT of the semiconductor device described with reference to FIGS. 5 to 6D may include one of the active patterns ACT of the semiconductor device described with reference to FIGS. 3A to 3F.

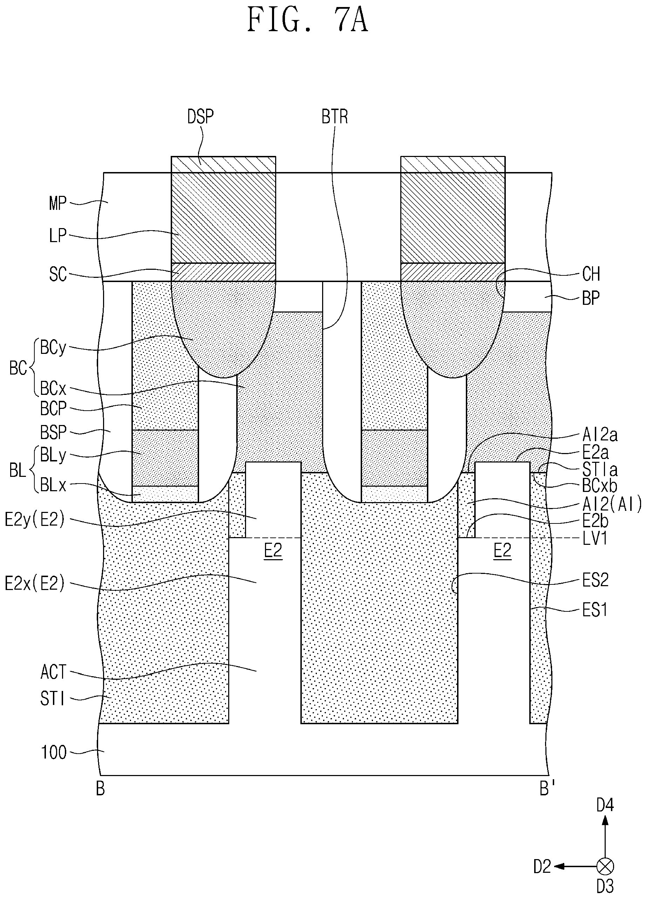

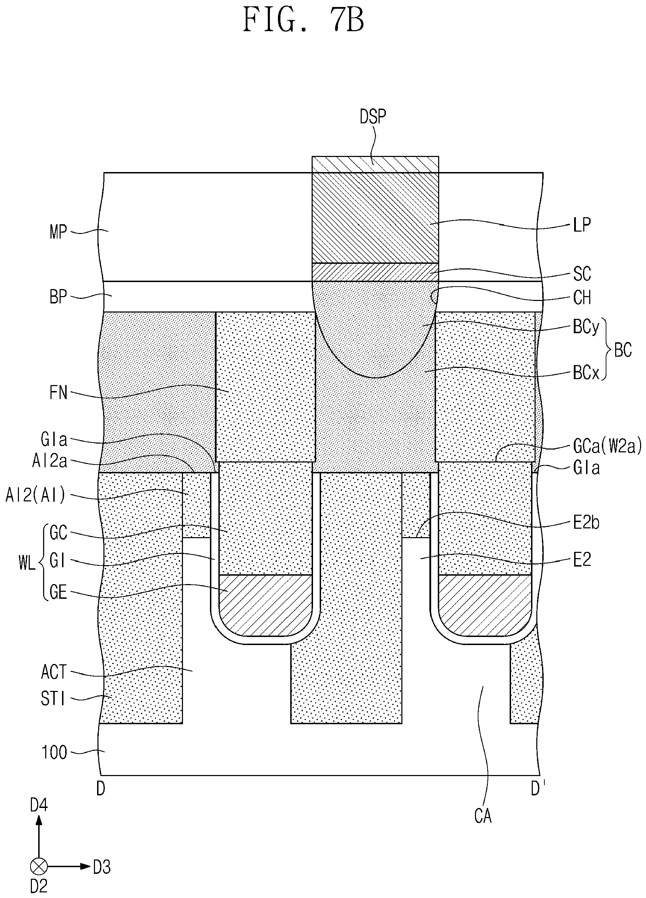

FIGS. 7A and 7B are cross-sectional views corresponding to the lines B-B' and D-D' of FIG. 1A, respectively, according to one or more embodiments of the disclosure.

Referring to FIGS. 7A and 7B, a bottom surface BCxb of the lower storage node contact BCx may be located at a level lower than the first top surface E2a of the second edge portion E2 of the active pattern ACT. The lower storage node contact BCx may cover or at least partially cover the upper portion E2y of the second edge portion E2. As an example, the lower storage node contact BCx may contact a side surface of the upper portion E2y of the second edge portion E2. Thus, a contact area between the lower storage node contact BCx and the second edge portion E2 of the active pattern ACT may be increased, compared to the semiconductor device of FIGS. 2A to 2E. As a result, the lower storage node contact BCx may be easily electrically connected to the second edge portion E2 of the active pattern ACT, and the electrical characteristics of the semiconductor device may be improved.

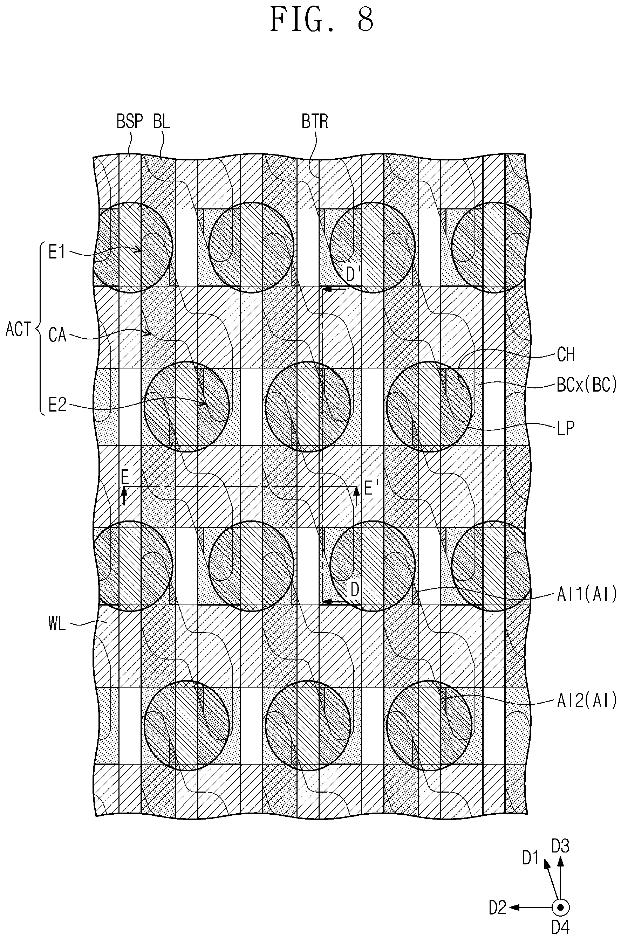

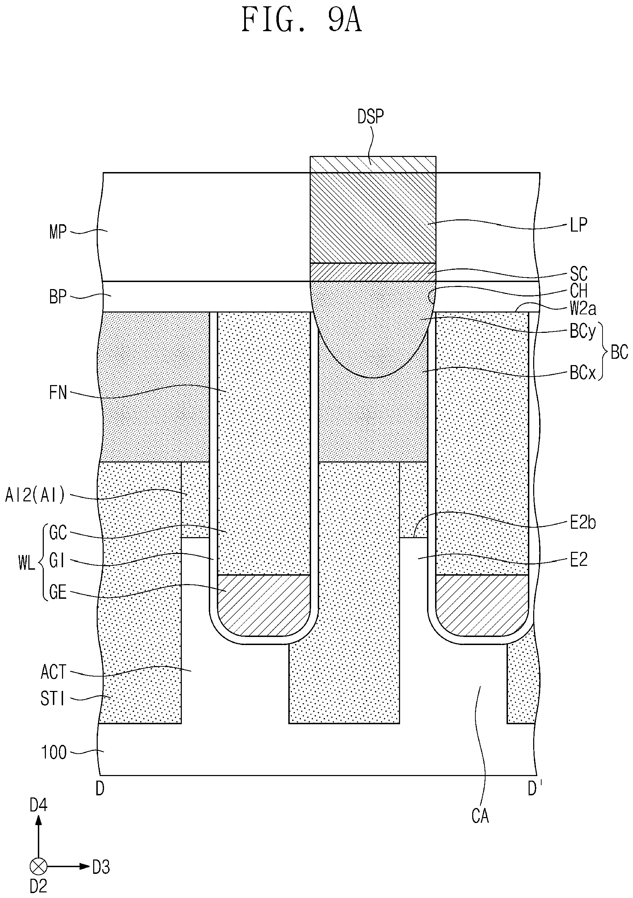

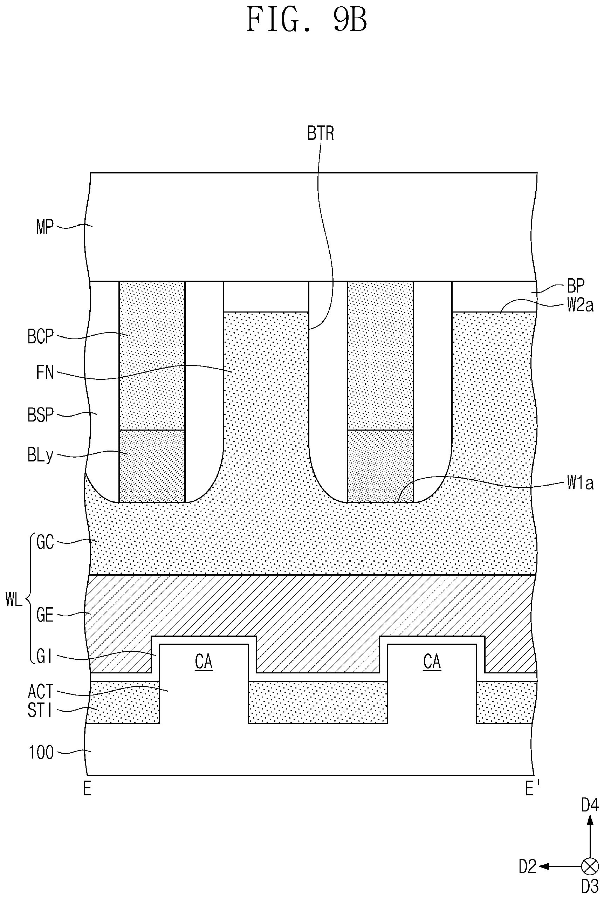

FIG. 8 is a plan view illustrating a semiconductor device according to one or more embodiments of the disclosure. FIGS. 9A and 9B are cross-sectional views corresponding to lines D-D' and E-E' of FIG. 8, respectively, according to one or more embodiments of the disclosure.

Referring to FIGS. 8 to 9B, the fence pattern FN may not be provided. The word line WL may extend in the third and fourth directions D3 and D4, between the lower storage node contacts BCx, which are adjacent to each other in the third direction D3. The second top surface W2a of the word line WL may be located at substantially the same level as the top surface of the lower storage node contact BCx. The word line WL may contact the buffer pattern BP. The word lines WL may be spaced apart from each other in the third direction D3, with the lower storage node contact BCx interposed therebetween.

The bit line trench region BTR may be provided in the word line WL (e.g., in the gate capping pattern GC). The bit line trench region BTR may be provided to cross the word line WL in the third direction D3. In each word line WL, the bit line trench regions BTR may be spaced apart from each other in the second direction D2.

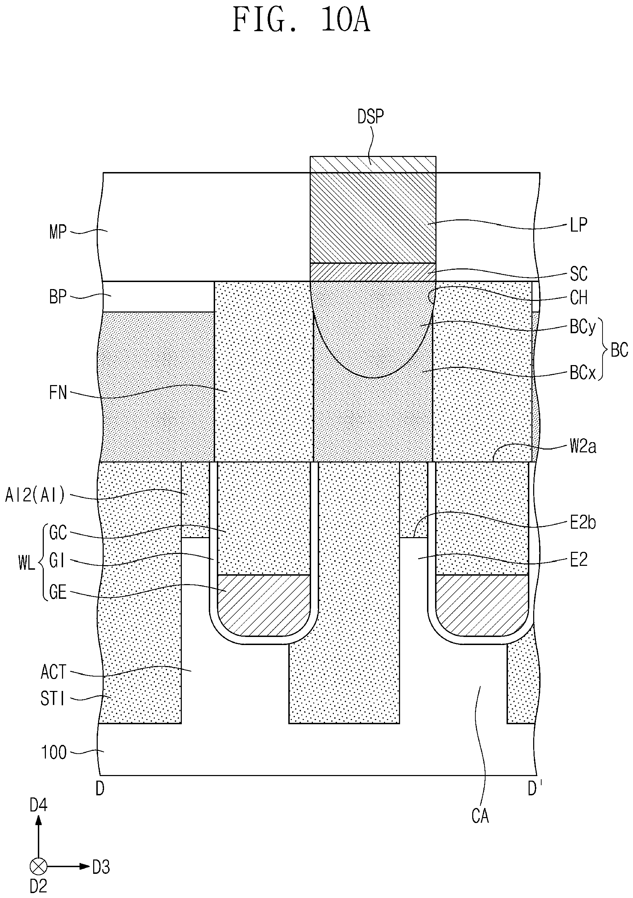

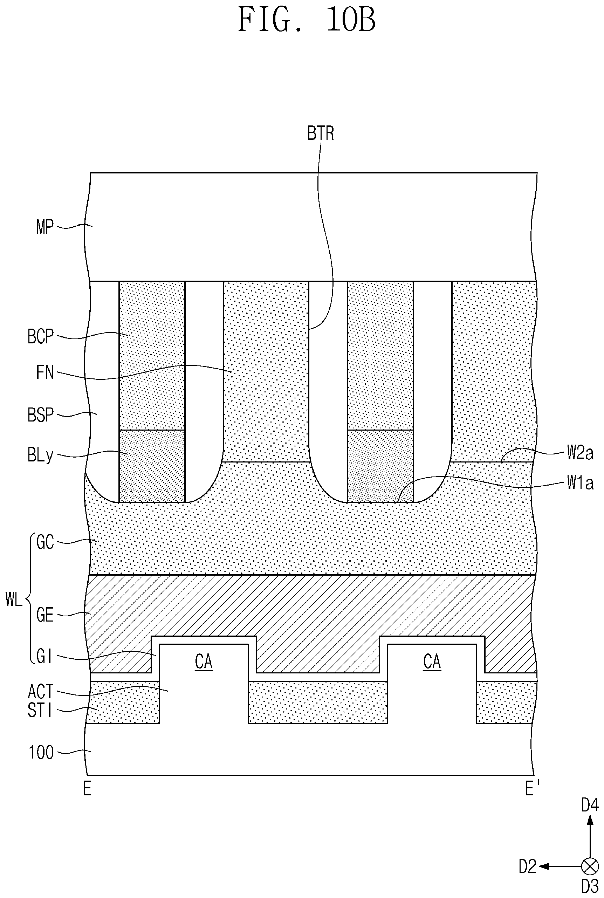

FIGS. 10A and 10B are cross-sectional views corresponding to the lines D-D' and E-E' of FIG. 1A, according to one or more embodiments of the disclosure.

Referring to FIGS. 10A and 10B, the fence pattern FN may be provided to penetrate the buffer pattern BP. A top surface of the fence pattern FN may be located at substantially the same level as the top surface of the buffer pattern BP, the top surface of the bit line capping pattern BCP, and the top surface of the bit line spacer BSP. The top surface of the fence pattern FN may contact a bottom surface of the mold pattern MP.

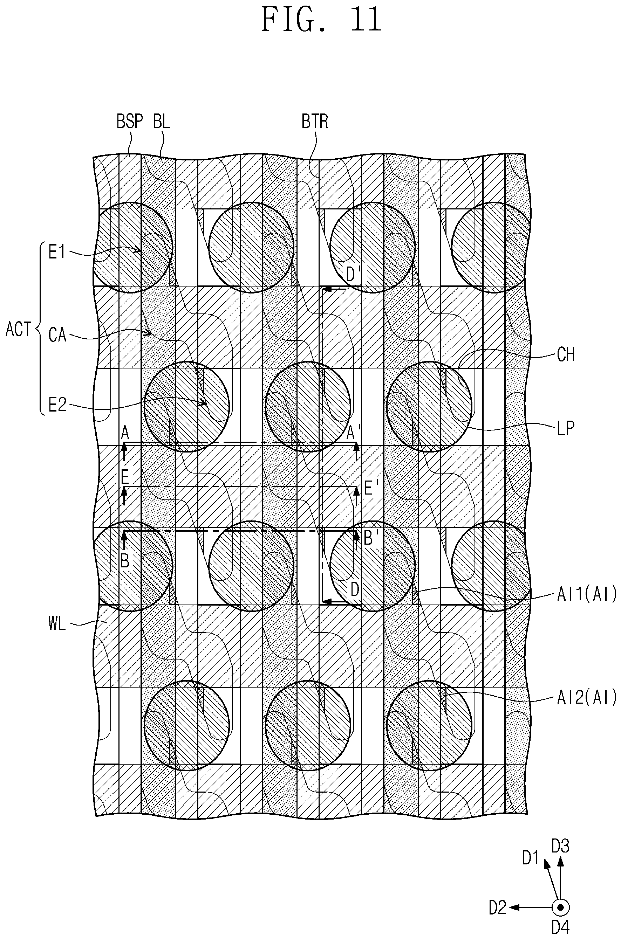

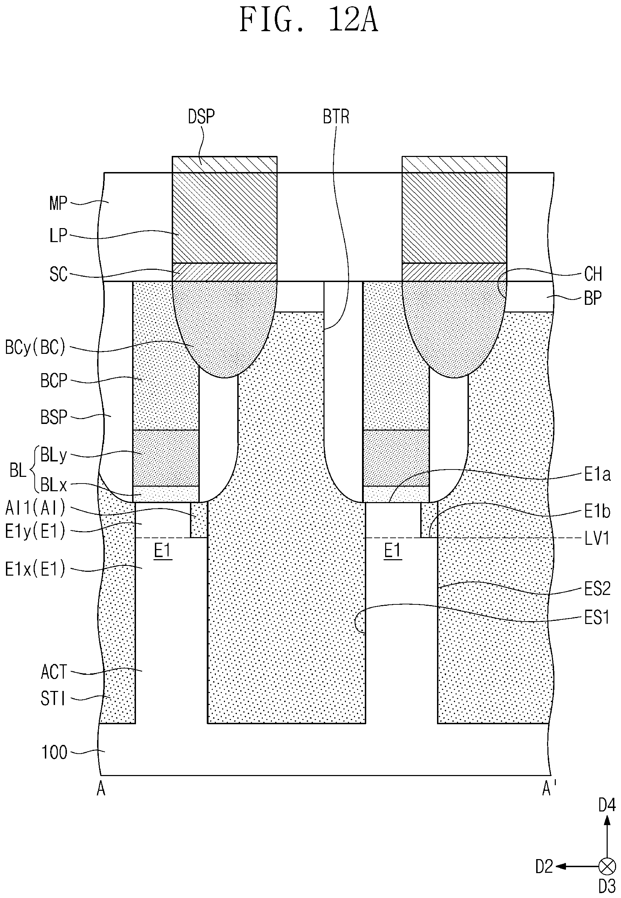

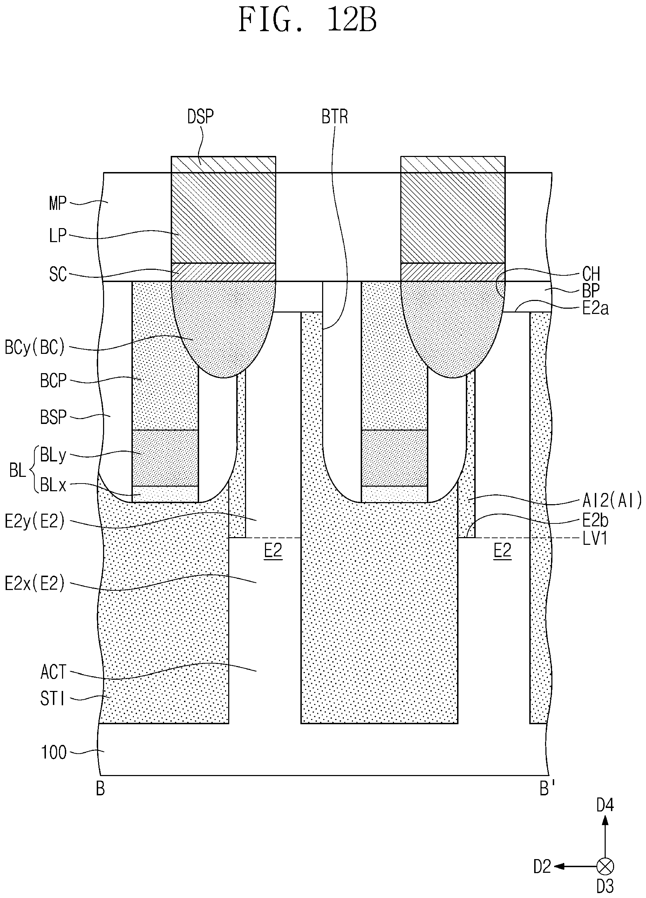

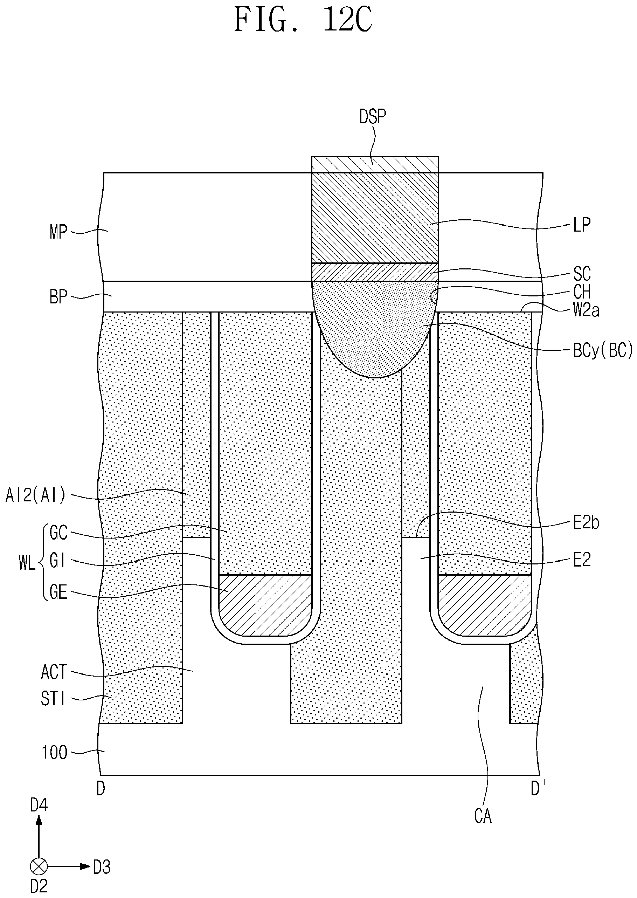

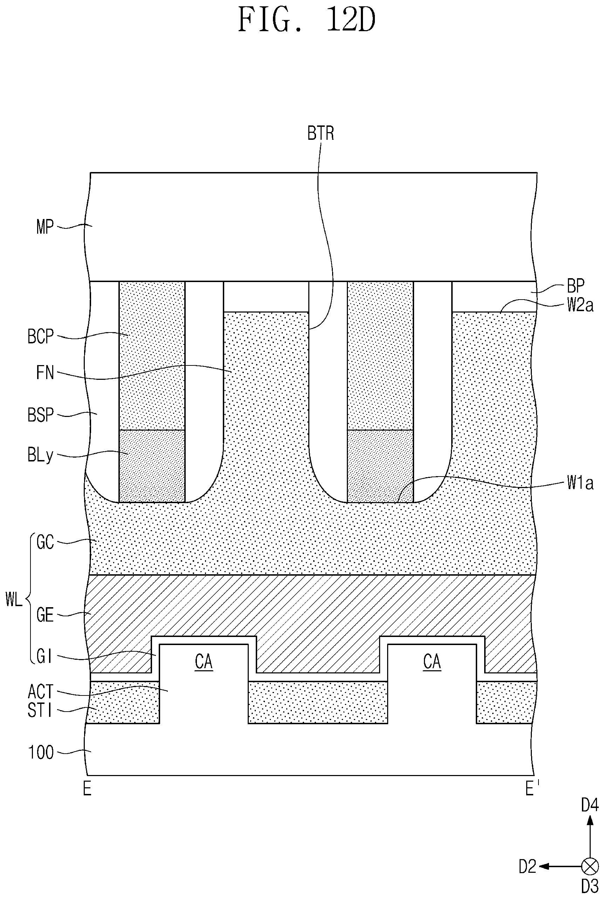

FIG. 11 is a plan view illustrating a semiconductor device according to one or more embodiments of the disclosure. FIGS. 12A to 12D are sectional views corresponding to lines A-A', B-B', D-D', and E-E' of FIG. 11, respectively.

Referring to FIGS. 11 to 12D, the fence pattern FN and the lower storage node contact BCx may not be provided.

The second edge portion E2 of the active pattern ACT may contact the upper storage node contact BCy and the buffer pattern BP. The first top surface E2a of the second edge portion E2 of the active pattern ACT may be located at a level higher than the top surface of the bit line BL. The first top surface E2a of the second edge portion E2 of the active pattern ACT may be located at a level higher than the lowermost surface of the upper storage node contact BCy.

The second active insulating pattern AI2 may contact the upper storage node contact BCy. The word line WL may contact the buffer pattern BP. The second top surface W2a of the word line WL may be located at a level higher than the top surface of the bit line BL and the lowermost surface of the upper storage node contact BCy.

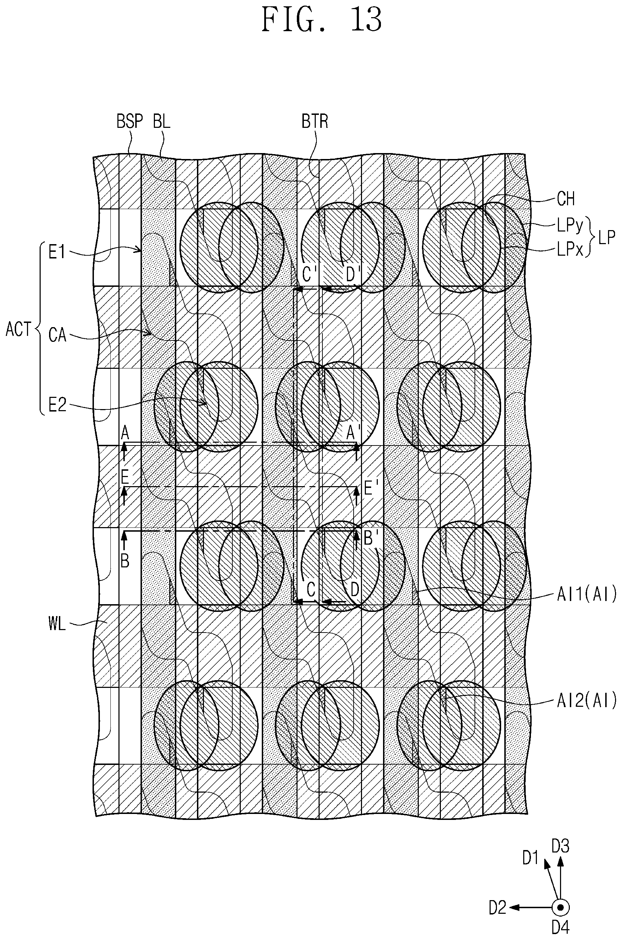

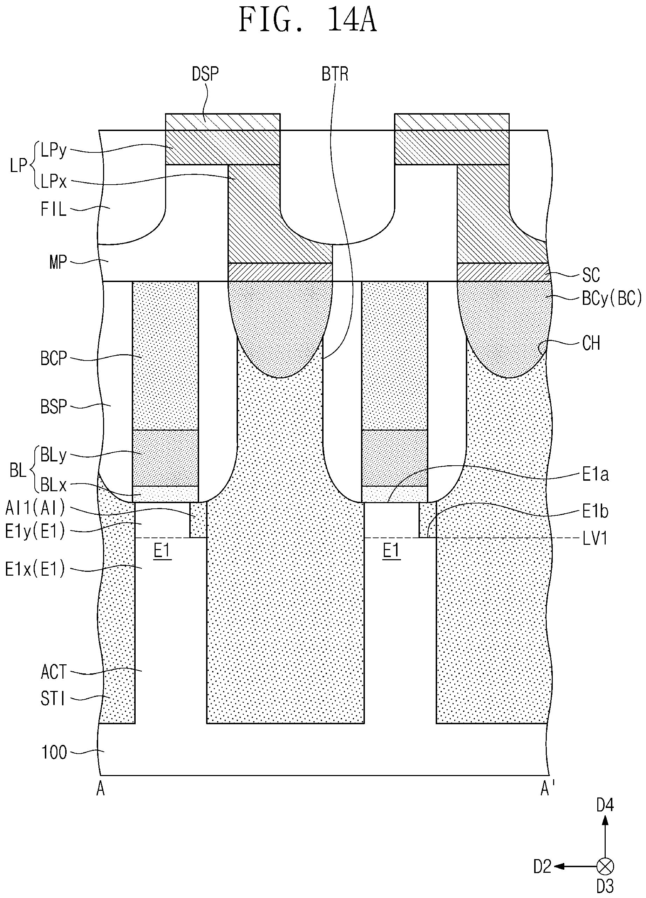

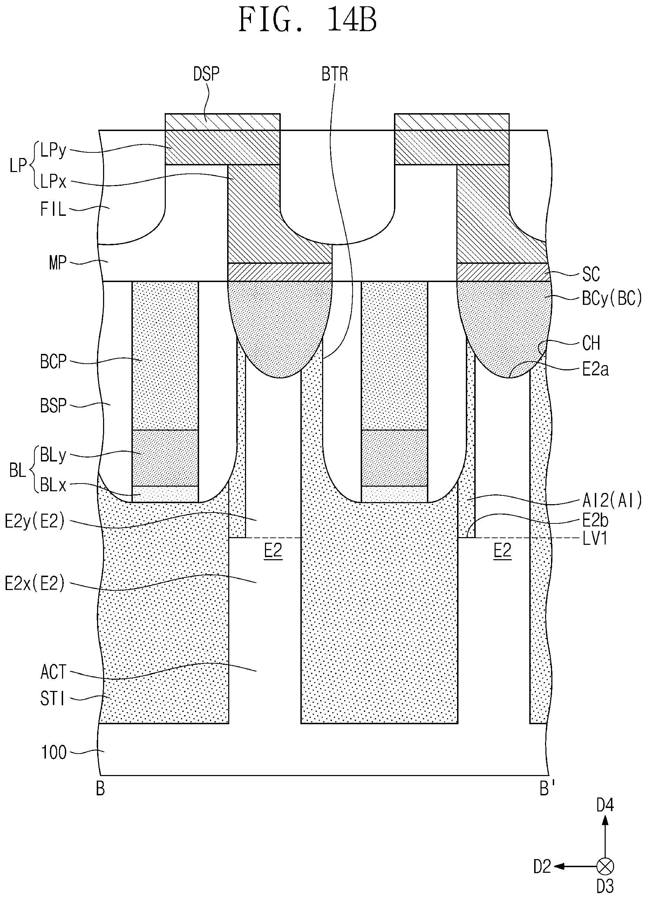

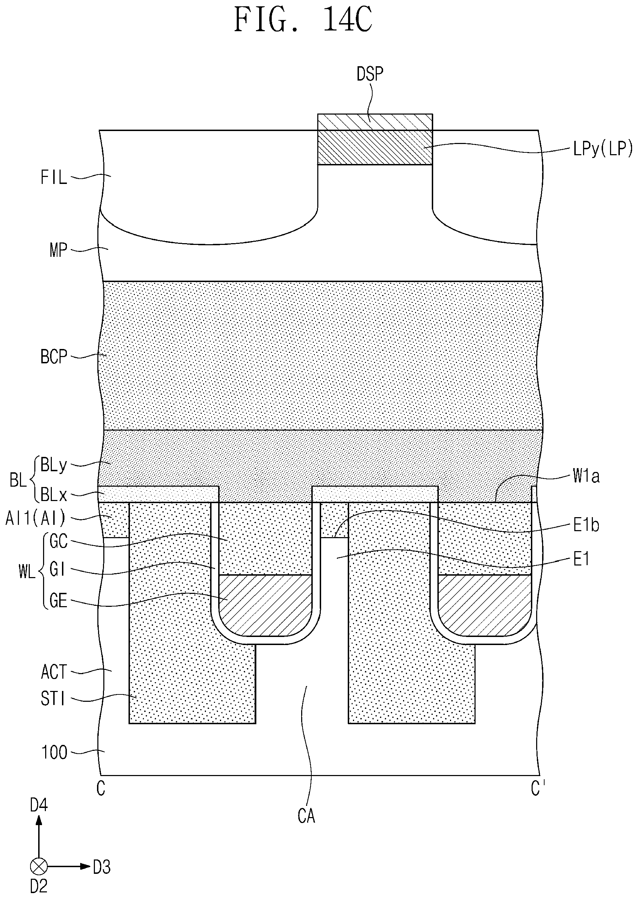

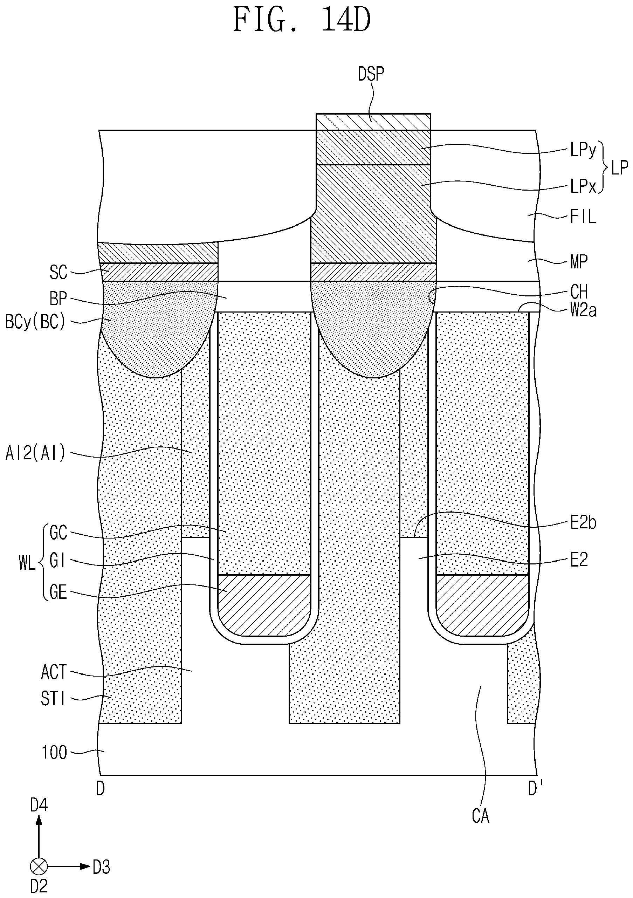

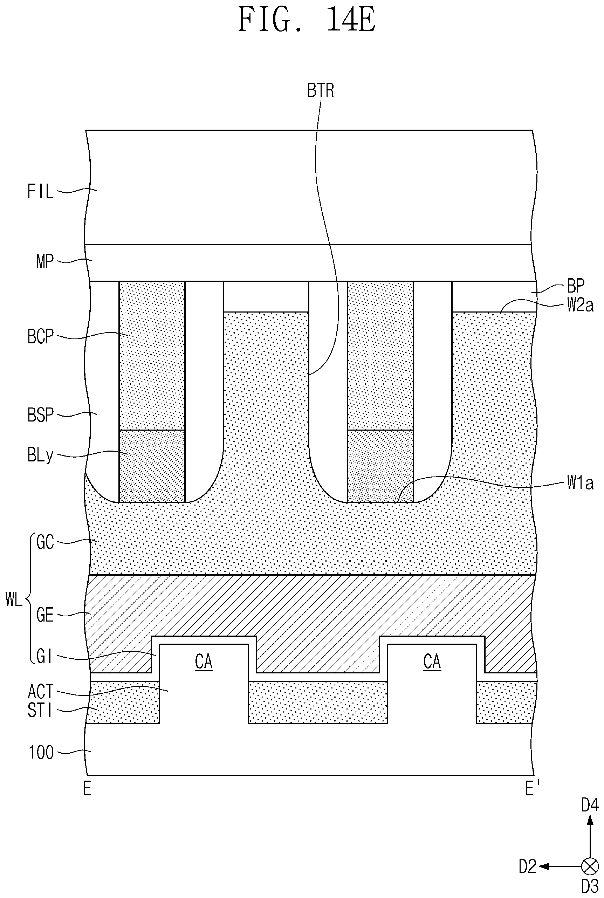

FIG. 13 is a plan view illustrating a semiconductor device according to one or more embodiments of the disclosure. FIGS. 14A to 14E are cross-sectional views corresponding to lines A-A', B-B', C-C', D-D', and E-E' of FIG. 13, respectively, according to one or more embodiments of the disclosure.

Referring to FIGS. 13 to 14E, the fence pattern FN and the lower storage node contact BCx may not be provided. The second edge portion E2 of the active pattern ACT, the second active insulating pattern AI2, and the word line WL may be provided to have substantially the same or similar features as those in the embodiment of FIGS. 11 to 12D.

In a plan view, the contact hole CH may be interposed between the bit lines BL, which are adjacent to each other in the second direction D2. The contact holes CH may be two-dimensionally disposed in the second and third directions D2 and D3. For example, the contact holes CH in a row may be arranged side by side in the second direction D2, and the contact holes CH in a column may be arranged side by side in the third direction D3. In a plan view, the contact holes CH may be vertically overlap the second edge portions E2 of the active patterns ACT with an increased area, as compared to the semiconductor device of FIGS. 11 to 12D. Thus, even when there are a misalignment issue in the contact holes CH, the second edge portion E2 of the active pattern ACT may be easily connected to the upper storage node contact BCy, compared to the semiconductor device described with reference to FIGS. 11 to 12D.

The upper storage node contact BCy and the second silicide pattern SC may be provided in a lower portion of the contact hole CH.

The landing pad LP may include a lower landing pad LPx, which is provided in an upper portion of the contact hole CH, and an upper landing pad LPy, which is provided on the lower landing pad LPx. The lower landing pad LPx may be provided to have the same or similar features as those of the landing pad LP described with reference to FIGS. 1A to 2E. The upper landing pad LPy may be shifted from the lower landing pad LPx in the second direction D2 or an opposite direction thereof. A portion of the upper landing pad LPy may be positioned vertically above and, in some examples, vertically overlap the bit line BL. In an embodiment, a plurality of upper landing pads LPy may be provided. The upper landing pads LPy may be linearly arranged in the second direction D2 and may be arranged in a zigzag shape in the third direction D3. The lower and upper landing pads LPx and LPy may be formed of or include the same or different materials from each other. However, the disclosure is not limited to this example, and the structure and material of the landing pad LP may be modified in various ways within the range that is generally changeable by a skilled person in the art.

A filling pattern FIL may be provided to enclose the upper landing pad LPy. The filling pattern FIL may be interposed between the upper landing pads LPy, which are adjacent to each other. In a plan view, the filling pattern FIL may have a mesh shape with holes, and the upper landing pads LPy may be provided to fill the holes. The filling pattern FIL may be provided to penetrate the upper landing pads LPy. In an embodiment, the filling pattern FIL may be formed of or include at least one of silicon nitride (SiN), silicon oxide (SiO₂), and silicon oxynitride (SiON). In an embodiment, the filling pattern FIL may include an empty space with an air layer (e.g., an air gap).

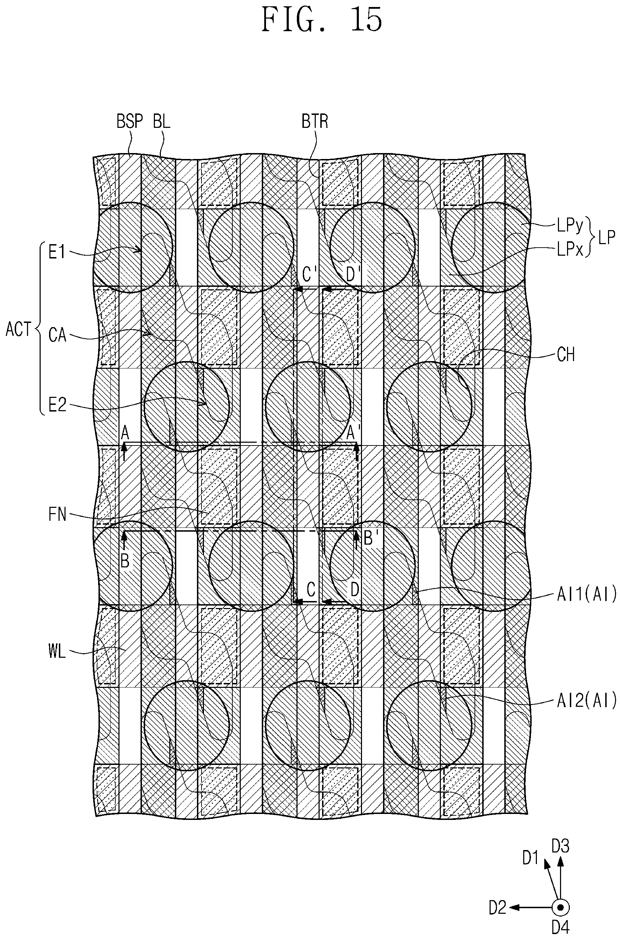

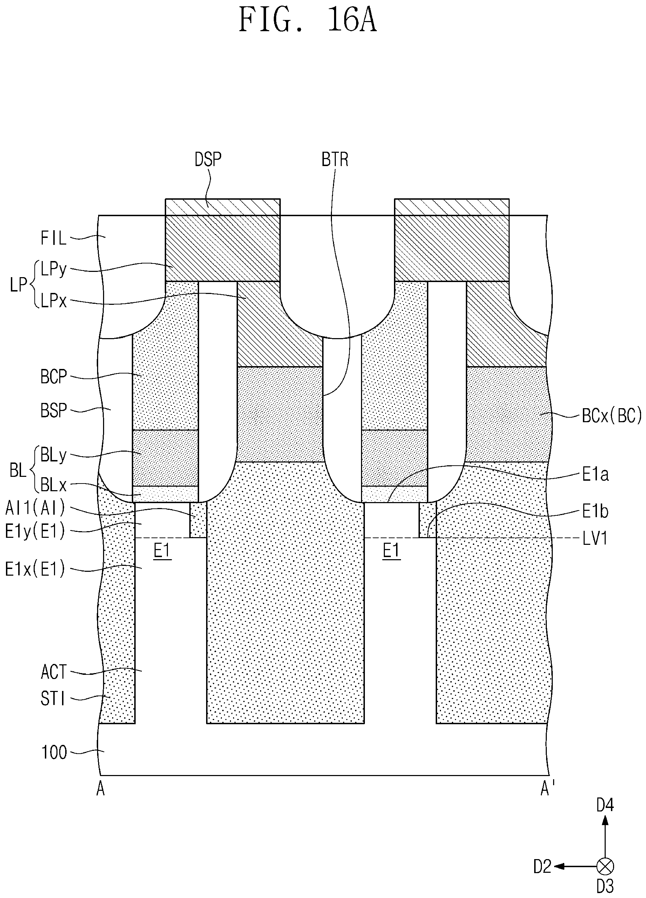

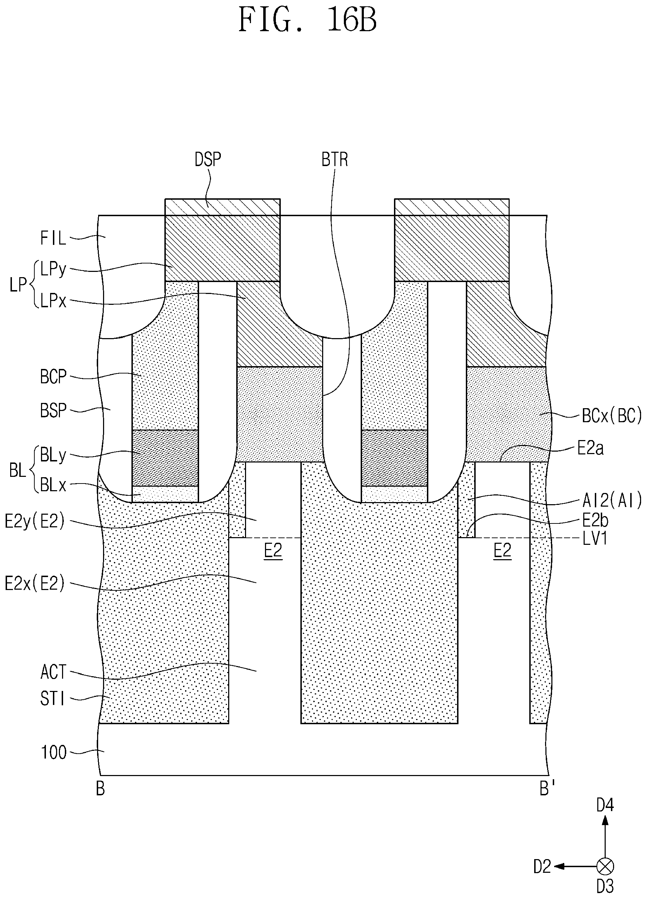

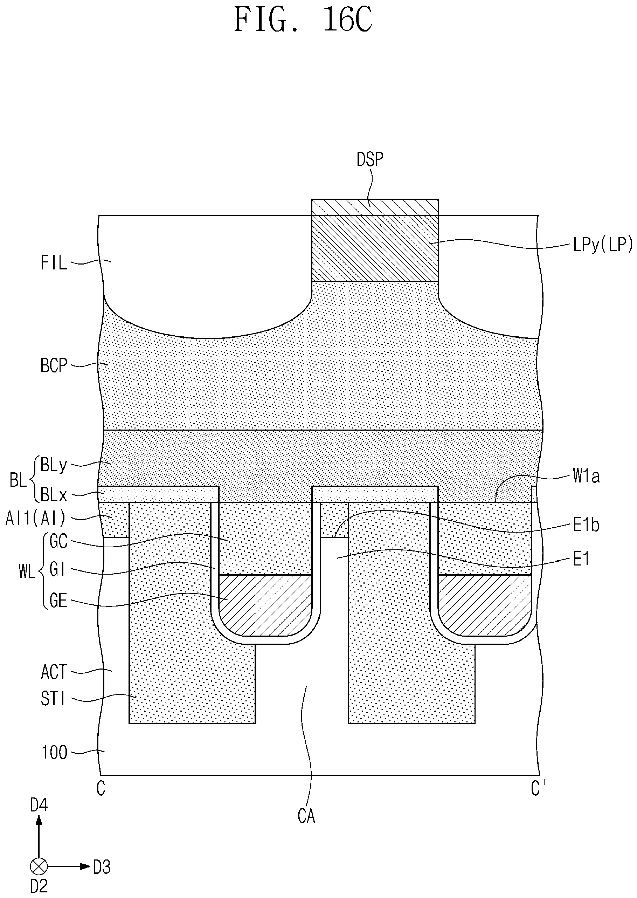

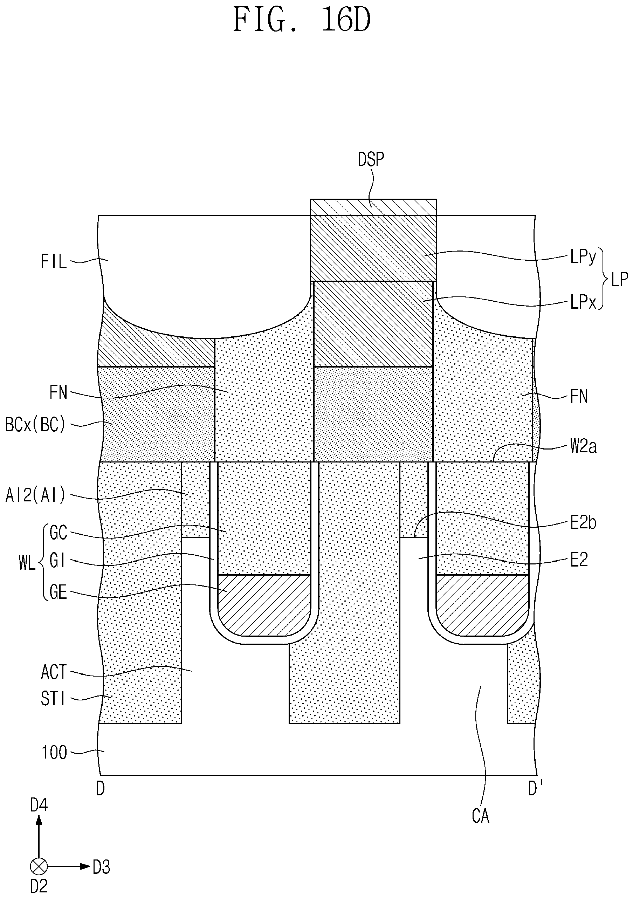

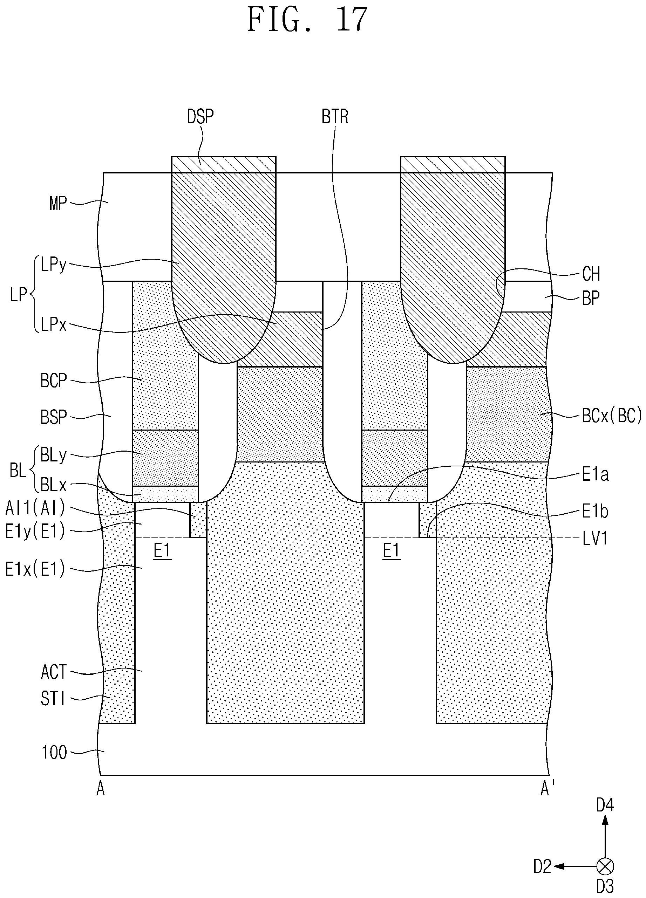

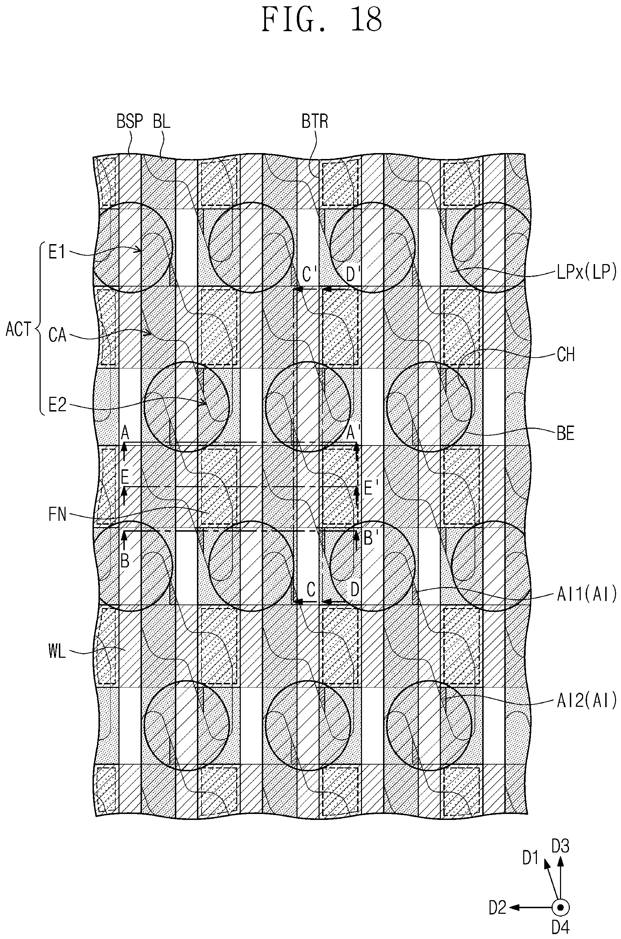

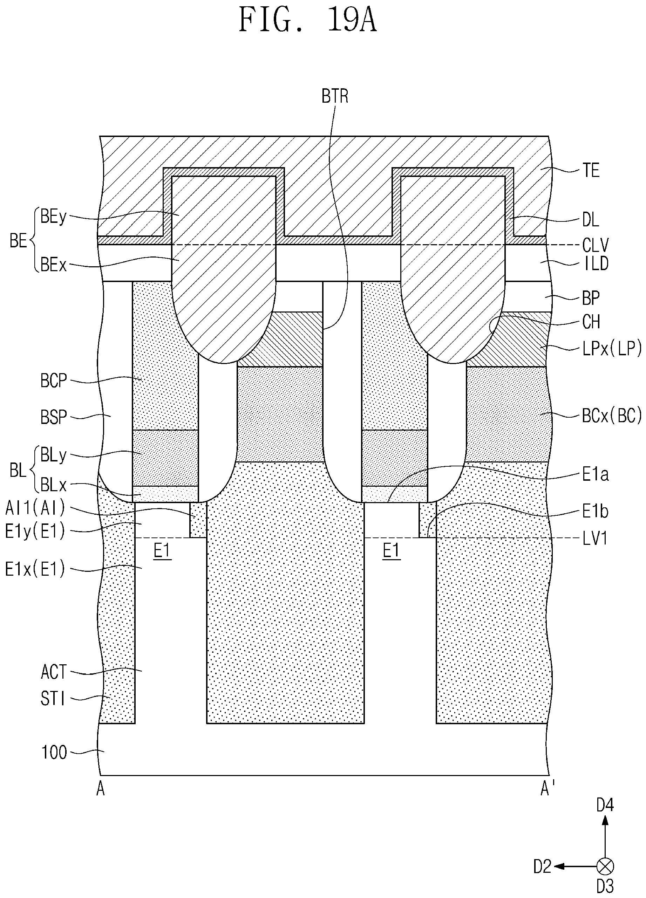

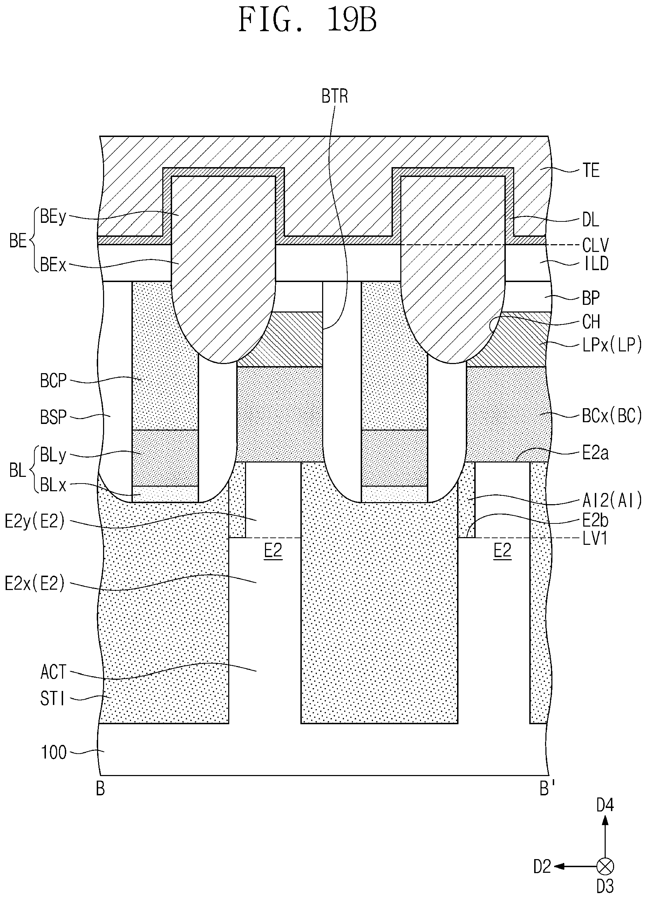

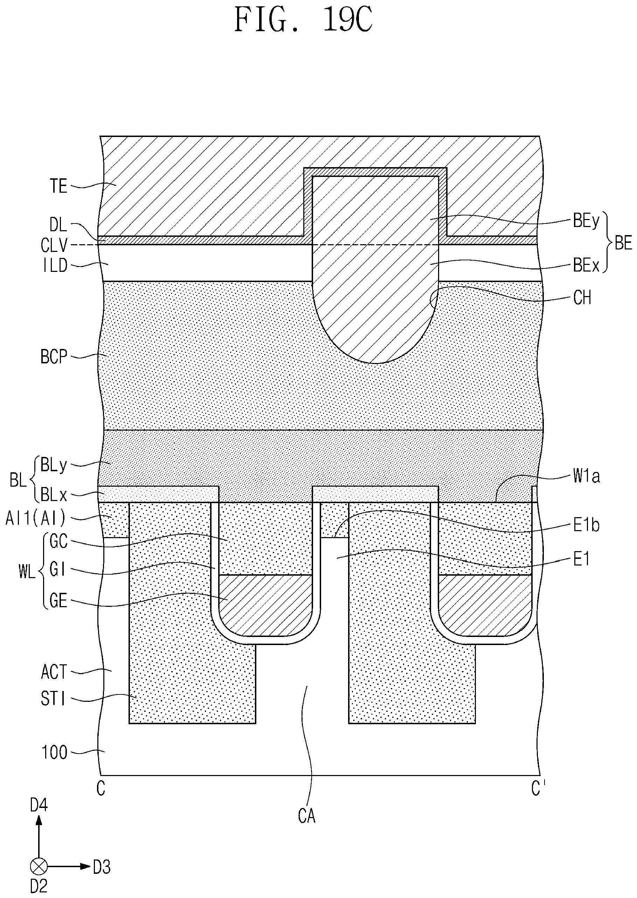

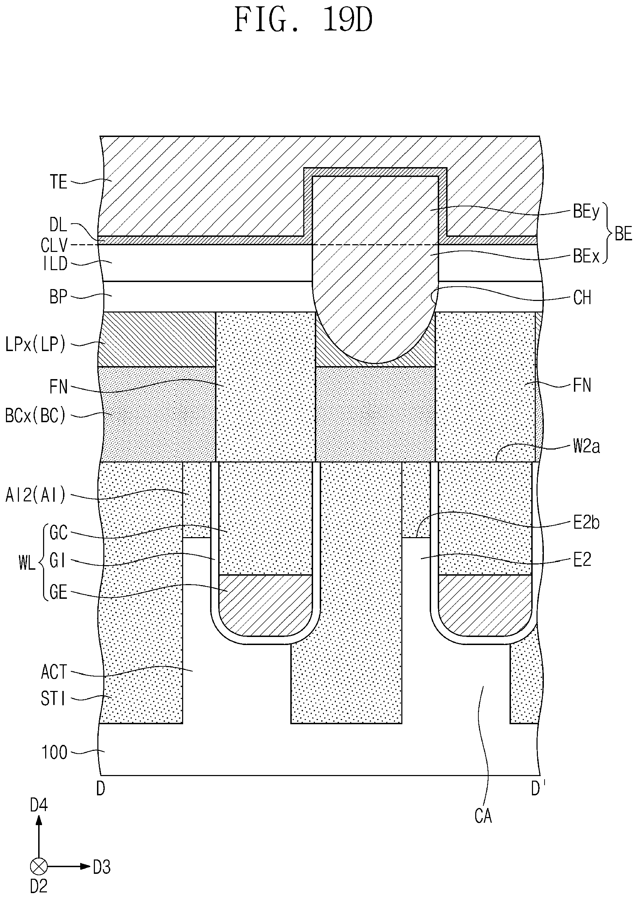

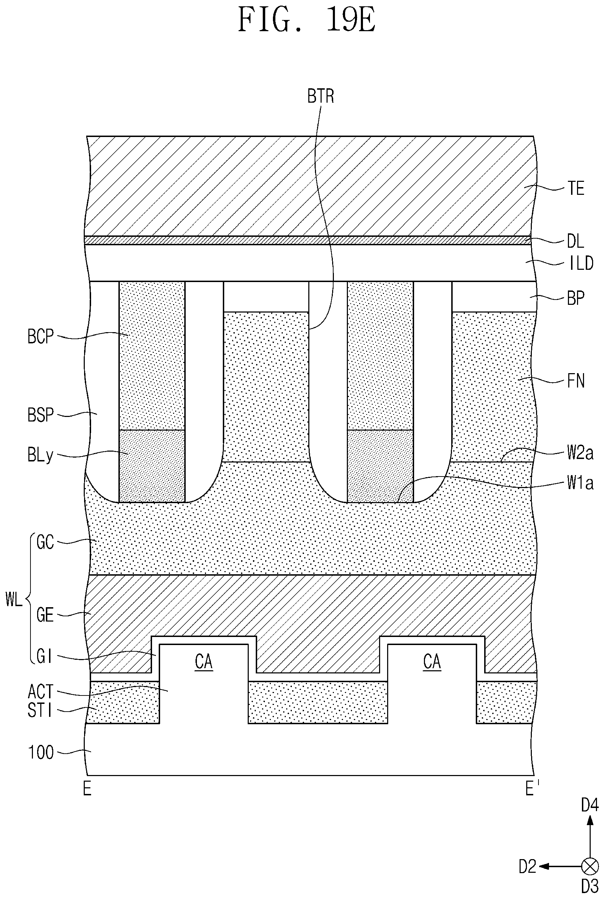

FIG. 15 is a plan view illustrating a semiconductor device according to one or more embodiments of the disclosure. FIGS. 16A to 16D are cross-sectional views corresponding to lines A-A', B-B', C-C', and D-D' of FIG. 15, respectively, according to one or more embodiments of the disclosure. FIG. 17 is a cross-sectional view corresponding to the line A-A' of FIG. 15, according to one or more embodiments of the disclosure. FIG. 18 is a plan view illustrating a semiconductor device according to one or more embodiments of the disclosure. FIGS. 19A to 19E are cross-sectional views corresponding to lines A-A', B-B', C-C', D-D', and E-E' of FIG. 18, respectively, according to one or more embodiments of the disclosure.

Referring to FIGS. 15 to 19E, the lower landing pad LPx may be provided on the lower storage node contact BCx. The lower landing pad LPx may contact the top surface of the lower storage node contact BCx. The lower landing pad LPx may be interposed between the bit line capping patterns BCP, which are adjacent to each other in the second direction D2. The lower landing pad LPx may be interposed between the fence patterns FN, which are adjacent to each other in the third direction D3.

In an embodiment, a plurality of lower landing pads LPx may be provided. The lower landing pads LPx may be spaced apart from each other in the second and third directions D2 and D3. The lower landing pads LPx, which are adjacent to each other in the second direction D2, may be spaced apart from each other, with the bit line capping pattern BCP interposed therebetween. The lower landing pads LPx, which are adjacent to each other in the third direction D3, may be spaced apart from each other, with the fence pattern FN interposed therebetween.

Referring to FIGS. 16A to 16D, a top surface of the lower landing pad LPx may be located at substantially the same level as the top surface of the bit line capping pattern BCP. Referring to FIGS. 17 and 19A to 19E, the top surface of the lower landing pad LPx may be located at a level lower than the top surface of the bit line capping pattern BCP.

The upper storage node contact BCy and the second silicide pattern SC may not be provided.

Referring to FIGS. 15 to 16D, the mold pattern MP may not be provided. The upper landing pad LPy may be provided on the lower landing pad LPx. The upper landing pad LPy may contact the bit line capping pattern BCP, the bit line spacer BSP, and the lower landing pad LPx. The upper landing pad LPy and the filling pattern FIL may be provided to have substantially the same or similar features as those in the embodiment of FIGS. 13 to 14E.

Referring to FIG. 17, the lower landing pad LPx may be interposed between the buffer pattern BP and the lower storage node contact BCx. The upper landing pad LPy may be provided in the contact hole CH. The upper landing pad LPy may be provided to fill the contact hole CH. The upper landing pad LPy may contact the bit line capping pattern BCP and the bit line spacer BSP. The upper landing pad LPy may contact the lower landing pad LPx at a level lower than the bottom surface of the mold pattern MP. A top surface of the upper landing pad LPy may be located at substantially the same level as a top surface of the mold pattern MP. The lowermost surface of the upper landing pad LPy may be located at a level lower than the top surface of the lower landing pad LPx.

Referring to FIGS. 18 to 19E, the mold pattern MP may not be provided. An interlayer insulating layer ILD may be provided on the substrate 100. For example, the interlayer insulating layer ILD may be provided on the bit line capping pattern BCP and the buffer pattern BP. The interlayer insulating layer ILD may be formed of or include at least one of silicon nitride, silicon oxide, or silicon oxynitride. In an embodiment, the interlayer insulating layer ILD may include an empty region. The contact holes CH may be provided to penetrate the interlayer insulating layer ILD, and in a plan view, the interlayer insulating layer ILD may have a mesh shape with the contact holes CH.

A bottom electrode BE may be provided on the lower landing pad LPx. The bottom electrode BE may include a lower portion BEx, which is lower than a contact level CLV, and an upper portion BEy, which is higher than the contact level CLV. The contact level CLV may be defined as a vertical level of a top surface of the interlayer insulating layer ILD. The lower and upper portions BEx and BEy of the bottom electrode BE may contact each other, without an interface therebetween, at the contact level CLV, but the disclosure is not limited to this example.

The lower portion BEx of the bottom electrode BE may be provided in the contact hole CH. The lower portion BEx of the bottom electrode BE may fill an inner space of the contact hole CH. The lower portion BEx of the bottom electrode BE may contact the bit line capping pattern BCP, the bit line spacer BSP, and the lower landing pad LPx. The lowermost surface of the lower portion BEx of the bottom electrode BE may be located at a level lower than the top surface of the lower landing pad LPx.

The upper portion BEy of the bottom electrode BE may be provided on the lower portion BEx of the bottom electrode BE. The upper portion BEy of the bottom electrode BE may have a pillar shape. In an embodiment, the upper portion BEy of the bottom electrode BE may have a hollow cylindrical shape with one closed end. Alternatively, the upper portion BEy of the bottom electrode BE may include a pillar-shaped lower portion and a hollow cylindrical upper portion.

In an embodiment, a plurality of bottom electrodes BE may be provided. The bottom electrodes BE may be spaced apart from each other in the second and third directions D2 and D3. In an embodiment, in a plan view, the bottom electrodes BE may be arranged in a honeycomb shape. In detail, each of the bottom electrodes BE may be placed at the center of a hexagon defined by other six bottom electrodes BE. However, the disclosure is not limited to this example.

A top electrode TE may be provided on the bottom electrode BE. For example, the top electrode TE may cover or at least partially cover a top surface of the upper portion BEy of the bottom electrode BE and may enclose and cover a side surface of the upper portion BEy of the bottom electrode BE. The top electrode TE may be provided to fill a space between the upper portions BEy of the bottom electrodes BE.

Each of the bottom and top electrodes BE and TE may include a conductive material. For example, each of the bottom and top electrodes BE and TE may be formed of or include at least one of doped silicon (Si), doped silicon germanium (SiGe), metallic materials (e.g., Ti, Mo, W, Cu, Al, Ta, Ru, Ir, Co, Pt, Au, and Ag), metal nitride materials (e.g., nitride materials containing Ti, Mo, W, Cu, Al, Ta, Ru, Ir, Co, Pt, Au, or Ag, titanium silicon nitride (TiSiN), titanium aluminum nitride (TiAlN), tantalum aluminum nitride (TaAlN)), conductive oxide materials (e.g., PtO, RuO₂, IrO₂, SRO (SrRuO₃), BSRO ((Ba,Sr)RuO₃), CRO (CaRuO₃), and LSCo), and metal silicide materials. Each of the bottom and top electrodes BE and TE may be a single layer, which is made of a single material, or a composite layer including two or more materials.

A dielectric layer DL may be interposed between the top electrode TE and each of the upper portions BEy of the bottom electrodes BE and between the top electrode TE and the interlayer insulating layer ILD. The dielectric layer DL may be provided to conformally cover the upper portions BEy of the bottom electrodes BE. The dielectric layer DL may be formed of or include at least one of metal oxides (e.g., HfO₂, ZrO₂, Al₂O₃, La₂O₃, Ta₂O₃, and TiO₂) and perovskite dielectric materials (e.g., STO (SrTiO₃), BST ((Ba,Sr)TiO₃), BaTiO₃, PZT, and PLZT).

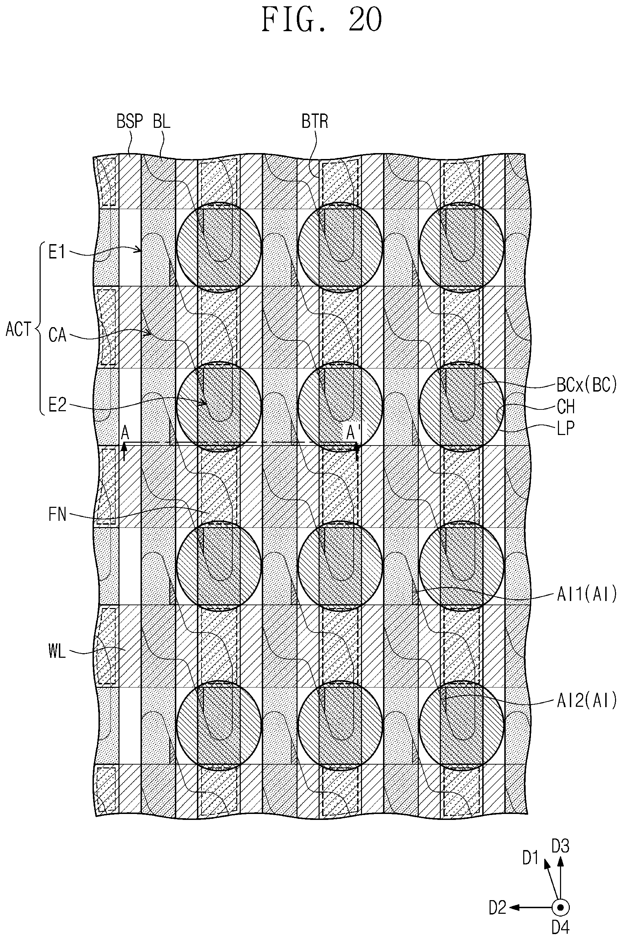

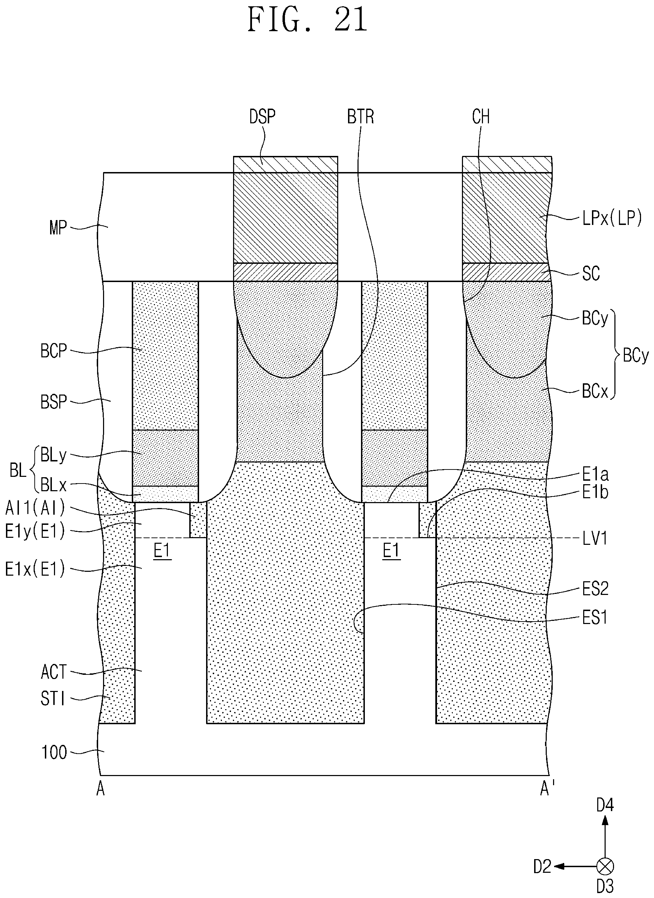

FIG. 20 is a plan view illustrating a semiconductor device according to one or more embodiments of the disclosure. FIG. 21 is a cross-sectional view corresponding to a line A-A' of FIG. 20, according to one or more embodiments of the disclosure.

Referring to FIGS. 20 and 21, the contact holes CH may be provided to have substantially the same or similar features as those in the embodiment of FIGS. 13 to 14E. In a plan view, the upper storage node contact BCy, the second silicide pattern SC, and the lower landing pad LPx may be interposed between the bit lines BL, which are adjacent to each other in the second direction D2. However, the upper landing pad LPy and the filling pattern FIL may not be provided, unlike the embodiment of FIGS. 13 to 14E.

The data storage pattern DSP may be disposed on the lower landing pad LPx and may be aligned to the lower landing pad LPx. In an embodiment, the data storage pattern DSP may contact the lower landing pad LPx. Thus, the data storage patterns DSP may be two-dimensionally arranged in the second and third directions D2 and D3. As an example, the data storage patterns DSP in a row may be arranged side by side in the second direction D2, and the data storage patterns DSP in a column may be arranged side by side in the third direction D3.

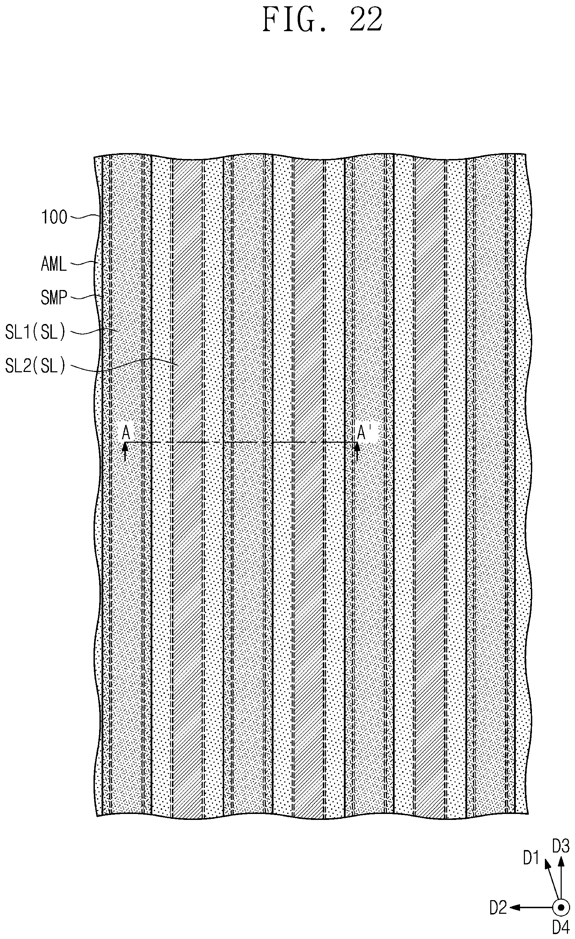

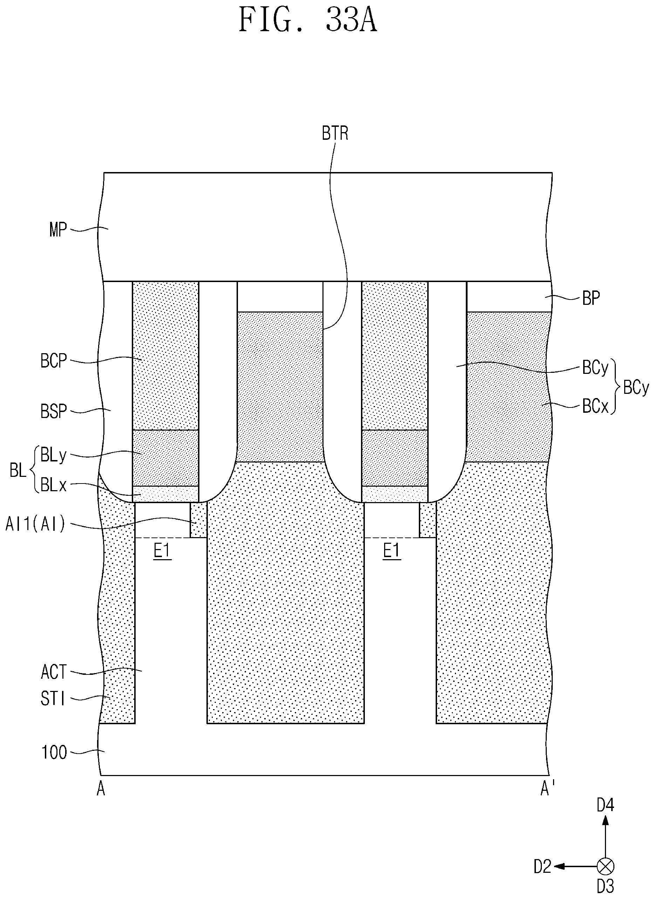

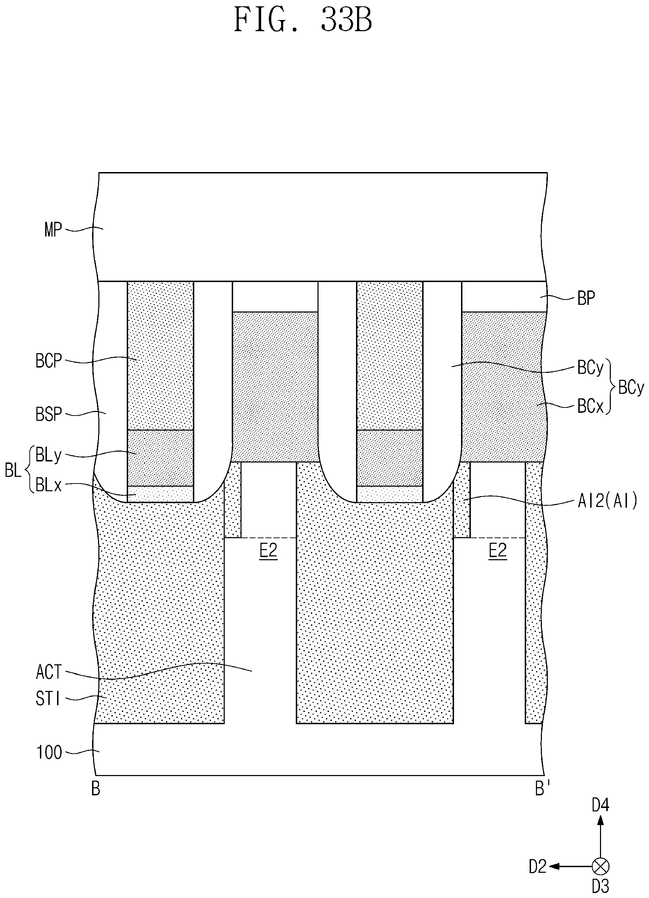

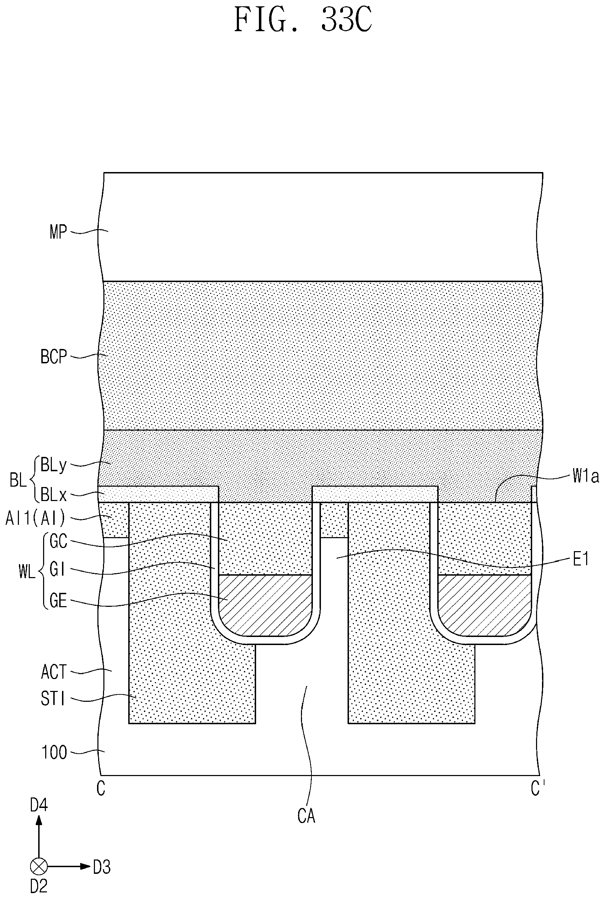

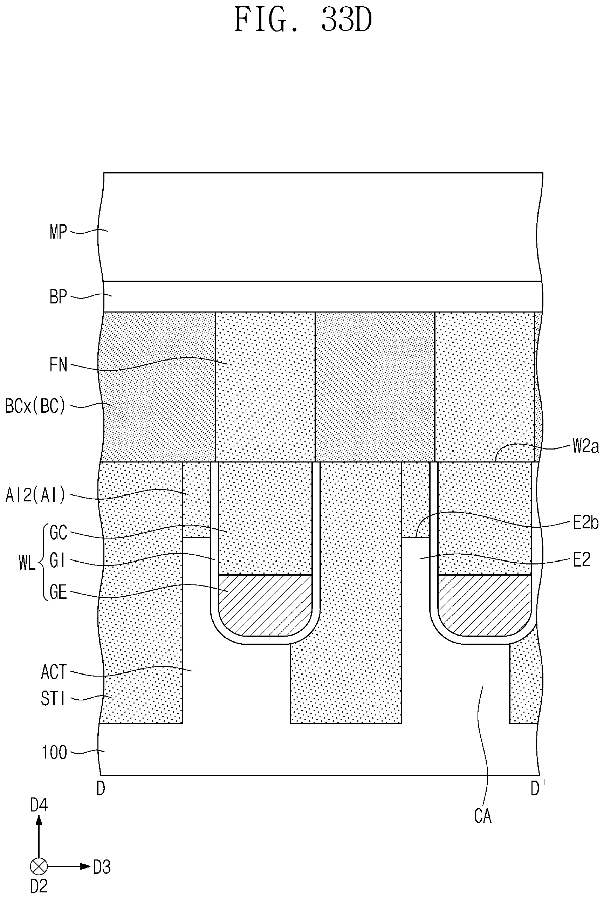

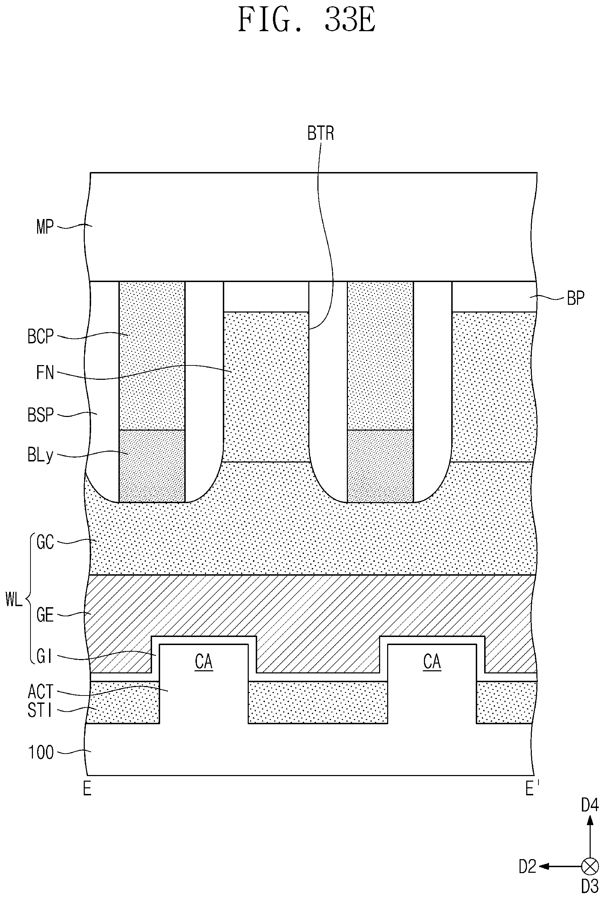

Hereinafter, a method of fabricating a semiconductor device, according to an embodiment of the disclosure, will be described in more detail with reference to FIGS. 22 to 59C. In the following description, a previously-described element may be identified by the same reference number without repeating an overlapping description thereof, for concise description. Therefore, repeated descriptions of aspects similar to those described above may be omitted

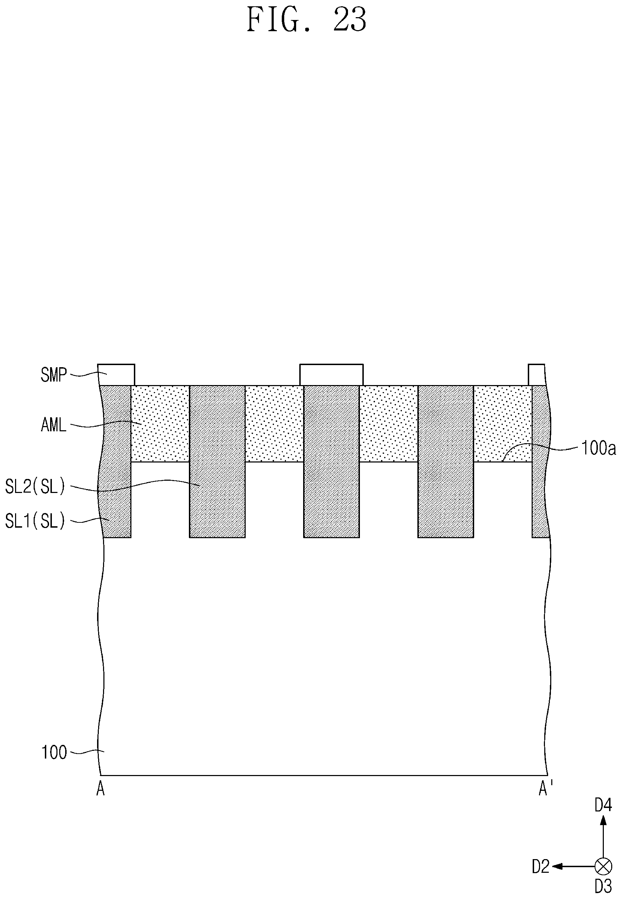

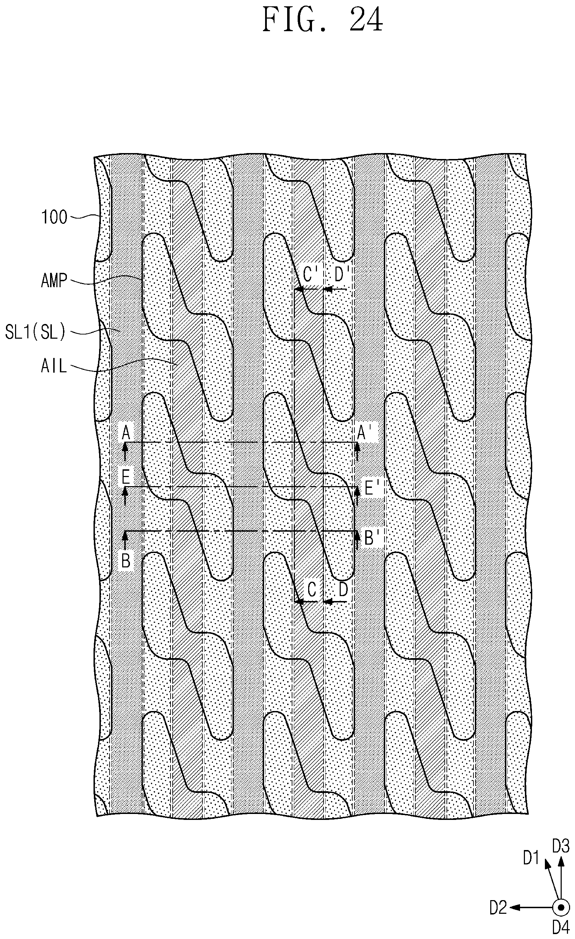

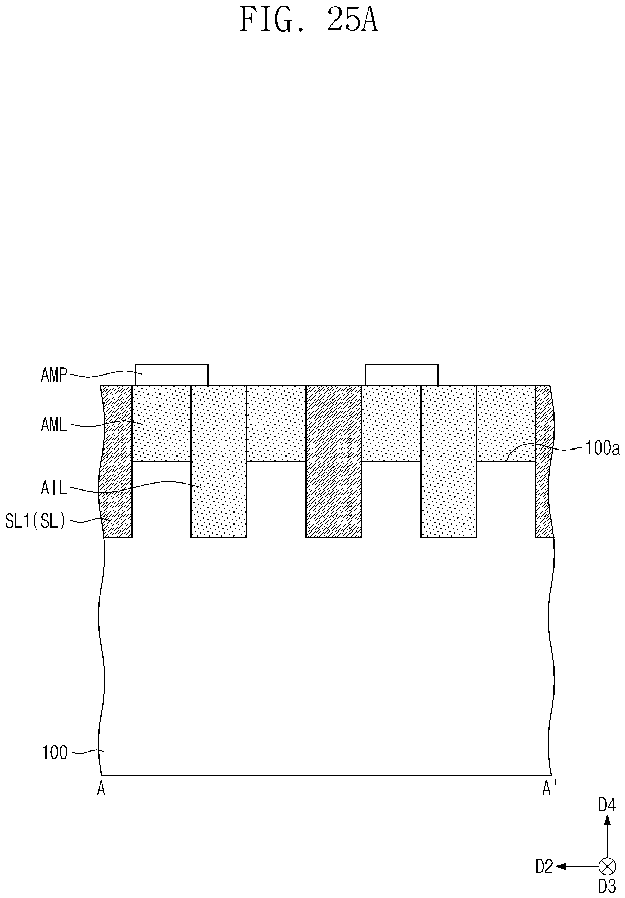

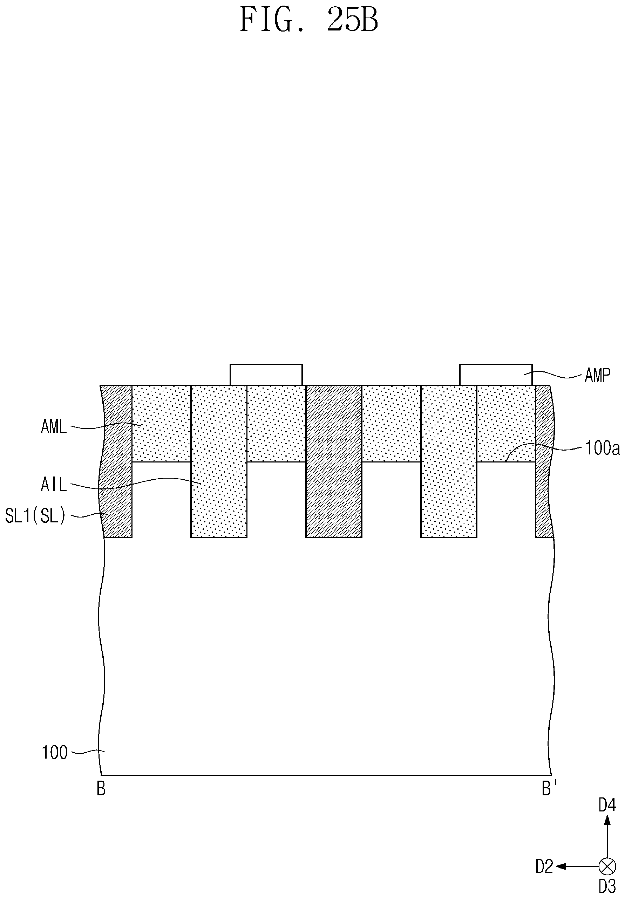

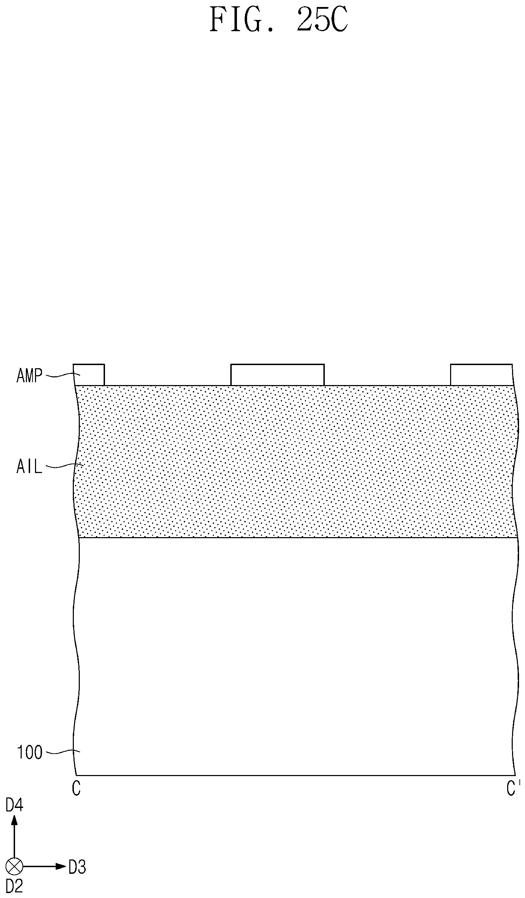

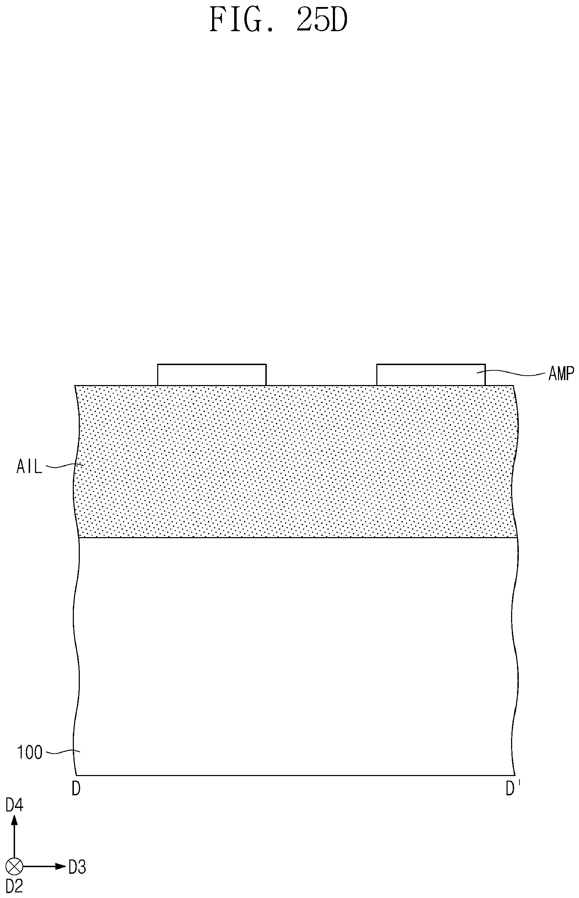

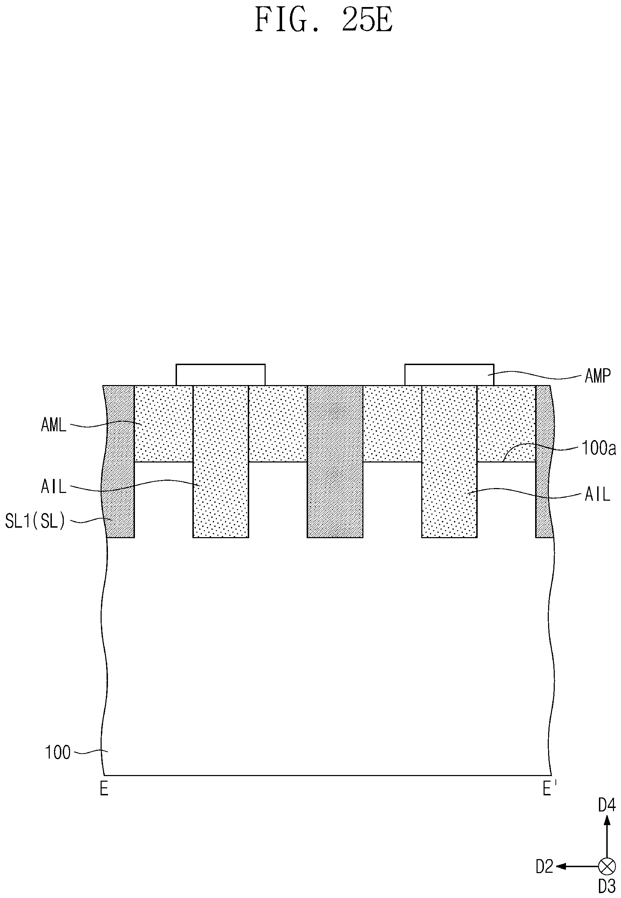

FIGS. 22 to 33E are diagrams illustrating a method of fabricating a semiconductor device, according to one or more embodiments of the disclosure. In detail, FIGS. 22, 24, 26, 28, 30, and 32 are plan views illustrating a method of fabricating a semiconductor device, according to one or more embodiments of the disclosure. FIGS. 23A, 25A, 27A, 29A, 31A, and 33A are cross-sectional views corresponding to lines A-A' of FIGS. 22, 24, 26, 28, 30, and 32, respectively, according to one or more embodiments of the disclosure. FIGS. 25B, 27B, 29B, 31B, and 33B are cross-sectional views corresponding to lines B-B' of FIGS. 24, 26, 28, 30, and 32, respectively, according to one or more embodiments of the disclosure. FIGS. 25C, 27C, 29C, 31C, and 33C are cross-sectional views corresponding to lines C-C' of FIGS. 24, 26, 28, 30, and 32, respectively, according to one or more embodiments of the disclosure. FIGS. 25D, 27D, 29D, 31D, and 33D are cross-sectional views corresponding to lines D-D' of FIGS. 24, 26, 28, 30, and 32, respectively, according to one or more embodiments of the disclosure. FIGS. 25E, 27E, 29E, 31E, and 33E are cross-sectional views corresponding to lines E-E' of FIGS. 24, 26, 28, 30, and 32, respectively, according to one or more embodiments of the disclosure.

Referring to FIGS. 22 and 23, the substrate 100 may be prepared. Sacrificial lines SL may be formed on the substrate 100. In an embodiment, the formation of the sacrificial lines SL may include forming an active mold layer on the substrate 100, partially removing the active mold layer to form active mold lines AML, and forming the sacrificial lines SL in empty regions that are formed by the partial removing of the active mold layer. An upper portion of the substrate 100 may be recessed to a specific depth during the removal process of the active mold layer. Bottom surfaces of the sacrificial lines SL may be located at a level lower than the uppermost surface 100a of the substrate 100. The active mold line AML may be formed of or include silicon nitride (SiN). The sacrificial line SL may be formed of or include at least one carbon-containing material (e.g., Spin-on Hardmask (SOH) and Amorphous Carbon Layer (ACL)).

The active mold lines AML and the sacrificial lines SL may extend in the third direction D3, on the substrate 100. The active mold lines AML and the sacrificial lines SL may be alternately disposed in the second direction D2.

Sacrificial mask patterns SMP may be formed on top surfaces of the sacrificial lines SL to extend in the third direction D3. The sacrificial mask patterns SMP may be formed on the top surfaces of some, but not all, of the sacrificial lines SL. The sacrificial lines SL under sacrificial mask patterns SMP will be referred to as first sacrificial lines SL1, and the others will be referred to as second sacrificial lines SL2. The first sacrificial lines SL1 and the second sacrificial lines SL2 may be alternately disposed in the second direction D2.

Referring to FIGS. 24 and 25E, active insulating lines AIL may be formed on the substrate 100. In an embodiment, the formation of the active insulating lines AIL may include sequentially removing the second sacrificial lines SL2 and the sacrificial mask patterns SMP and forming the active insulating lines AIL to fill empty regions that are formed by the removing of the second sacrificial lines SL2. The sacrificial mask pattern SMP may prevent the first sacrificial lines SL1 from being removed during the removal process of the second sacrificial lines SL2. The active insulating lines AIL may extend in the third direction D3, on the substrate 100. The active insulating line AIL may be interposed between the active mold lines AML, which are adjacent to each other in the second direction D2.

Active mask patterns AMP may be formed on the substrate 100. In an embodiment, the active mask pattern AMP may be formed of or include polysilicon. In an embodiment, the formation of the active mask patterns AMP may include forming an active mask layer on the substrate 100, performing a first patterning process on the active mask layer to form active mask lines, and performing a second patterning process on the active mask line to form the active mask patterns AMP.

During the first patterning process, the active mask layer may be divided into a plurality of active mask lines, which are elongated in the first direction D1. Each of side surfaces of the active mask lines may have a wavy profile. In an embodiment, each of the side surfaces of the active mask lines may have a linear profile. The active mask lines may be spaced apart from each other in the third direction D3. The first patterning process may include performing an exposure process one time. Alternatively, the first patterning process may include performing the exposure process two or more times; that is, the first patterning process may be performed using a multi-patterning technology.

During the second patterning process, each of the active mask lines may be divided into a plurality of active mask patterns AMP, which are spaced apart from each other in the first direction D1. As a result of the first and second patterning processes, the active mask patterns AMP may be formed to have the same or similar profile as the profile of the active pattern ACT described with reference to FIGS. 3A to 3F, in a plan view.

The profile of the active pattern ACT may be variously changed, depending on the profile and disposition of the active mask pattern AMP to be described below. For example, the final profile of the active pattern ACT may be the same as that shown in FIGS. 3A to 3F, according to the profile and disposition of the active mask pattern AMP.

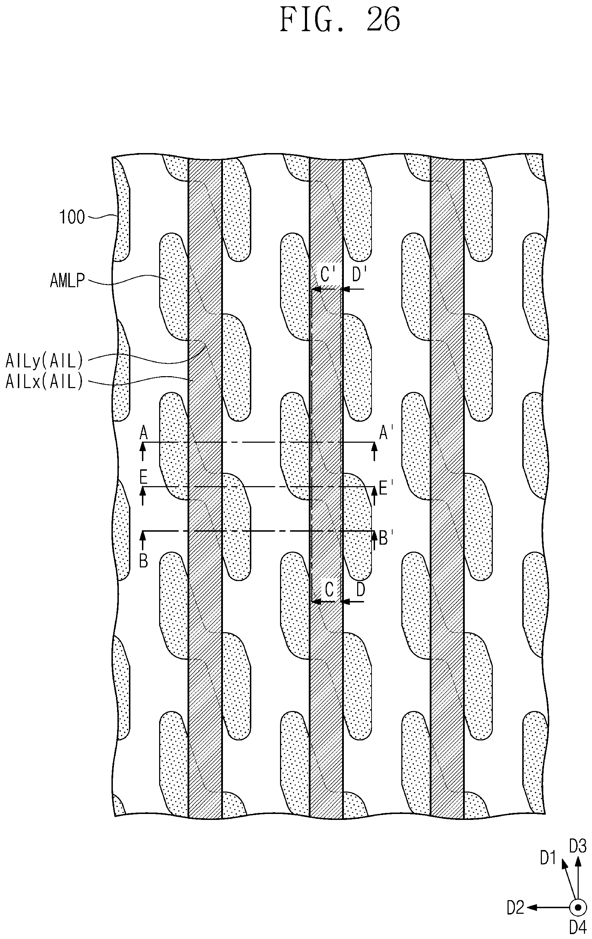

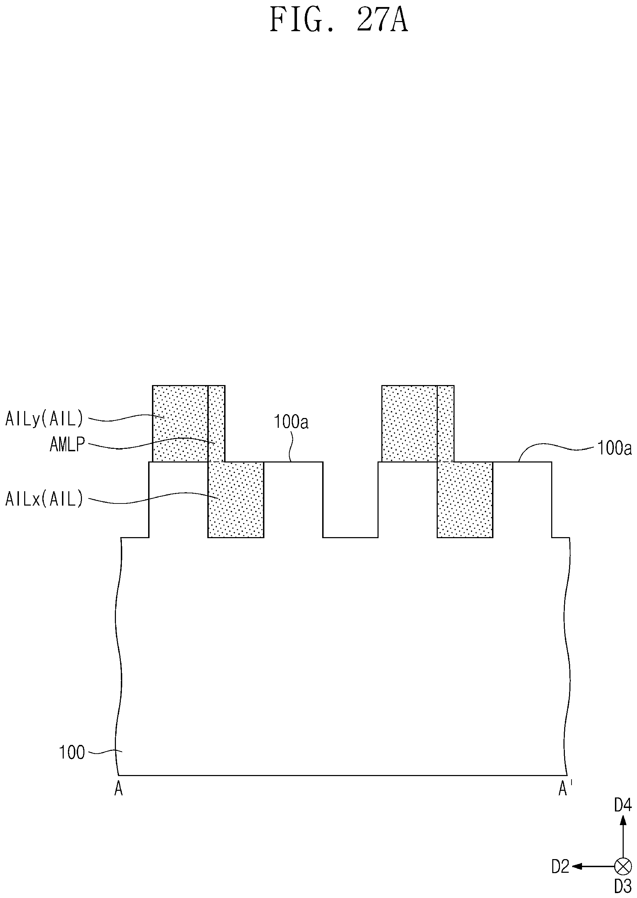

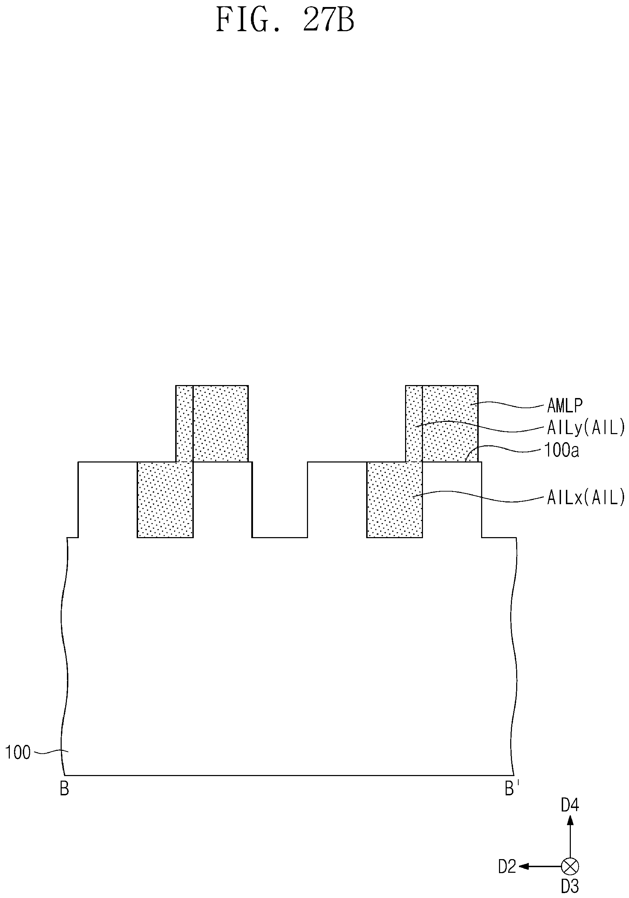

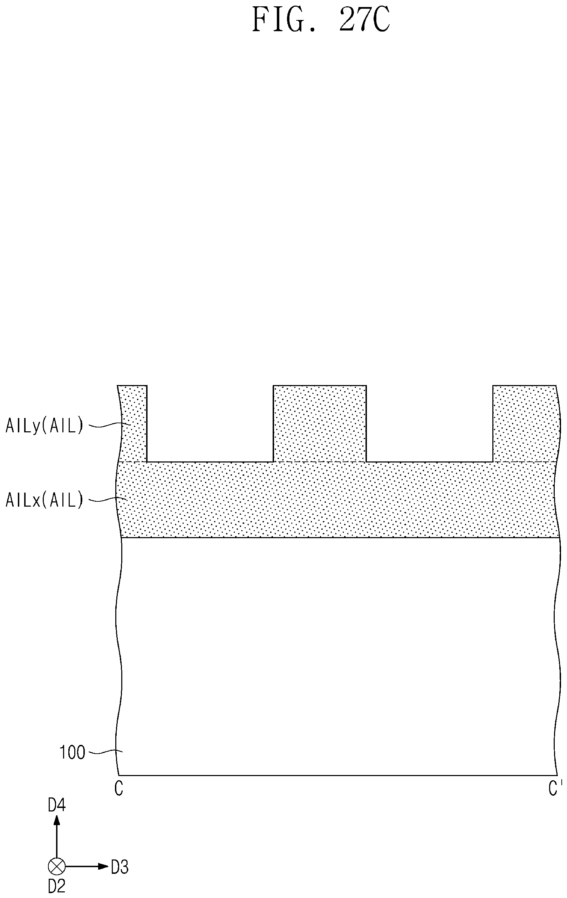

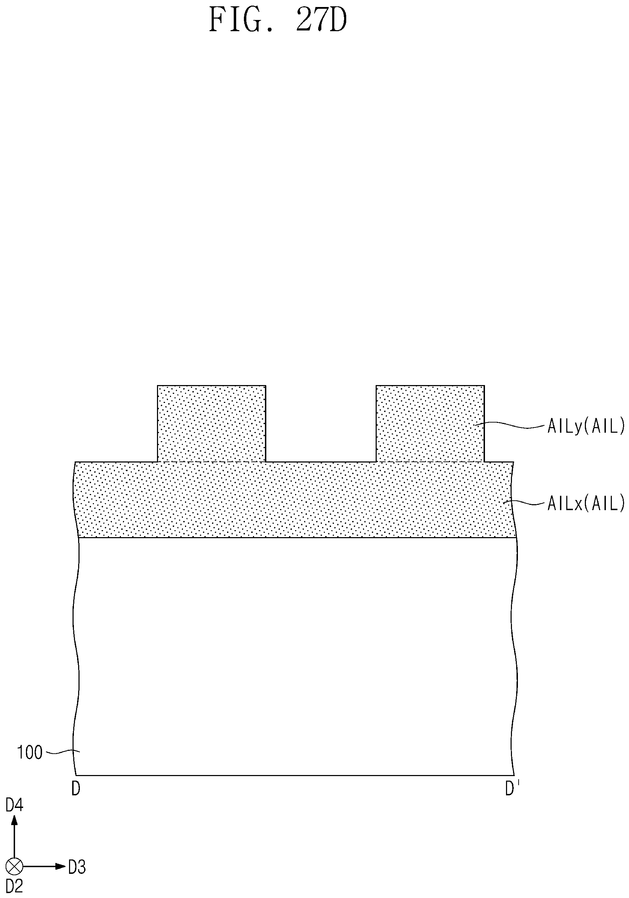

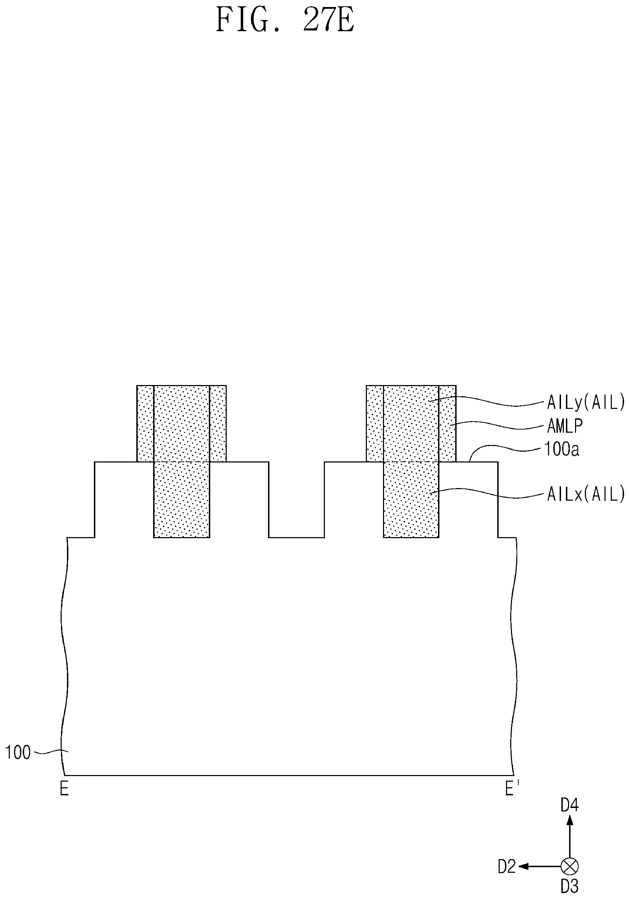

Referring to FIGS. 26 to 27E, a removal process using the active mask patterns AMP as an etch mask may be performed on a portion of the active mold lines AML, a portion of the first sacrificial lines SL1, and a portion of the active insulating lines AIL. In this case, remaining portions of the active mold lines AML may form active mold patterns AMLP, which are spaced apart from each other in the first and third directions D1 and D3.

The active insulating line AIL may include an upper active insulating line AILy and a lower active insulating line AILx. The upper active insulating line AILy may be an upper portion of the active insulating line AIL, which is patterned during the removal process on the active insulating line AIL, and the lower active insulating line AILx may be a lower portion of the active insulating line AIL that is not patterned. The upper active insulating line AILy may be interposed between the active mold patterns AMLP, which are adjacent to each other in the first direction D1. In a plan view, the active mold patterns AMLP, which are adjacent to each other in the first direction D1, and the upper active insulating line AILy, which are placed between the active mold patterns AMLP, may have substantially the same or similar profile as the profile of the active pattern ACT described with reference to FIGS. 3A to 3F.

Thereafter, the active mask patterns AMP and the first sacrificial lines SL1 may be sequentially removed from the substrate 100.

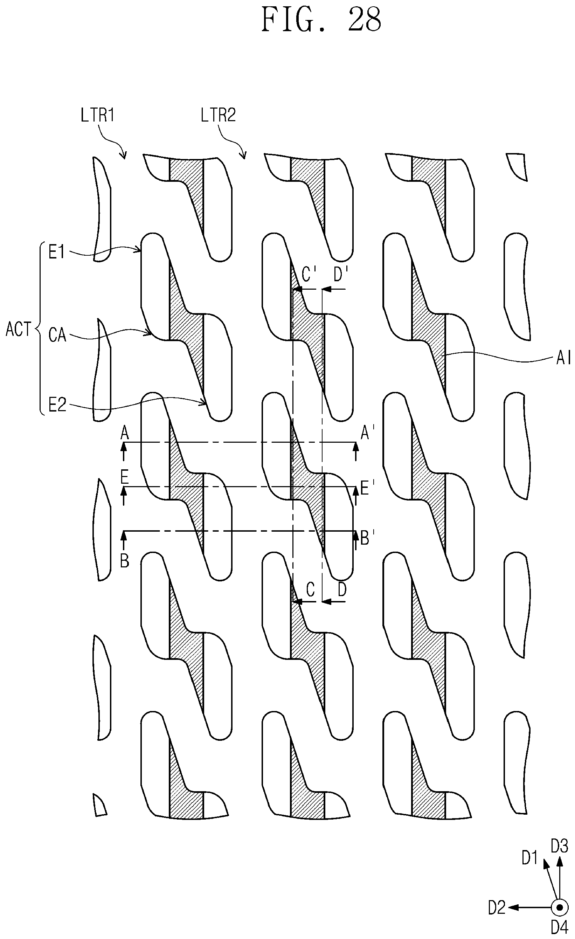

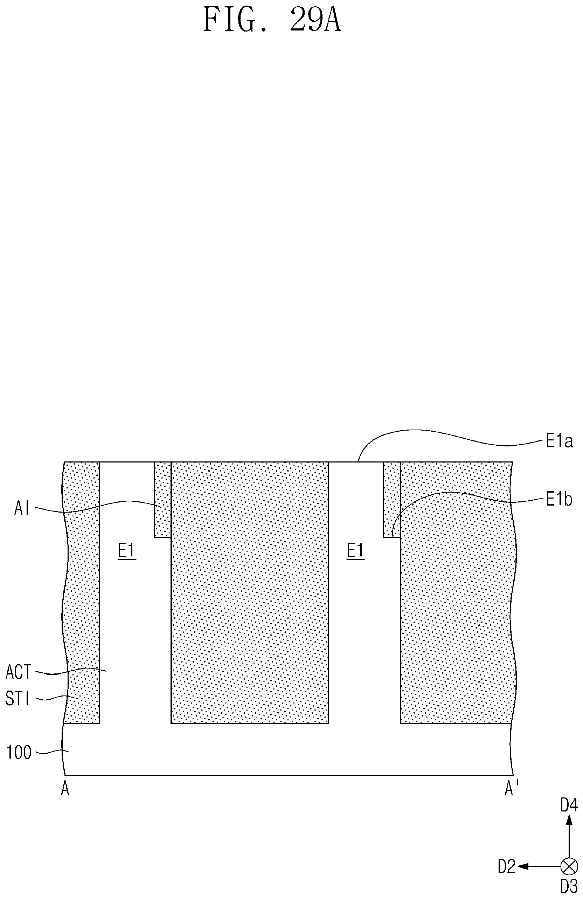

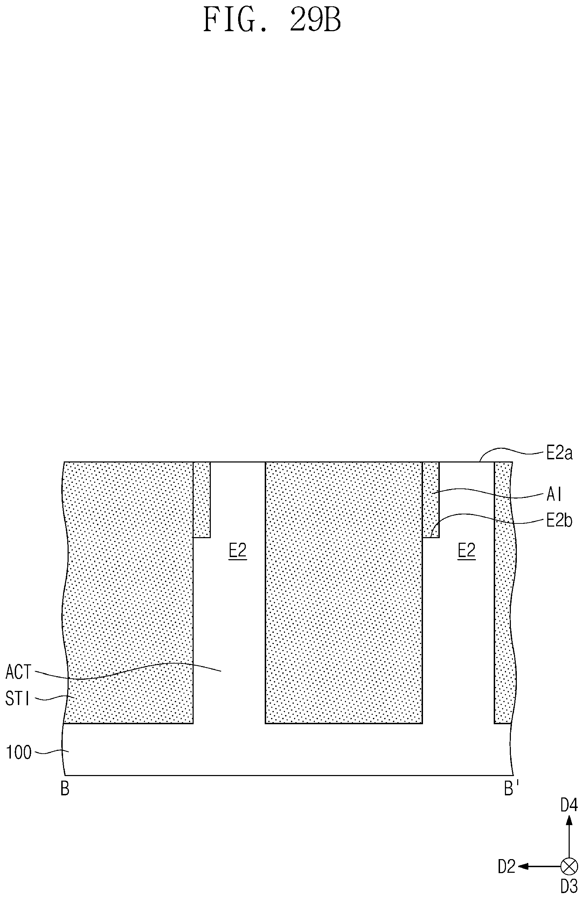

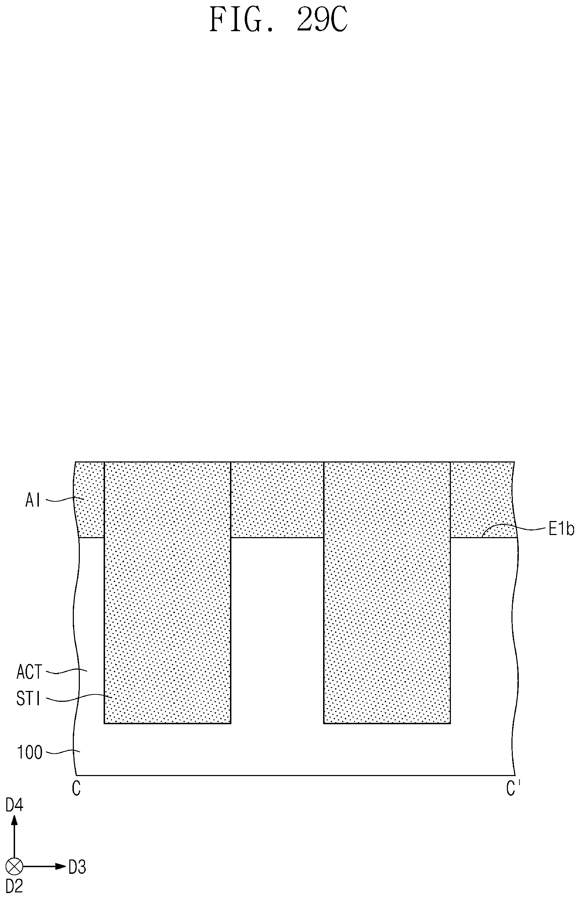

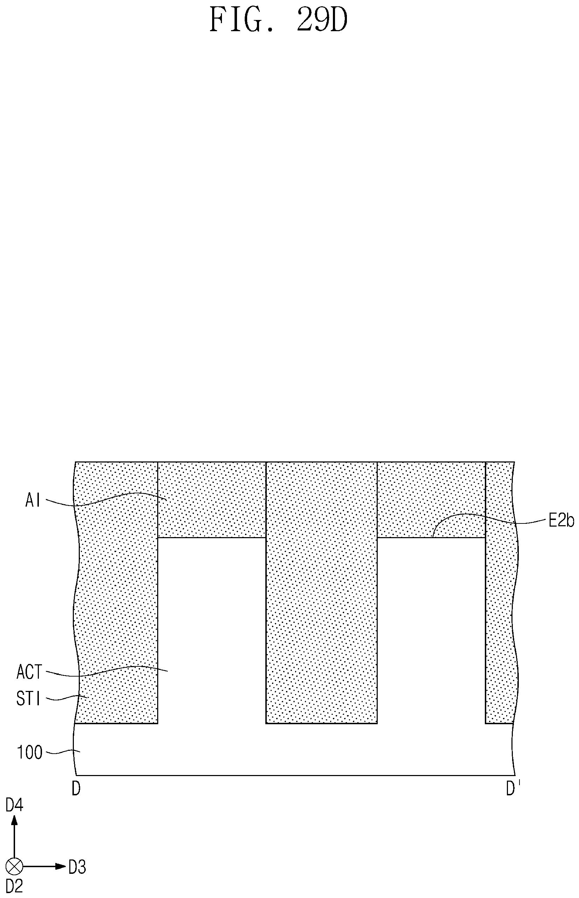

Referring to FIG. 28 to 29E, a removal process may be performed on the active mold patterns AMLP, the active insulating lines AIL, and the substrate 100, and as a result, the active patterns ACT and active insulating patterns AI may be formed. In an embodiment, the removal process may include an etching process using the active mold patterns AMLP and the upper active insulating lines AILy as an etch mask. As a result of the removal process, the lower active insulating line AILx may be divided into the active insulating patterns AI, which are spaced apart from each other in the third direction D3. An upper portion of the center portion CA of the active pattern ACT may be recessed by the active insulating pattern AI.

A first line trench region LTR1 and a second line trench region LTR2 may be formed between the active patterns ACT by the removal process. The first line trench region LTR1 may extend in the first direction D1, between the active patterns ACT. The second line trench region LTR2 may extend in the third direction D3, between the active patterns ACT. The device isolation pattern STI may be formed to fill the first and second line trench regions LTR1 and LTR2.

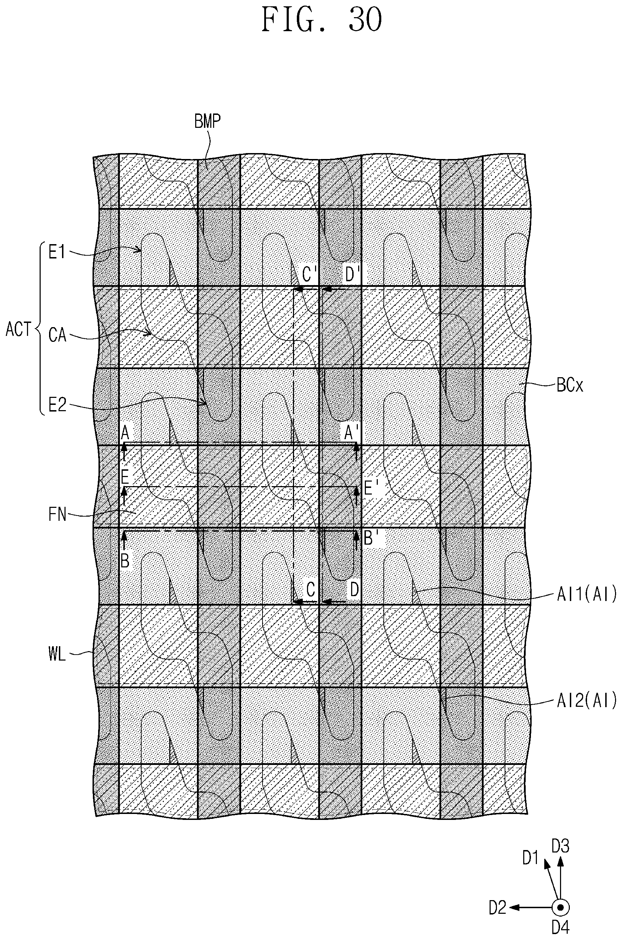

Referring to FIGS. 30 to 31E, the word line WL may be formed to cross the active pattern ACT and the device isolation pattern STI. The word line WL may be formed to penetrate the active insulating pattern AI. Thus, each of the active insulating patterns AI may be divided into the first active insulating pattern AI1 and the second active insulating pattern AI2, which are spaced apart from each other in the first direction D1.

The formation of the word line WL may include forming a mask pattern on the active pattern ACT and the device isolation pattern STI, performing an anisotropic etching process using the mask pattern to form a trench region crossing the active pattern ACT and the device isolation pattern STI, and filling the trench region with the word line WL. The word line WL may be formed on the center portion CA of the active pattern ACT and between the first and second edge portions E1 and E2.

In an embodiment, the filling of the trench region with the word line WL may include conformally depositing the gate dielectric pattern GI on an inner surface of the trench region, filling the trench region with a conductive layer, performing an etch-back and/or polishing process on the conductive layer to form the gate electrode GE, and forming the gate capping pattern GC on the gate electrode GE to fill a remaining portion of the trench region.

The lower storage node contacts BCx and the fence patterns FN may be formed on the substrate 100 to be alternately disposed in the third direction D3. The lower storage node contacts BCx may be formed to extend in the second direction D2, on the second edge portions E2 of the active patterns ACT. The fence patterns FN may be formed to extend in the second direction D2, on the center portion CA of the active patterns ACT. In an embodiment, the formation of the lower storage node contacts BCx and the fence patterns FN may include forming a lower storage node contact layer to cover or at least partially cover the substrate 100 and forming the fence pattern FN to divide the lower storage node contact layer into the lower storage node contacts BCx, which are spaced apart from each other in the third direction D3. Next, the buffer pattern BP may be formed to cover or at least partially cover the substrate 100.

A bit line mask pattern BMP may be formed on the buffer pattern BP. The bit line mask pattern BMP may include a plurality of mask patterns, which are spaced apart from each other in the second direction D2 and extend in the third direction D3. The bit line mask pattern BMP may be formed on the second edge portion E2 of the active pattern ACT.

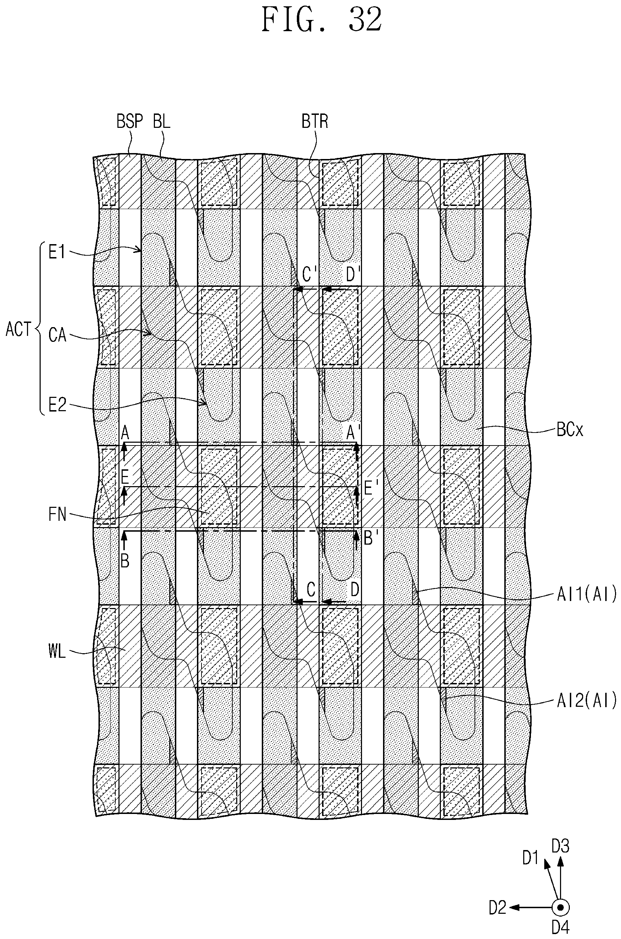

Referring to FIGS. 32 to 33E, the bit line trench regions BTR may be formed by an etching process using the bit line mask pattern BMP as an etch mask. The buffer pattern BP, the lower storage node contact BCx, the fence pattern FN, an upper portion of the word line WL, an upper portion of the first active insulating pattern AI1, and an upper portion of the first edge portion E1 of the active pattern ACT may be removed through the etching process, and the bit line trench regions BTR may be defined in a region that is removed by the etching process. The bit line trench regions BTR may be formed on the first edge portions E1 of the active patterns ACT. The first top surface E1a of the first edge portion E1 of the active pattern ACT may be exposed to the outside through the bottom surface of the bit line trench region BTR.

Each of the lower storage node contacts BCx may be divided into the lower storage node contacts BCx, which are spaced apart from each other in the second direction D2, by the bit line trench regions BTR. Each of the fence patterns FN may be divided into the fence patterns FN, which are spaced apart from each other in the second direction D2, by the bit line trench regions BTR. A portion of the top surface of the word line WL may also be recessed during the process of forming the bit line trench region BTR. Thus, the top surface of the word line WL may be classified into the first and second top surfaces W1a and W2a.

The bit line spacer BSP may be formed in the bit line trench region BTR. The bit line spacer BSP may be formed to cover or at least partially cover an inner side surface of the bit line trench region BTR. In an embodiment, a pair of the bit line spacers BSP may be formed to cover or at least partially cover opposite inner side surfaces of the bit line trench region BTR, respectively. The bit line spacer BSP may not cover at least a portion of the first edge portion E1 of the active pattern ACT. Between the pair of the bit line spacers BSP, the first top surface E1a of the first edge portion E1 of the active pattern ACT may be exposed to the outside.

The lower bit line BLx may be formed on the exposed first top surface E1a of the first edge portion E1 of the active pattern ACT. The upper bit line BLy may be formed on the lower bit line BLx. The lower bit line BLx, along with the upper bit line BLy, may form the bit line BL. As an example, the lower bit line BLx may be formed through a selective epitaxial growth (SEG) process, in which the first top surface E1a of the first edge portion E1 of the active pattern ACT is used as a seed layer. As a result of the SEG process, the lower bit line BLx may be selectively grown on the first top surface E1a of the first edge portion E1 of the active pattern ACT. The lower bit line BLx and the upper bit line BLy may be sequentially formed. In an embodiment, an additional process for the distinction between the lower bit line BLx and the upper bit line BLy may be performed, after the formation of the bit line BL. Thereafter, the bit line capping patterns BCP may be formed to fill a remaining portion of each of the bit line trench regions BTR, on the bit lines BL. The mold pattern MP may be formed to cover the entire top surface of the substrate 100.

Referring back to FIGS. 1A and 2A to 2E, the contact holes CH may be formed to penetrate the mold pattern MP. In an embodiment, the formation of the contact holes CH may include forming a mask pattern including holes to cover or at least partially cover the top surface of the mold pattern MP and performing a removal process, in which the mask pattern is used as an etch mask, on the mold pattern MP. The holes may be linearly arranged in the second direction D2 and may be arranged in a zigzag shape in the third direction D3. As another example, referring to FIGS. 20 and 21, the holes in a row may be formed to be arranged side by side in the second direction D2, and the holes in a column may be formed to be arranged side by side in the third direction D3.

The upper storage node contacts BCy may be formed in the contact holes CH, respectively. The second silicide pattern SC may be formed on the upper storage node contact BCy, in the contact hole CH. In an embodiment, a second barrier pattern may be formed together with the second silicide pattern SC. Thereafter, the landing pads LP may be formed to fill a remaining portion of each of the contact holes CH. The landing pad LP may have a top surface that is located at substantially the same level as the top surface of the mold pattern MP and is coplanar with the top surface of the mold pattern MP. Next, the data storage patterns DSP may be formed on the landing pads LP, respectively.

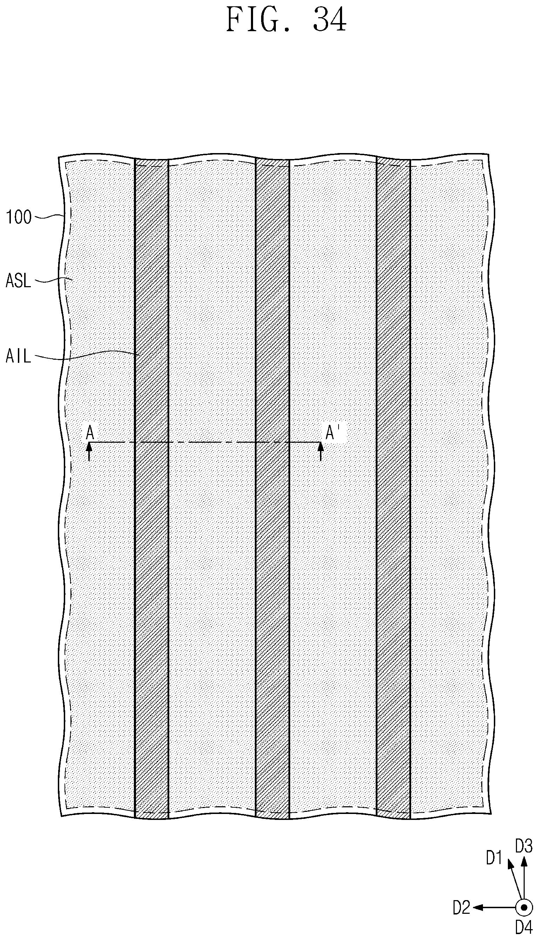

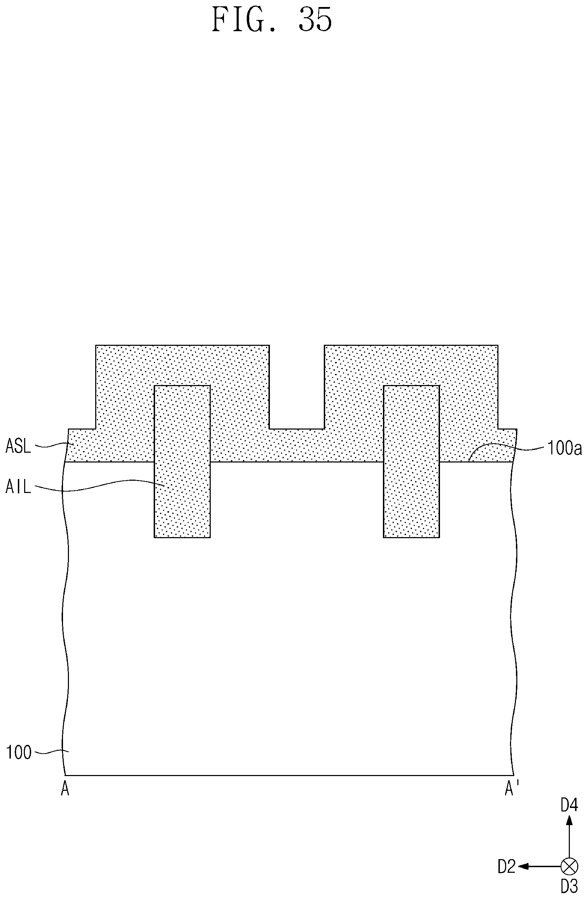

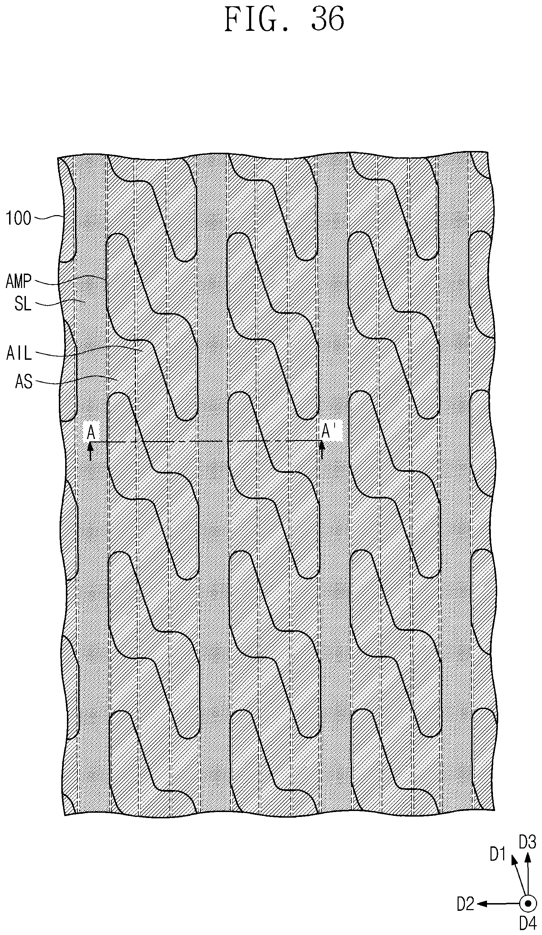

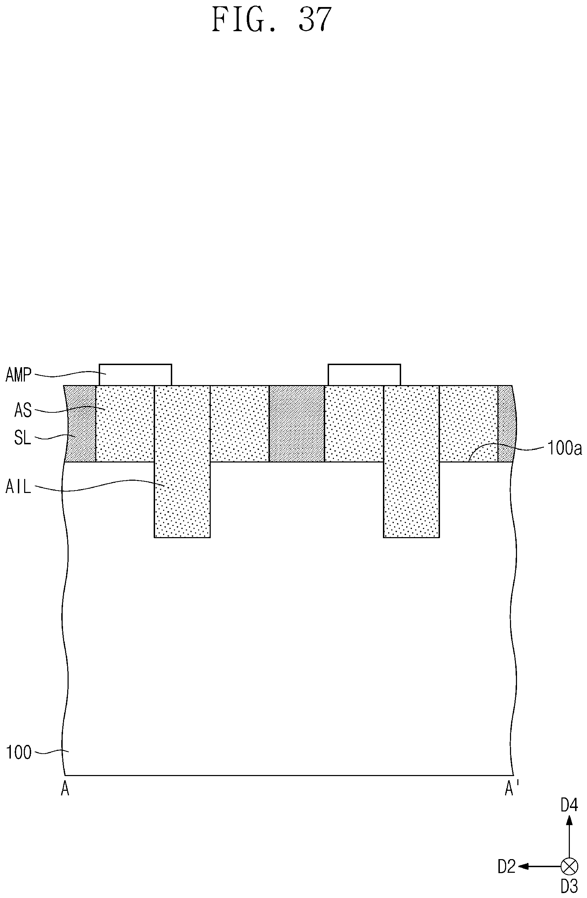

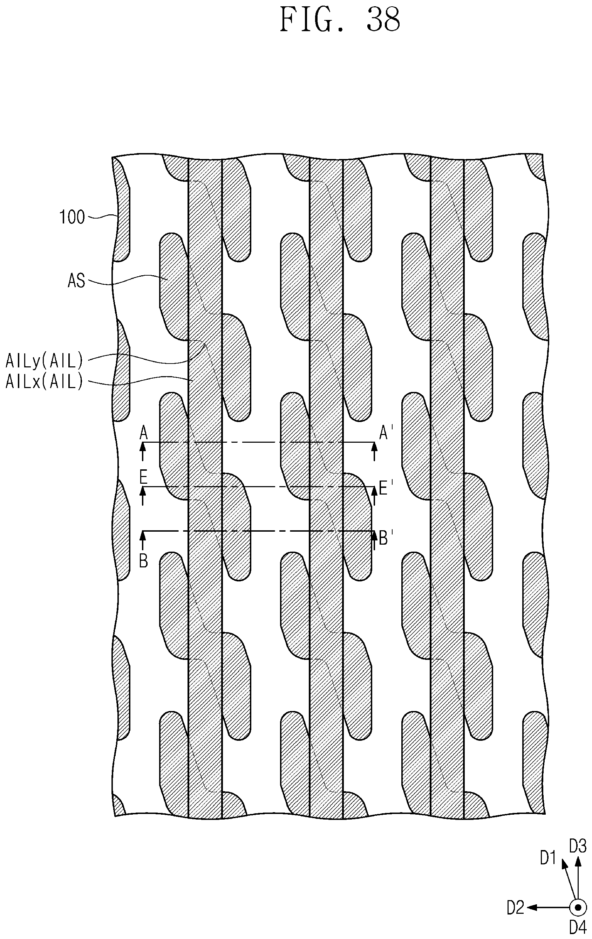

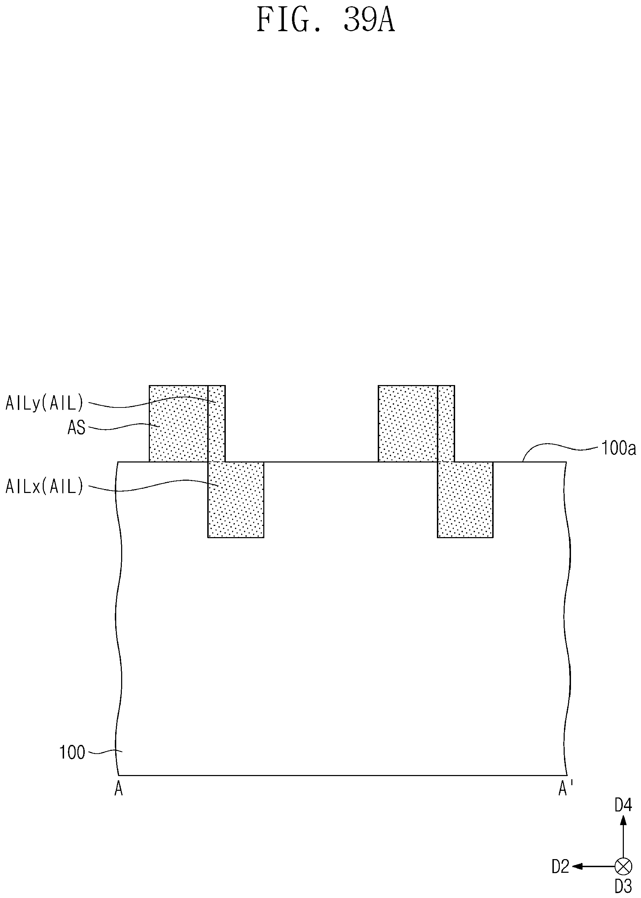

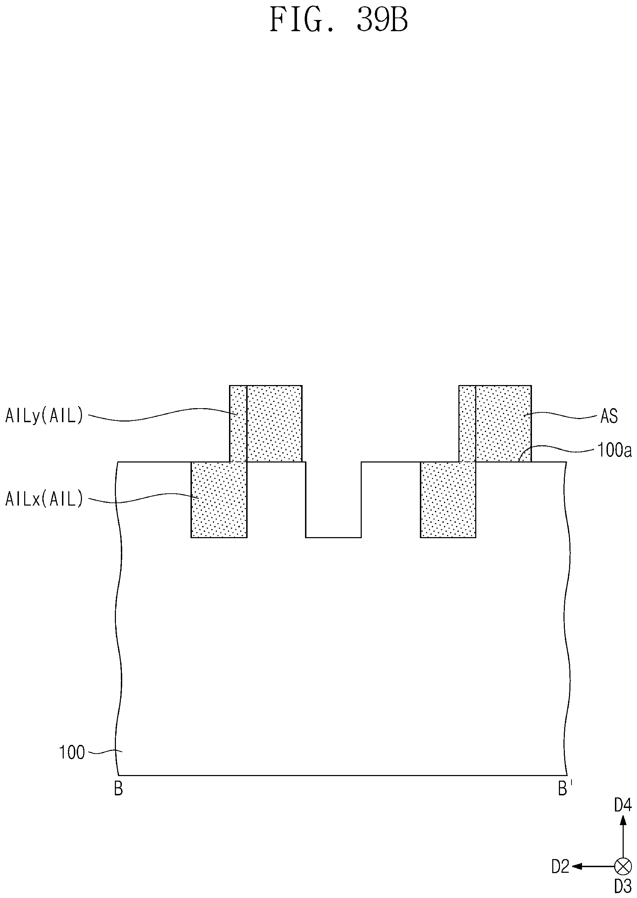

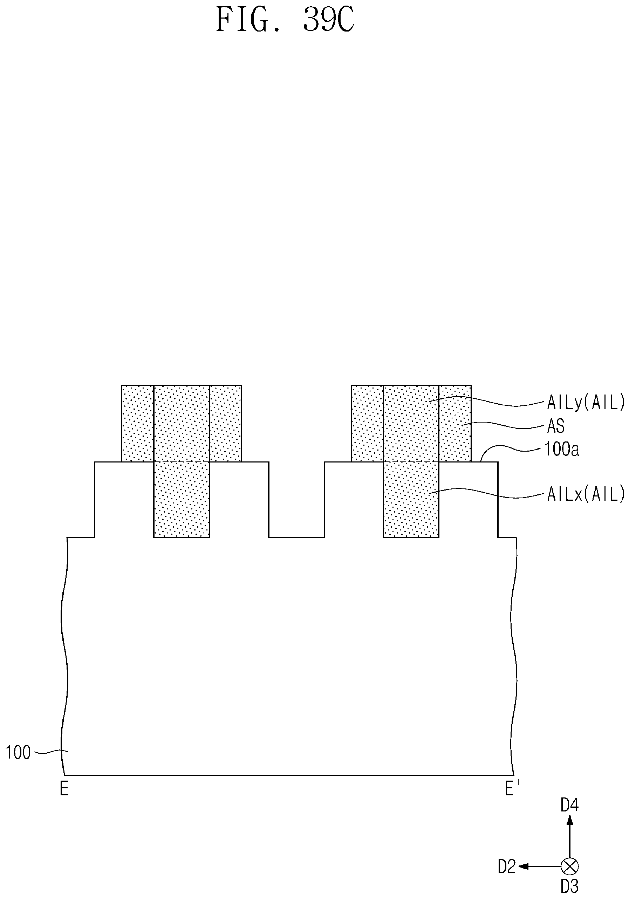

FIGS. 34 to 39C are diagrams illustrating a method of fabricating a semiconductor device, according to one or more embodiments of the disclosure. FIG. 35 is a cross-sectional view of line A-A' of FIG. 34. FIG. 37 is a cross-sectional view of line A-A' of FIG. 36. FIGS. 39A-39C are cross-sectional views of lines A-A', B-B' and E-E' of FIG. 38, respectively.

Referring to FIGS. 34 and 35, the substrate 100 may be provided, and the active insulating lines AIL may be formed on the substrate 100. In an embodiment, the formation of the active insulating lines AIL may include forming an active mold layer on the substrate 100, partially removing the active mold layer, and forming the active insulating lines AIL to fill empty regions that are formed by the partial removing of the active mold layer. An upper portion of the substrate 100 may be recessed to a specific depth during the removal process of the active mold layer. Bottom surfaces of the active insulating lines AIL may be located at a level lower than the uppermost surface 100a of the substrate 100.

Thereafter, a remaining portion of the active mold layer may be removed from the substrate 100. Thus, the uppermost surface 100a of the substrate 100 may be exposed to the outside. An active spacer layer ASL may be formed to cover or at least partially cover the exposed uppermost surface 100a of the substrate 100 and top and side surfaces of the active insulating lines AIL. The active spacer layer ASL may include an insulating material.

Referring to FIGS. 36 and 37, a removal process may be performed on the active spacer layer ASL. Here, a portion of the active spacer layer ASL may be left on a side surface of the active insulating line AIL to form active spacers AS. The active spacers AS may extend in the third direction D3. The active spacers AS, which are adjacent to each other in the second direction D2, may be formed at both sides of the active insulating line AIL. During the removal process, a portion of the uppermost surface 100a of the substrate 100 may be re-opened.

Next, the sacrificial lines SL may be formed to cover or at least partially cover the exposed uppermost surface 100a of the substrate 100. The sacrificial line SL may be formed to be interposed between the active spacers AS, which are adjacent to each other in the second direction D2.

The active mask patterns AMP may be formed on the substrate 100. The technical features of the active mask patterns AMP and the method forming the same may be similar to those in the embodiment described with reference to FIGS. 24 to 25E.

The sacrificial lines SL may be removed from the top surface of the substrate 100. In an embodiment, the sacrificial lines SL may also be removed, during the process of forming the active mask patterns AMP. In another embodiment, the removal process on the sacrificial lines SL may be separately performed, after the formation of the active mask patterns AMP.

Referring to FIGS. 38 to 39C, a removal process using the active mask patterns AMP as an etch mask may be performed on a portion of the active insulating lines AIL and a portion of the active spacers AS. As a result, each active spacer AS may be divided into the active spacers AS, which are spaced apart from each other in the third direction D3. The active spacers AS may be spaced apart from each other in the first direction D1.

The active insulating line AII, may include the upper active insulating line AILy and the lower active insulating line AILx. The upper active insulating line AILy and the lower active insulating line AILx may be provided to have substantially the same or similar features as those in the embodiment of FIGS. 26 to 27E. The upper active insulating line AlLy may be interposed between the active spacers AS, which are adjacent to each other in the first direction D1. In an embodiment, in a plan view, the active spacers AS, which are adjacent to each other in the first direction D1, and the upper active insulating line AILy, which are placed between the active spacers AS, may have the same or similar profile as the profile of the active pattern ACT described with reference to FIGS. 3A to 3F.

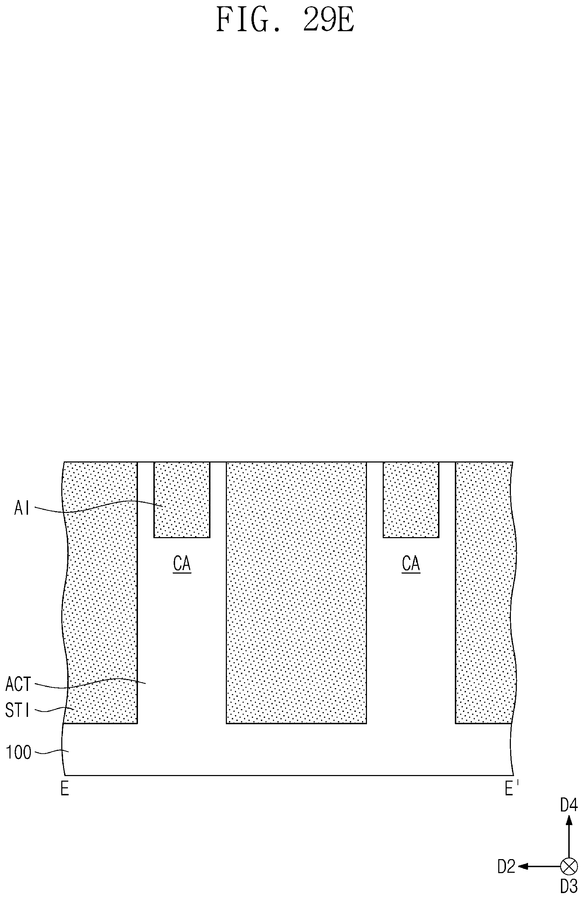

A removal process may be performed on the active spacers AS, the active insulating lines AIL, and the substrate 100, and as a result, the active patterns ACT and the active insulating patterns AI may be formed. In an embodiment, the removal process may include an etching process using the active spacers AS and the upper active insulating lines AILy as an etch mask. The active pattern ACT and the active insulating pattern AI may be provided to have substantially the same or similar features as those in the embodiment of FIGS. 28 and 29E.

Thereafter, the semiconductor device described with reference to FIGS. 1A and 2A to 2E may be formed using the fabricated method described above.

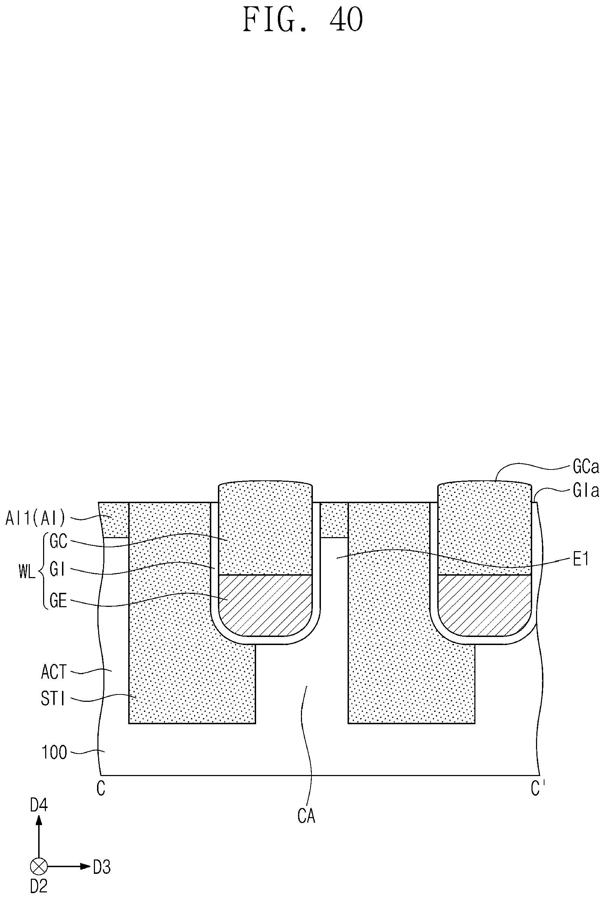

FIG. 40 is a cross-sectional view illustrating a method of fabricating a semiconductor device, according to one or more embodiments of the disclosure. FIGS. 40 is cross-sectional views corresponding to lines C-C' of FIG. 32.

Referring to FIGS. 32 and 40, the gate capping pattern GC may be formed to protrude above the first active insulating pattern AI1 and the gate dielectric pattern GI, during the formation of the bit line trench regions BTR described with reference to FIGS. 32 to 33E. Thus, a top surface GCa of the gate capping pattern GC may be located at a level higher than a top surface of the first active insulating pattern AI1 and a top surface GIa of the gate dielectric pattern GI. This process may be controlled using the etch selectivity between the gate capping pattern GC and neighboring elements (e.g., the active pattern ACT, the first and second active insulating patterns AI1 and AI2, and the gate dielectric pattern GI, and so forth). When the bit line trench regions BTR are formed, the gate capping pattern GC may be less removed than the neighboring elements, and thus, the gate capping pattern GC may protrude above the neighboring elements. Thereafter, the semiconductor device described with reference to FIG. 4 may be formed using the fabricated method described above.

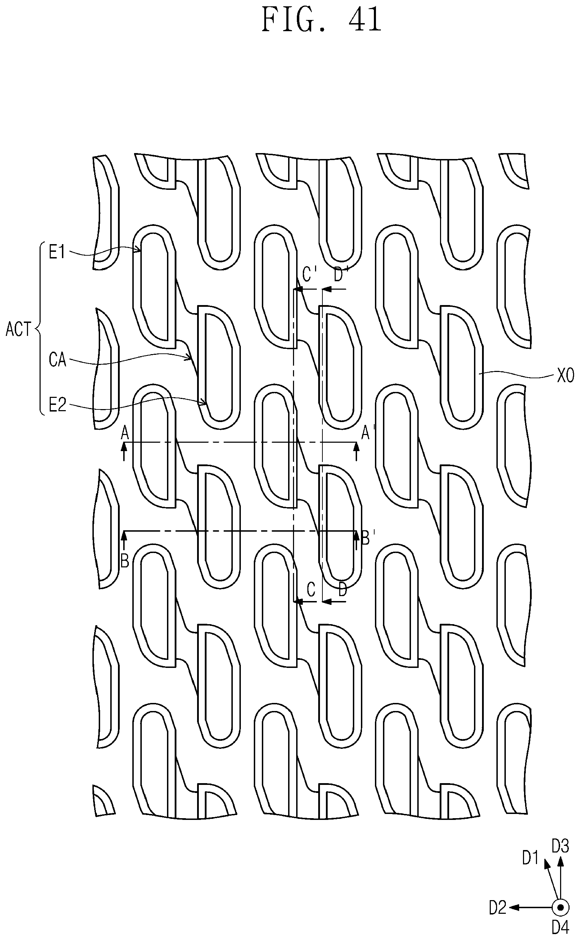

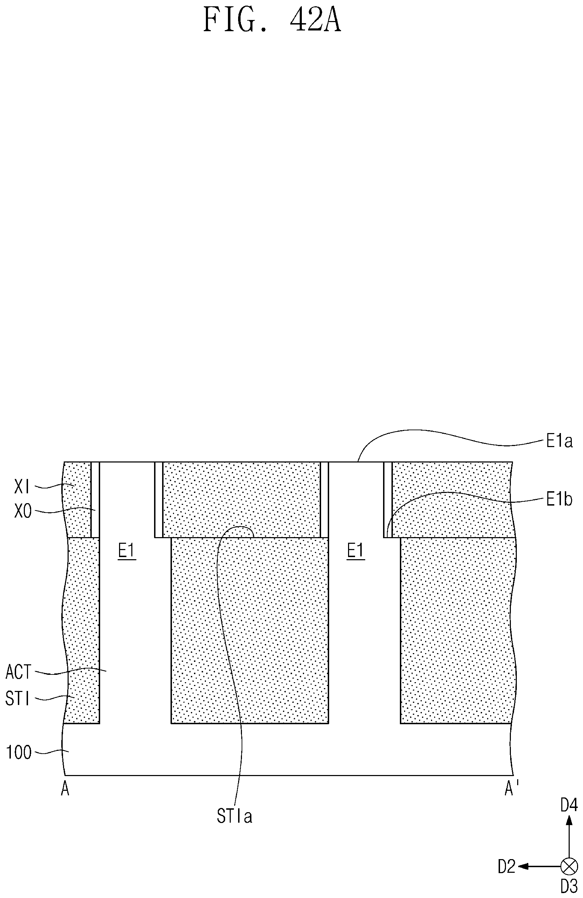

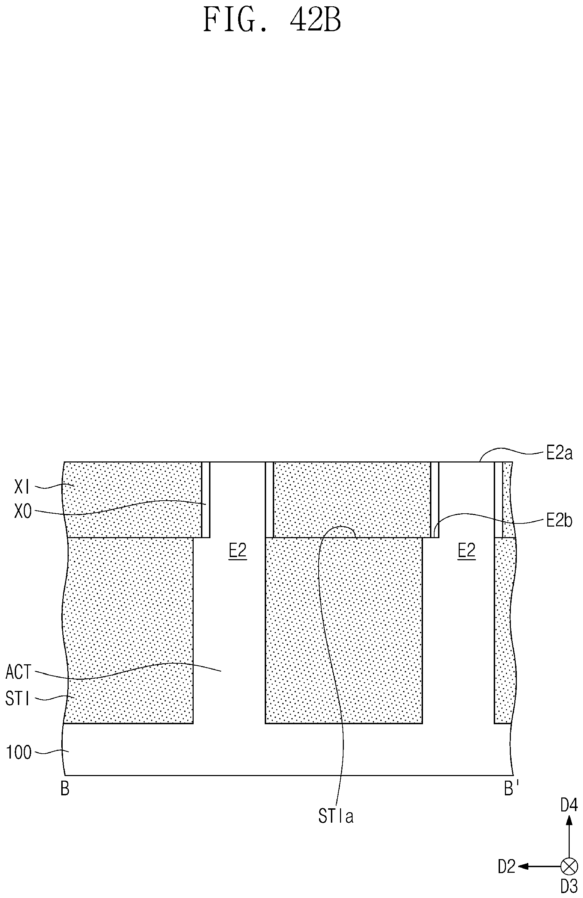

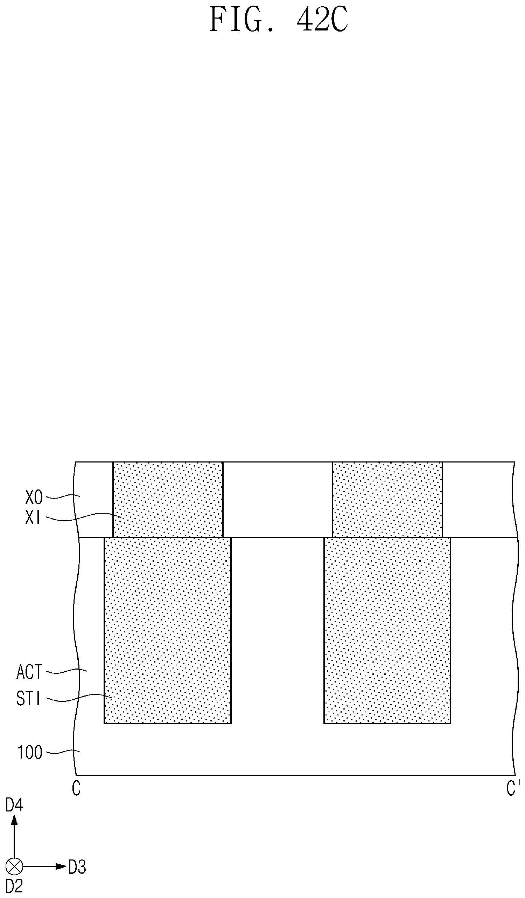

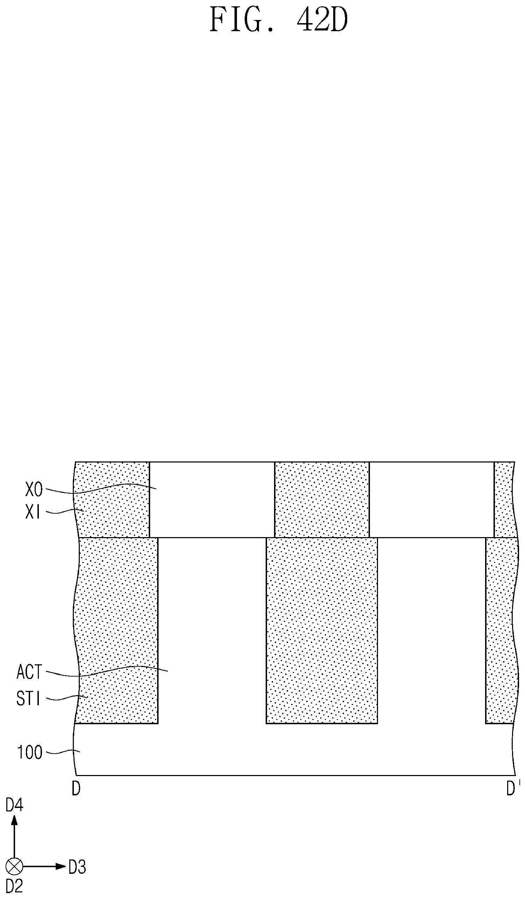

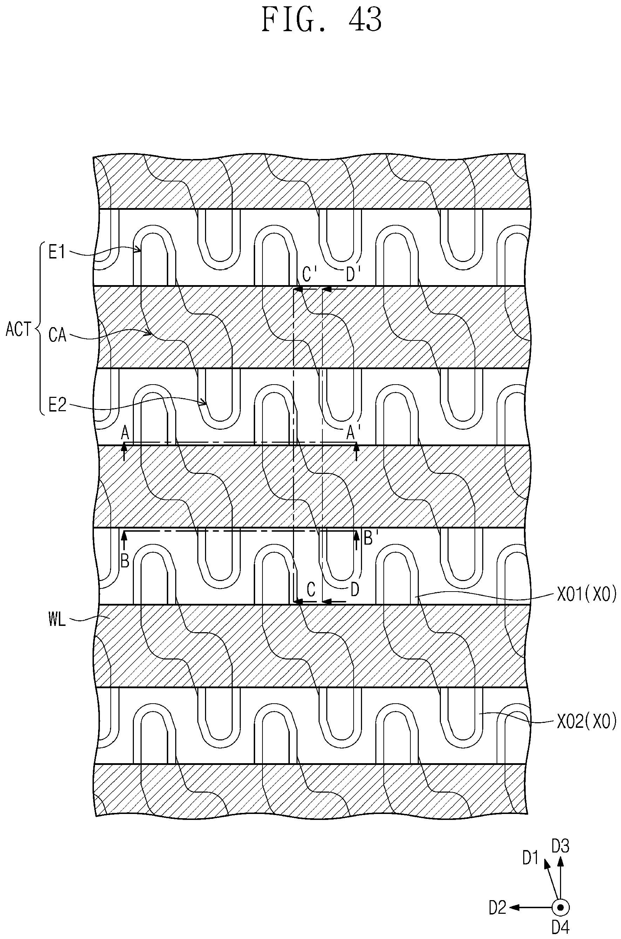

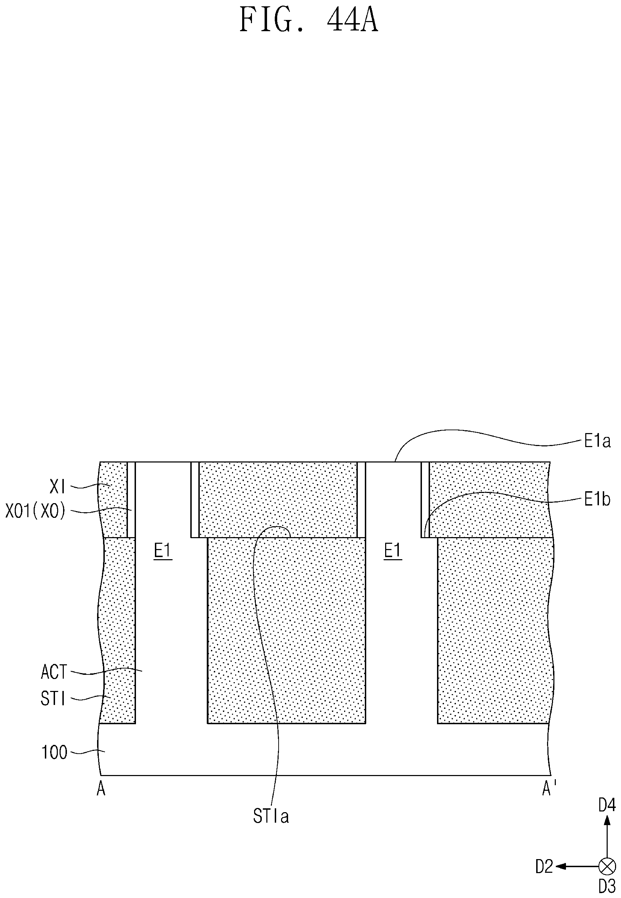

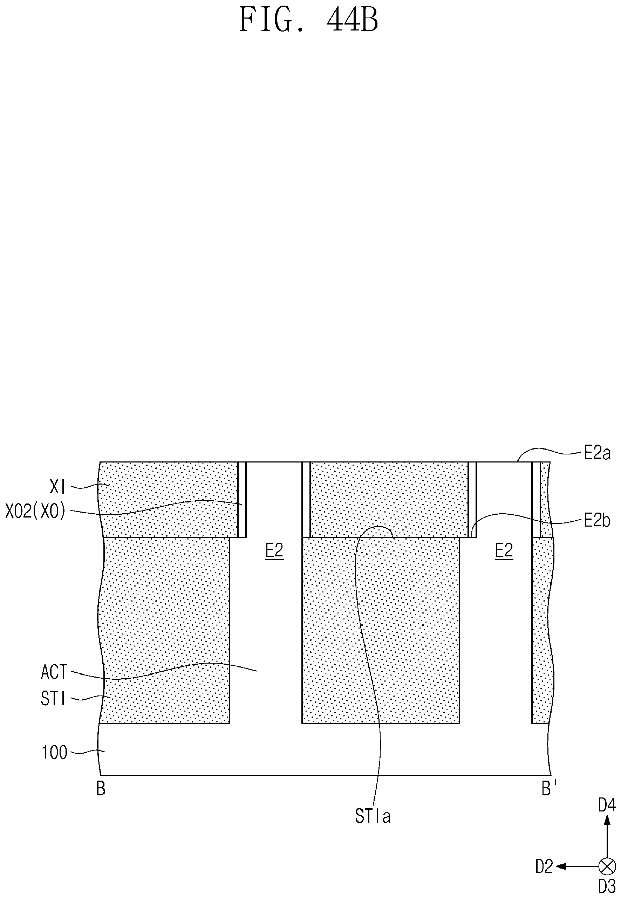

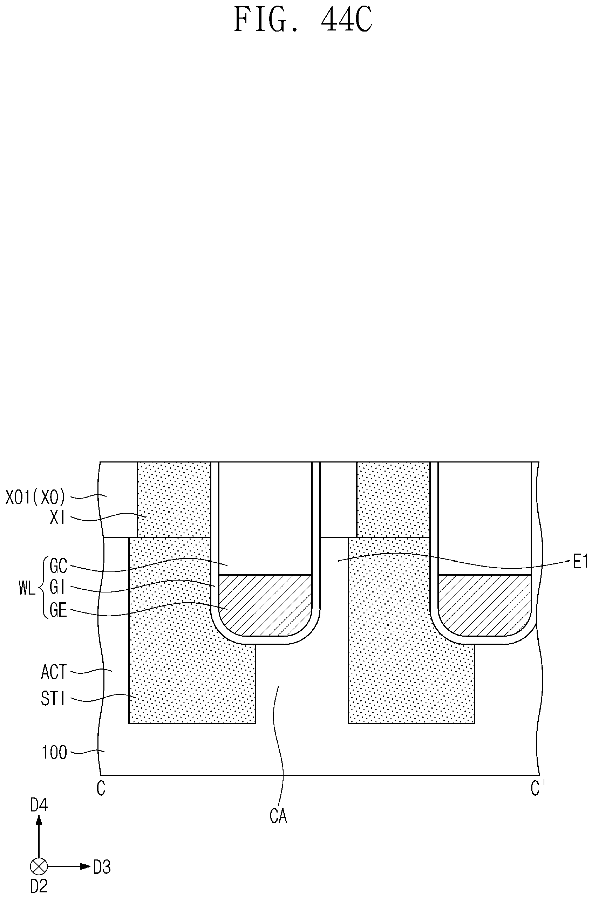

FIGS. 41 to 44D are diagrams illustrating a method of fabricating a semiconductor device, according to one or more embodiments of the disclosure. FIGS. 42A - 42D are cross-sectional views taken along lines A-A', B-B', C-C' and D-D' of FIG. 41, respectively. FIGS. 44A - 44D are cross-sectional views taken along lines A-A', B-B', C-C' and D-D' of FIG. 43, respectively
Referring to FIGS. 41 to 42D, a removal process may be performed on the device isolation pattern STI, after the formation of the active pattern ACT, the active insulating pattern AI, and the device isolation pattern STI described with reference to FIGS. 28A to 29D. As an example, the active pattern ACT may include one of the active patterns ACT of the semiconductor device described with reference to FIGS. 3A to 3F. During the removal process, the active insulating pattern AI may also be removed, and a side surface of the upper portion of each of the first and second edge portions E1 and E2 of the active pattern ACT may be exposed to the outside.

The active pad XO may be formed to enclose the exposed side surface of the upper portion of each of the first and second edge portions E1 and E2 of the active pattern ACT. Thereafter, the pad insulating pattern XI may be formed on the device isolation pattern STI and between the active patterns ACT.

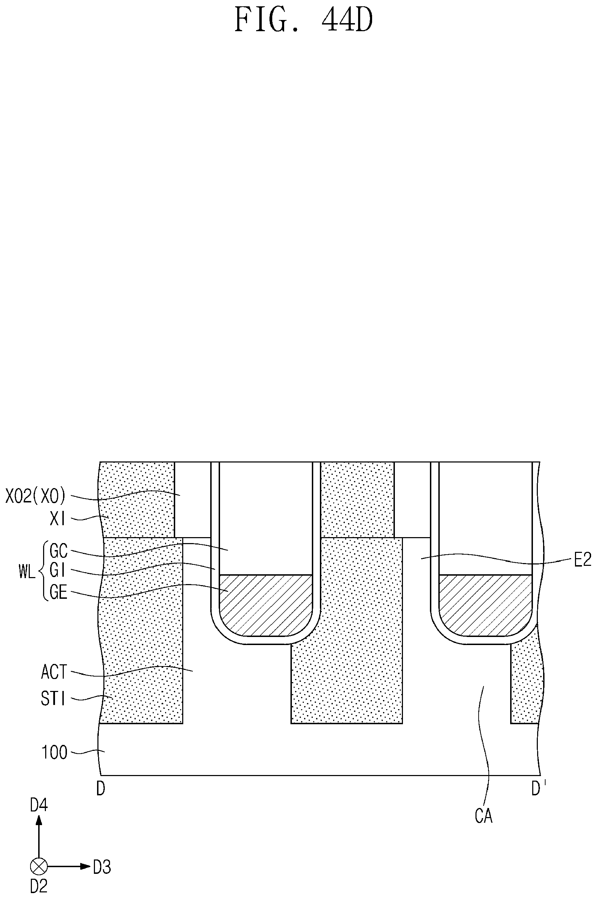

Referring to FIGS. 43 and 44D, the word line WL may be formed to cross the active pattern ACT, the device isolation pattern STI, and the active pad XO. The formation of the word line WL may be similar to that in the embodiment described with reference to FIGS. 30 to 31E. During the formation of the word line WL, the active pad XO may be divided into the first active pad XO1 and the second active pad XO2.

Thereafter, the semiconductor device described with reference to FIGS. 5 to 6D may be formed using the fabricated method described above.

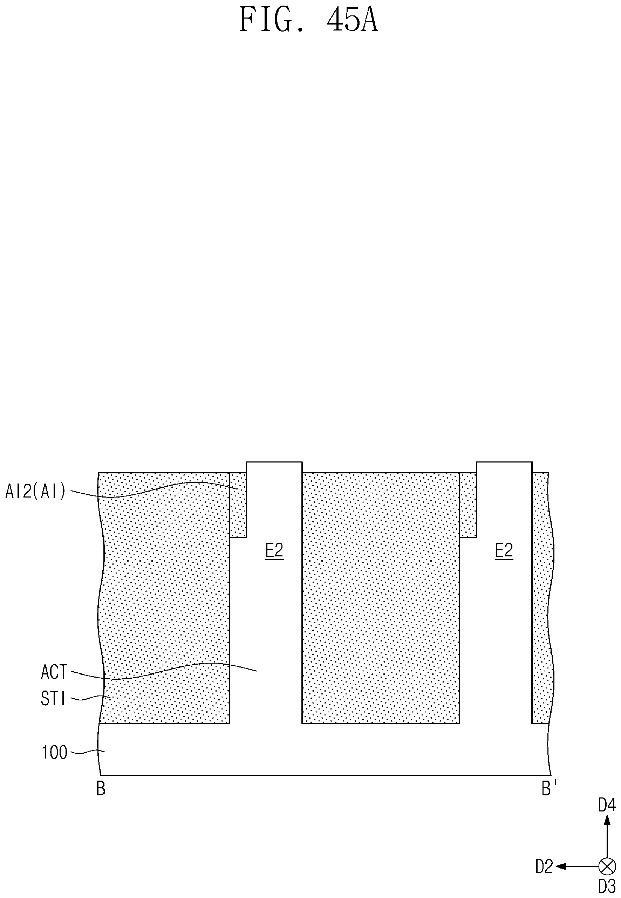

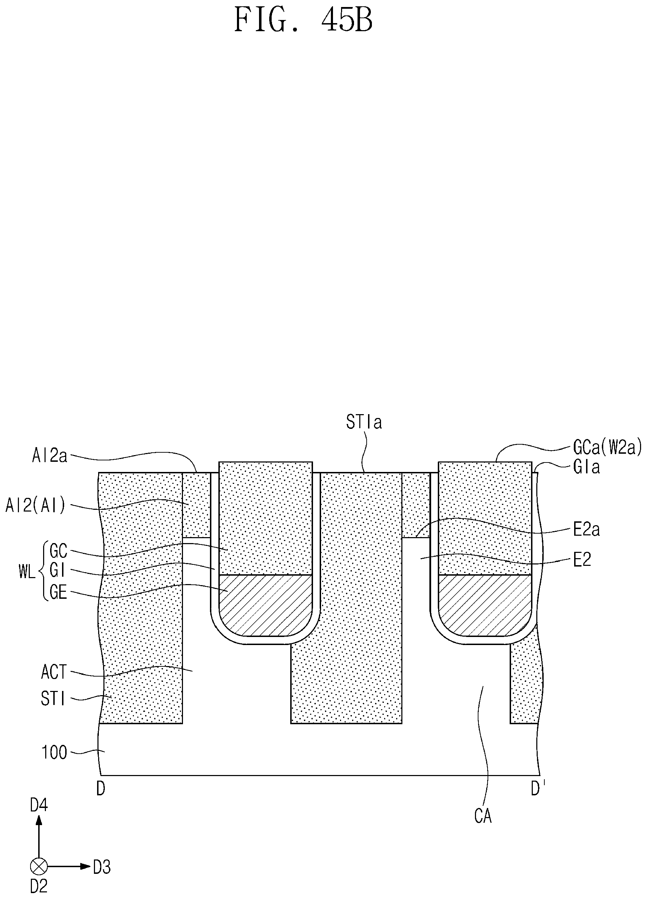

FIGS. 45A and 45B are diagrams illustrating a method of fabricating a semiconductor device, according to one or more embodiments of the disclosure. FIGS. 45A and 45B are cross-sectional views corresponding to lines B-B' and D-D' of FIG. 30, respectively.

Referring to FIGS. 30, 45A and 45B, a removal process may be performed on an upper portion of each of the device isolation pattern STI, the first and second active insulating patterns AI1 and AI2, and the gate dielectric pattern GI, after the formation of the word line WL described with reference to FIGS. 30 to 31E. Each of the device isolation pattern STI, the first and second active insulating patterns AI1 and AI2, and the gate dielectric pattern GI may have an etch selectivity with respect to the neighboring elements (e.g., the active pattern ACT, the gate capping pattern GC, and so forth). Thus, the neighboring elements may not be removed or may be removed less, during the removal process. Thus, the upper portion of each of the first and second edge portions E1 and E2 of the active pattern ACT may have a side surface that is exposed to the outside.

Thereafter, the semiconductor device described with reference to FIGS. 7A and 7B may be formed using the fabricated method described above.

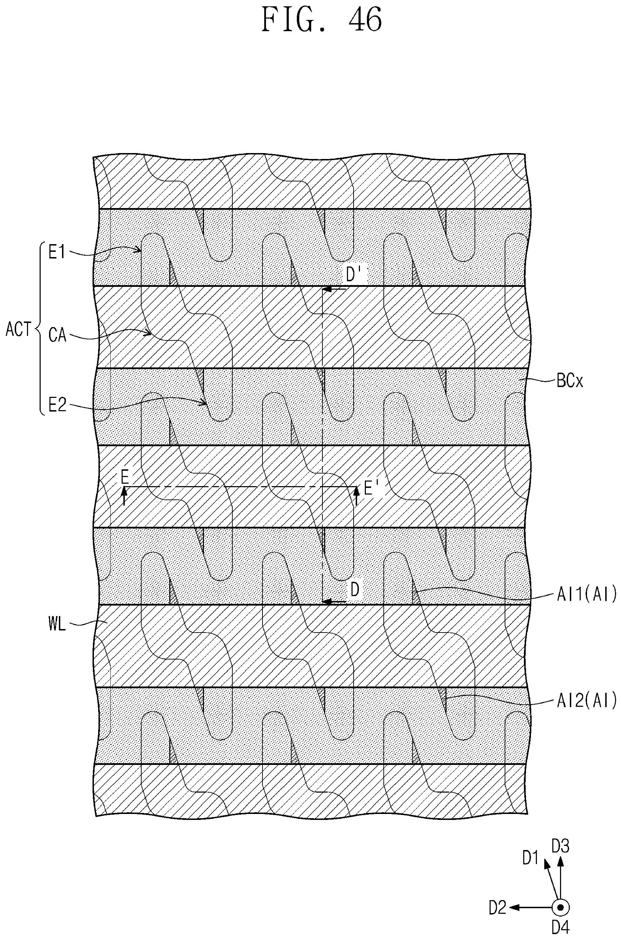

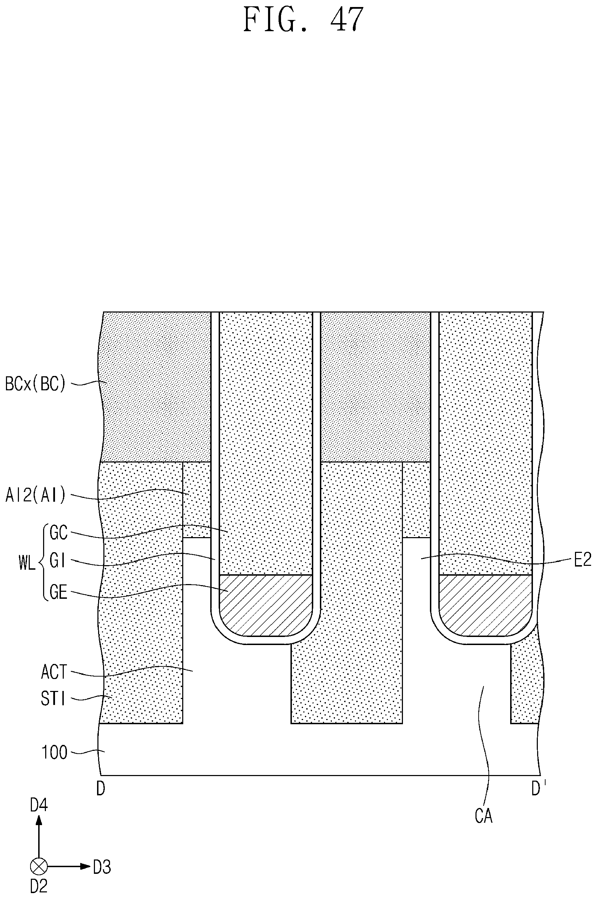

FIGS. 46 and 47 are diagrams illustrating a method of fabricating a semiconductor device, according to one or more embodiments of the disclosure. FIG. 47 is a cross-sectional view taken along line D-D' of FIG. 46.

Referring to FIGS. 46 and 47, a lower storage node contact layer may be formed on the substrate 100 after the formation of the active pattern ACT, the active insulating pattern AI, and the device isolation pattern STI described with reference to FIGS. 28 to 29E and before the formation of the word line WL.

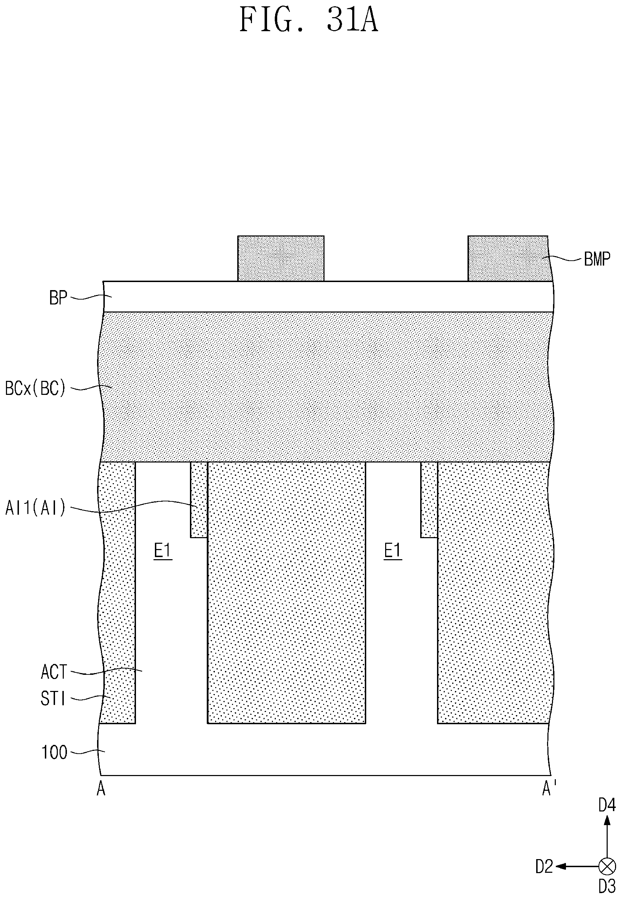

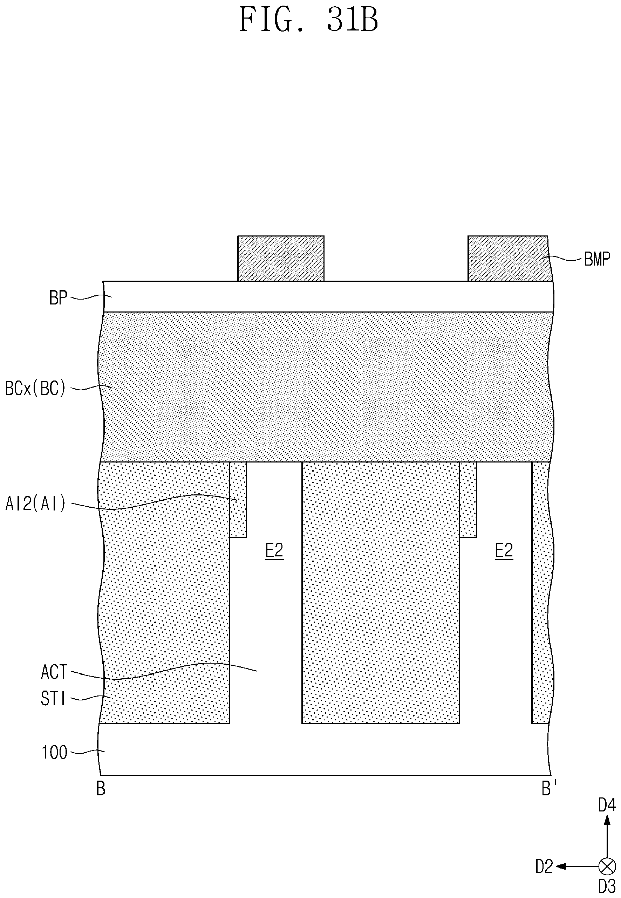

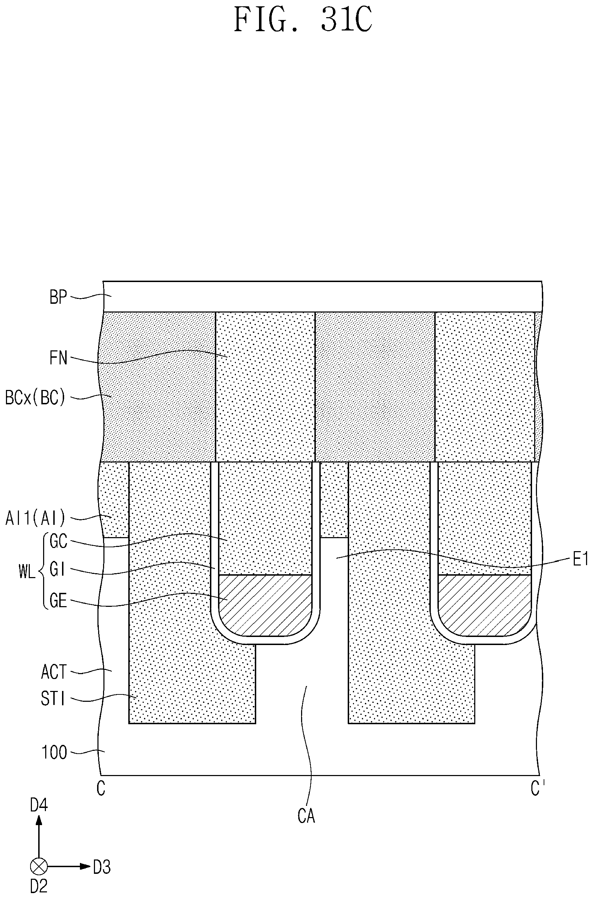

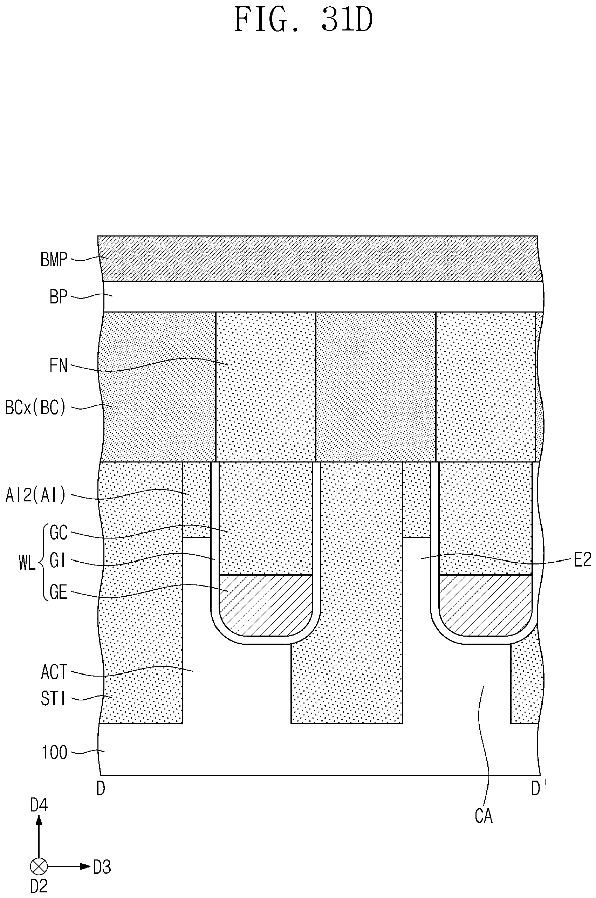

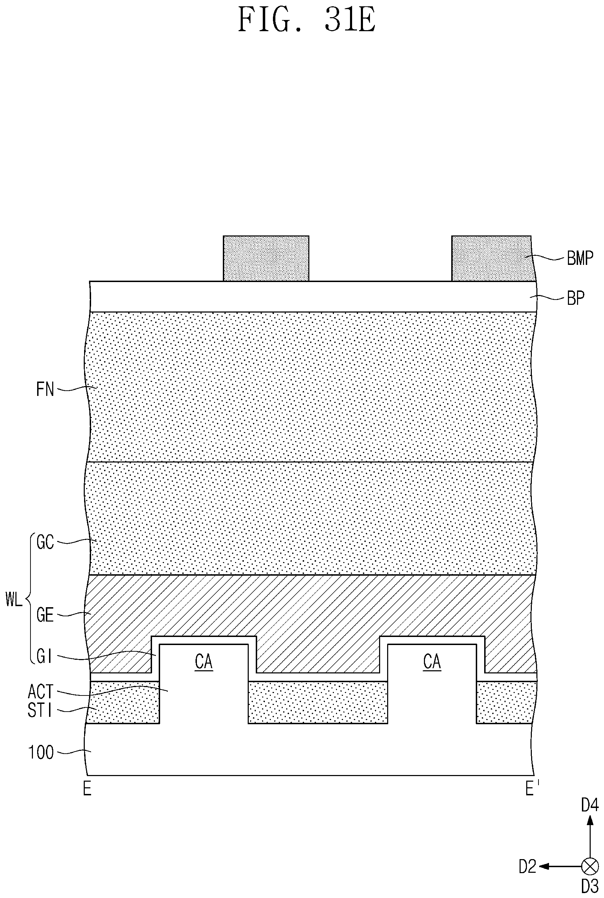

Next, the word line WL may be formed to cross the active pattern ACT, the active insulating pattern AI, and the device isolation pattern STI. The word line WL may be formed to penetrate the lower storage node contact layer. Thus, the lower storage node contacts BCx may be formed to be spaced apart from each other in the third direction D3 and extend in the second direction D2. The formation of the word line WL may be similar to that in the embodiment described with reference to FIGS. 31 to 32D.

Thereafter, the semiconductor device described with reference to FIGS. 8 to 9B may be formed using the fabricated method described above.

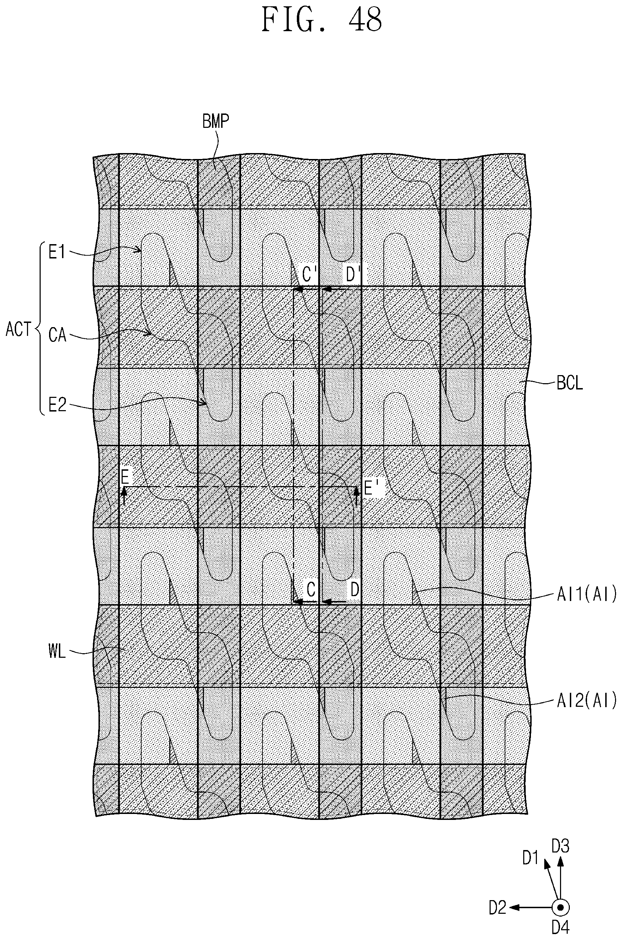

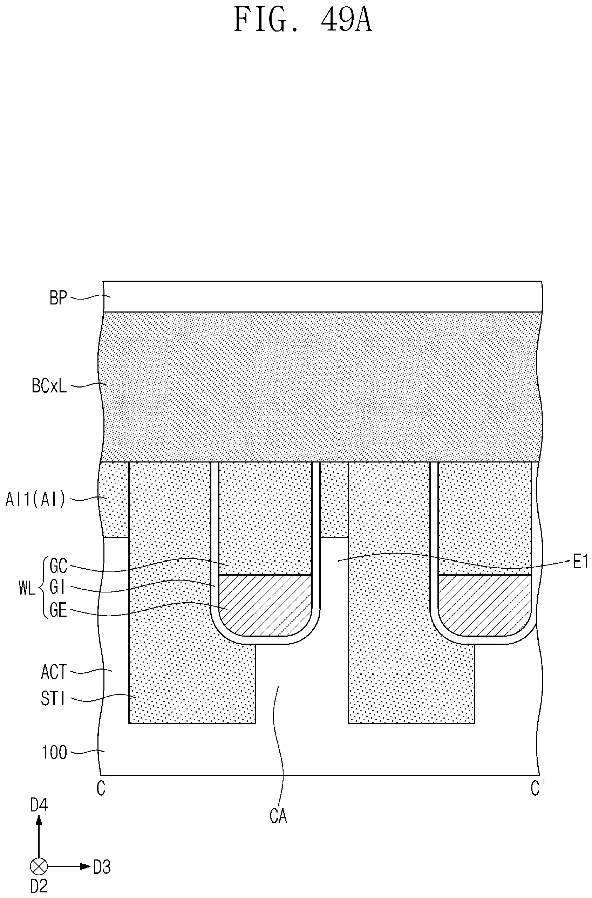

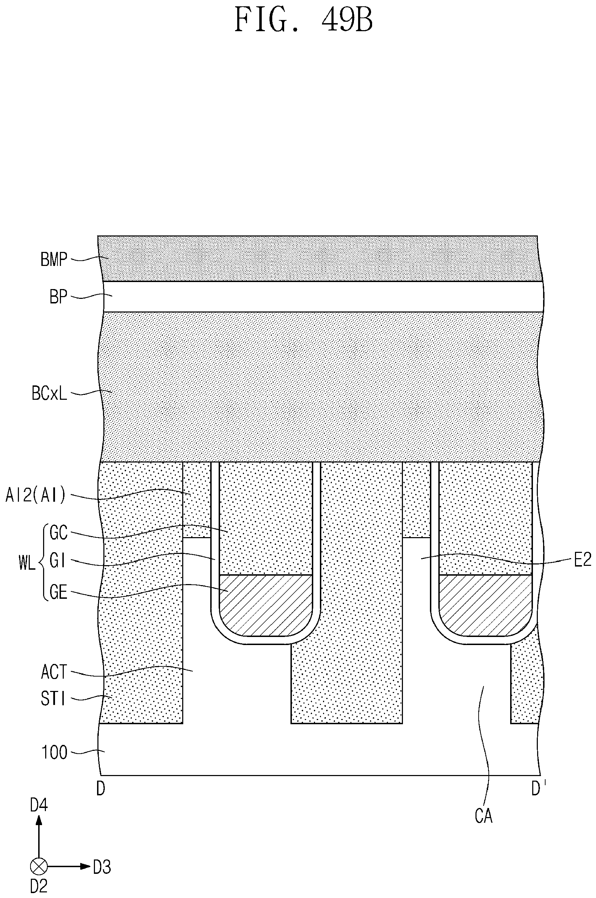

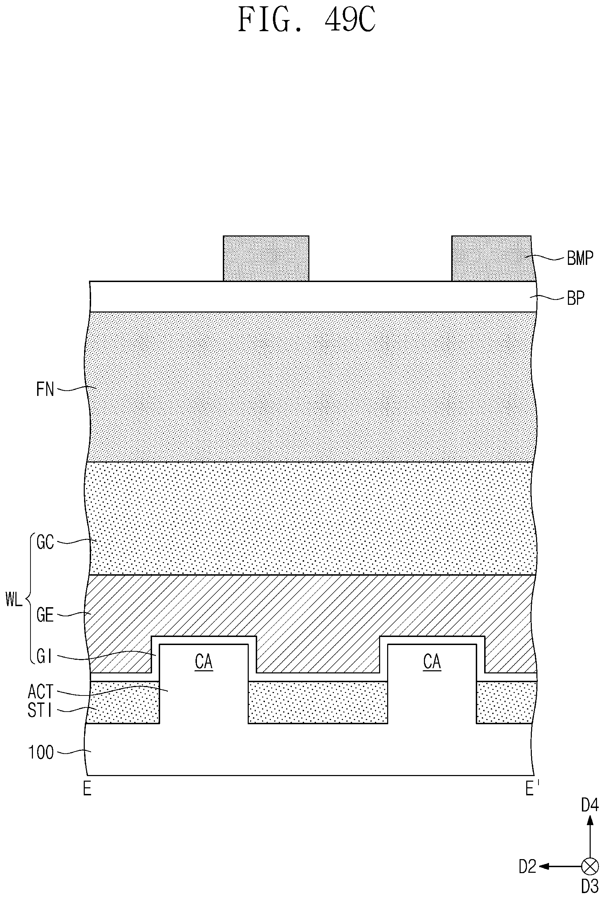

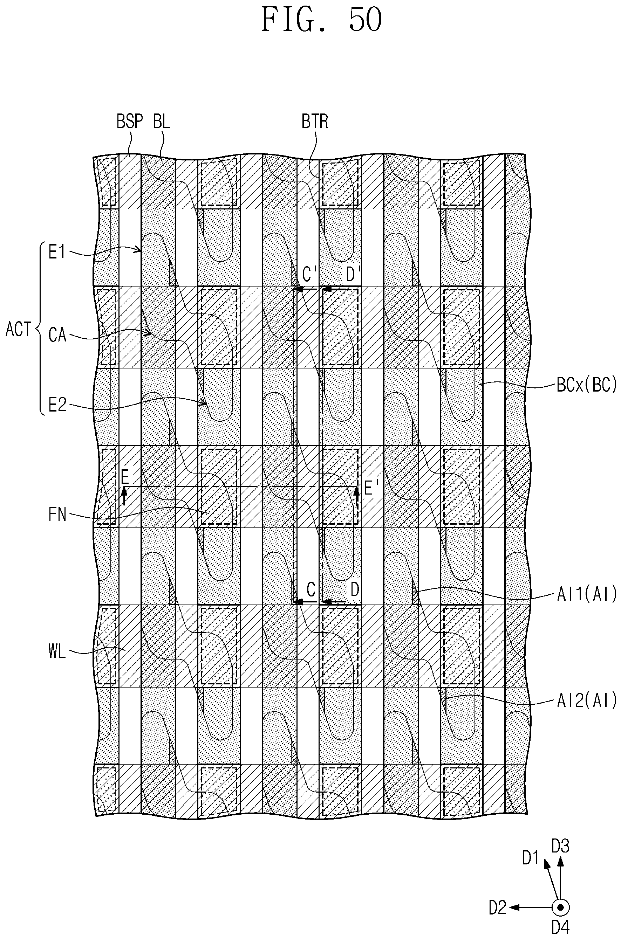

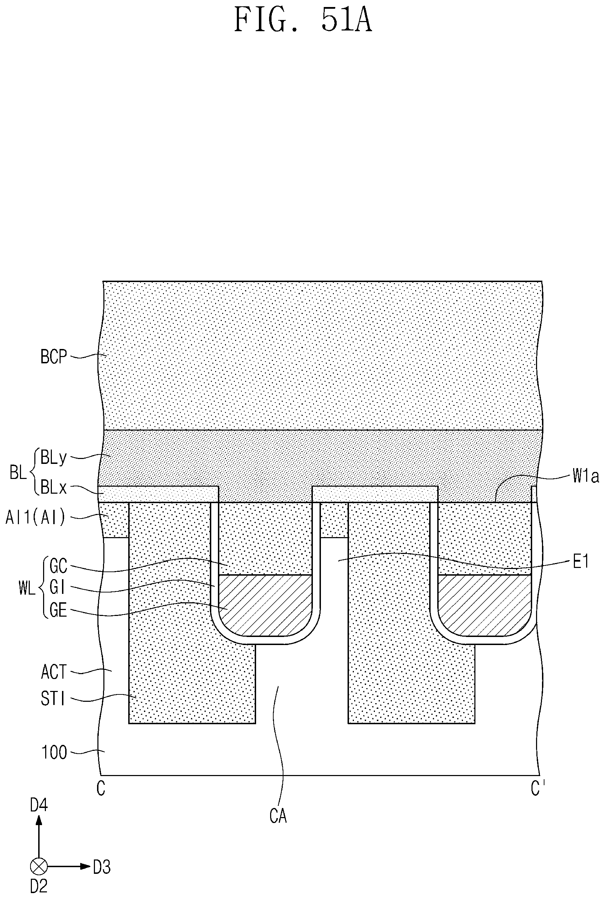

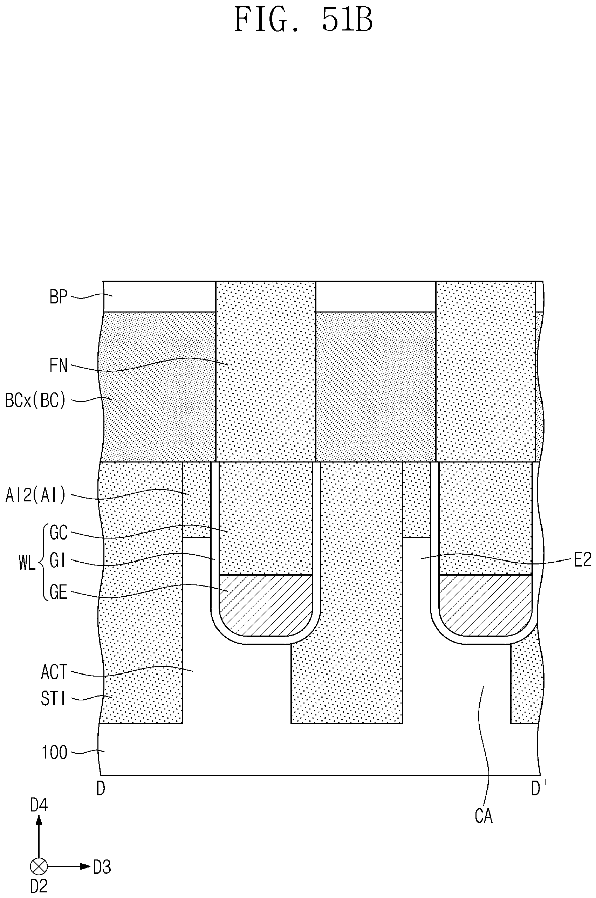

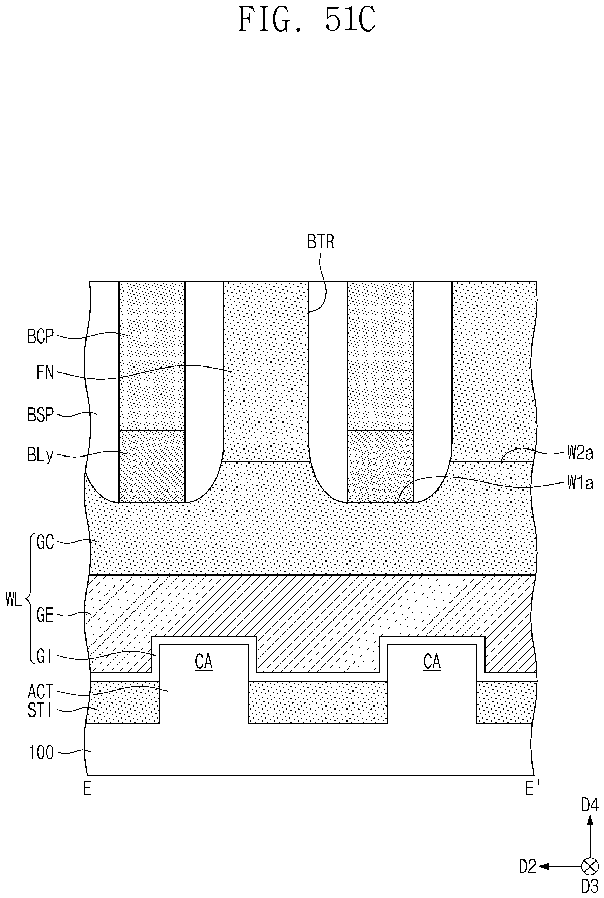

FIGS. 48 to 51C are diagrams illustrating a method of fabricating a semiconductor device, according to one or more embodiments of the disclosure. FIGS. 49A-49C are cross-sectional views taken along lines C-C', D-D', and E-E' of FIG. 48, respectively. FIGS. 51A-51C are cross-sectional views taken along lines C-C', D-D' and E-E' of FIG. 50, respectively.

Referring to FIGS. 48 to 49C, a lower storage node contact layer BCxL may be formed on the substrate 100, after the formation of the word line WL described with reference to FIGS. 30 to 31E. Next, the buffer pattern BP and bit line mask patterns BMP may be sequentially formed on the lower storage node contact layer BCxL.

Referring to FIGS. 50 to 51C, the bit line trench regions BTR may be formed on the first edge portions E1 of the active patterns ACT. The formation of the bit line trench regions BTR may be similar to that in the embodiment described with reference to FIGS. 32 to 33E. During the formation of the bit line trench regions BTR, the lower storage node contact layer BCxL may be divided into the lower storage node contacts BCx, which are spaced apart from each other in the second direction D2 and extend in the third direction D3.

Next, the bit line spacer BSP, the bit line BL, and the bit line capping pattern BCP may be sequentially formed, and the method of forming each of them may be similar to that in the embodiment described with reference to FIGS. 32 to 33E.

Next, the fence pattern FN may be formed between the bit lines BL, which are adjacent to each other in the second direction D2. In an embodiment, the formation of the fence pattern FN may include performing a partial removal process on the lower storage node contacts BCx and the buffer pattern BP and forming the fence patterns FN in empty regions of the lower storage node contacts BCx and the buffer pattern BP which are formed by the partial removal process. During the formation of the fence patterns FN, each lower storage node contact BCx may be divided into the lower storage node contacts BCx, which are spaced apart from each other in the third direction D3.

Thereafter, the semiconductor device described with reference to FIGS. 10A and 10B may be formed using the fabricated method described above.

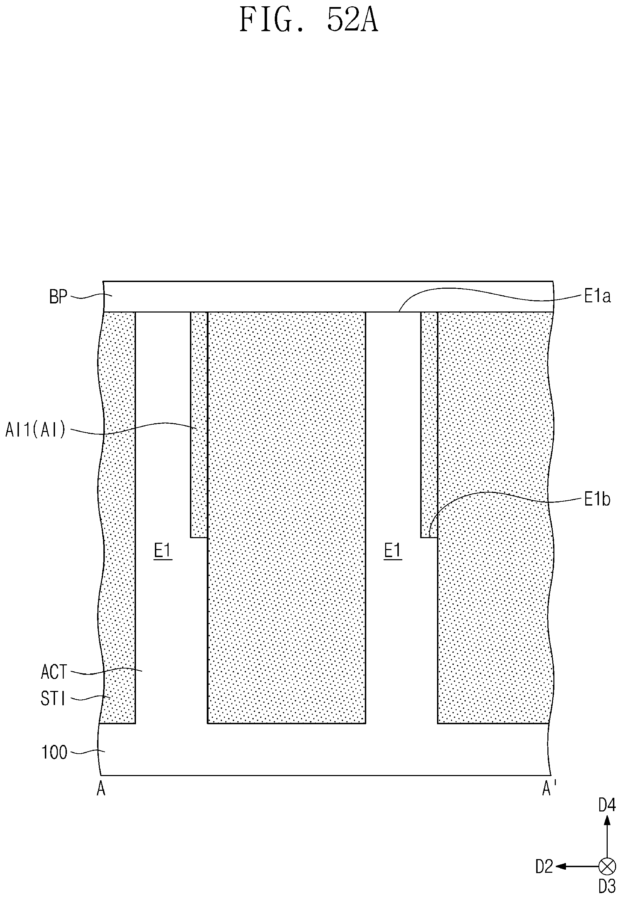

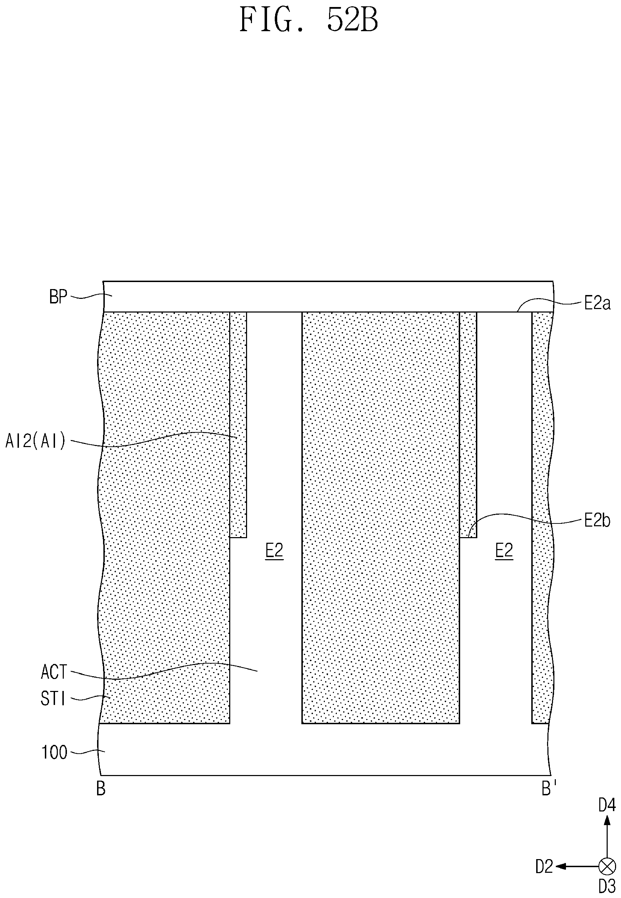

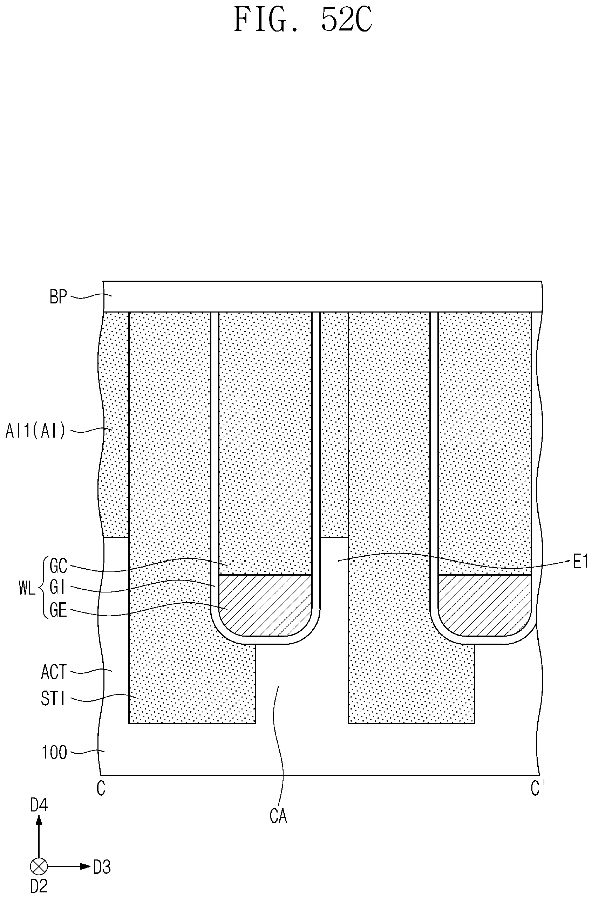

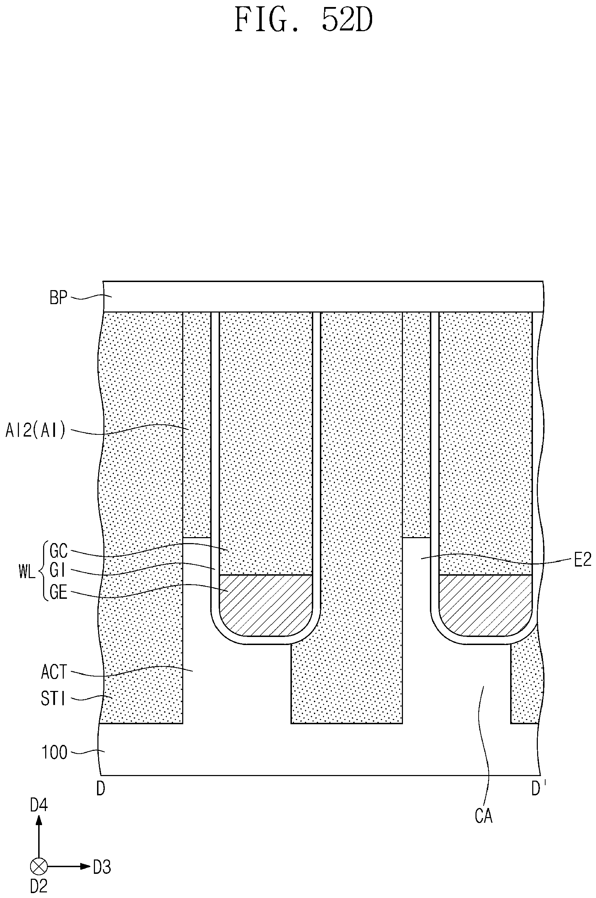

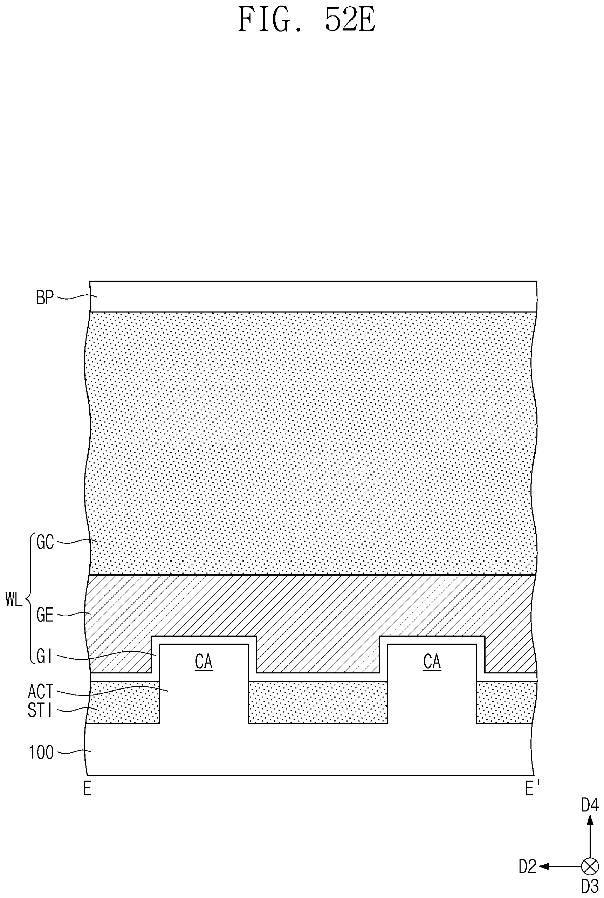

FIGS. 52A to 52E are diagrams illustrating a method of fabricating a semiconductor device, according to one or more embodiments of the disclosure. FIGS. 52A and 52E are cross-sectional views corresponding to lines A-A', B-B', C-C', D-D' and E-E' of FIG. 11 or FIG. 13, respectively.

Referring to FIG. 11 or FIG. 13 and FIGS. 52A to 52E, after the formation of the word line WL described with reference to FIGS. 30 to 31E, the process of forming the lower storage node contact BCx described with reference to FIGS. 30 to 31E may be omitted, and the buffer pattern BP may be formed to cover or at least partially cover the substrate 100. Each of the first and second active insulating patterns AI1 and AI2 may be formed to have a vertical length that is larger than that in the embodiment of FIGS. 28 to 29E. Thus, the second top surfaces E1b and E2b of the first and second edge portions E1 and E2 of the active pattern ACT may be formed at a level that is lower than that in the embodiment of FIGS. 28 to 29E.

After the formation of the buffer pattern BP, the bit line BL, the bit line capping pattern BCP, the mold pattern MP, the upper storage node contact BCy, and the data storage pattern DSP may be sequentially formed using the fabricated method described above, without an additional process for forming the lower storage node contact BCx, and in this case, the semiconductor device may be formed to have the structure described with reference to FIGS. 11 to 12D.

In an embodiment, for the semiconductor device described with reference to FIGS. 13 to 14E, the fabricating process may differ from the fabricated method described above, in some steps after the formation of the buffer pattern BP.

Referring to FIGS. 13 to 14E, the bit line trench region BTR, the bit line spacer BSP, the bit line BL, the bit line capping pattern BCP, and the mold pattern MP may be sequentially formed, and the formation of each of them may be similar to that in the embodiment described with reference to FIGS. 32 to 33E.

Next, the contact holes CH may be formed between the bit lines BL, which are adjacent to each other in the second direction D2. During the process of forming the contact holes CH, an upper portion of the second edge portion E2 of the active pattern ACT may be recessed to a specific depth and may be exposed to the outside. In an embodiment, the contact holes CH in a row may be formed to be arranged side by side in the second direction D2, and the contact holes CH in a column may be formed to be arranged side by side in the third direction D3.

The upper storage node contact BCy and the second silicide pattern SC may be formed in the contact holes CH. Next, the lower landing pad LPx may be formed to fill a remaining portion of the contact hole CH.

Thereafter, the upper landing pads LPy may be formed on the lower landing pads LPx. The formation of the upper landing pads LPy may include sequentially forming an upper landing pad layer and mask patterns to cover or at least partially cover top surfaces of the lower landing pads LPx and removing the upper landing pad layer through an anisotropic etching process using the mask patterns as an etch mask to form the upper landing pads LPy.

Next, the filling pattern FIL may be formed in a region, which is formed by removing the upper landing pad layer. The filling pattern FIL may be formed to enclose each of the upper landing pads LPy. The data storage patterns DSP may be formed on the upper landing pads LPy, respectively.

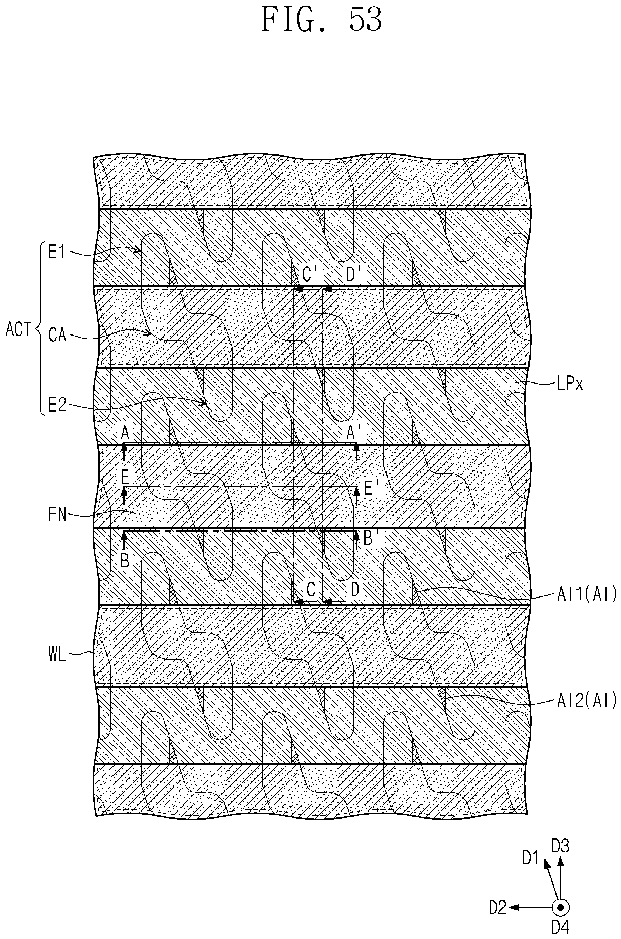

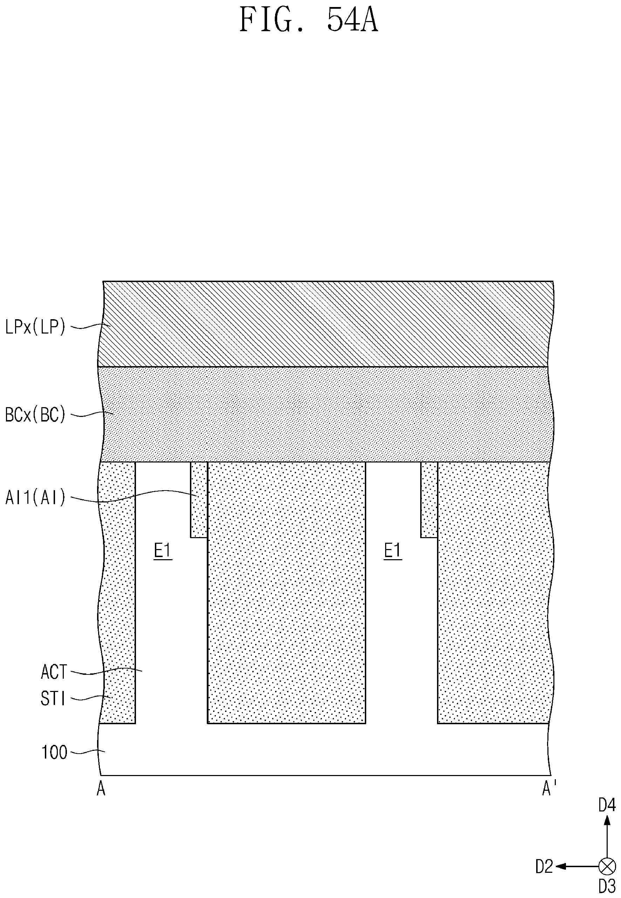

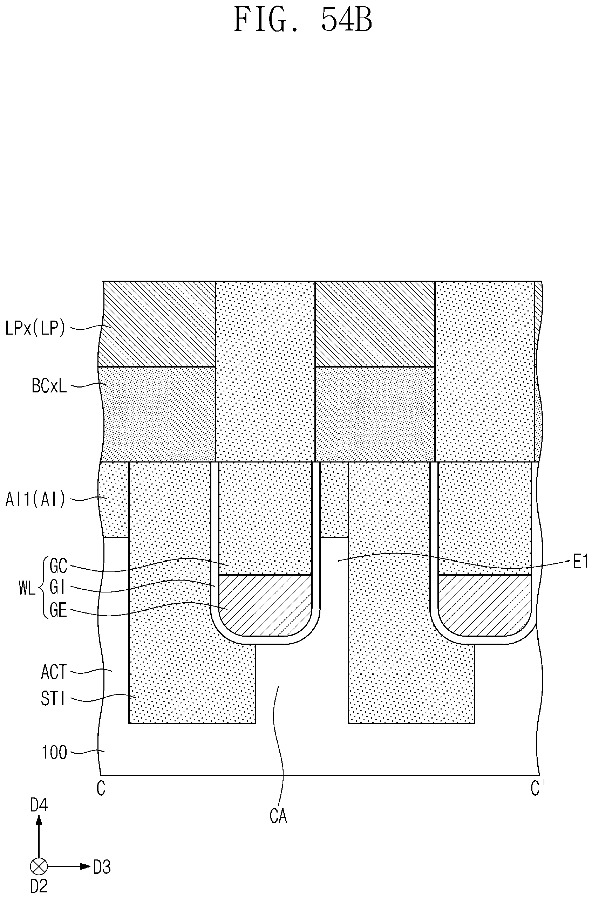

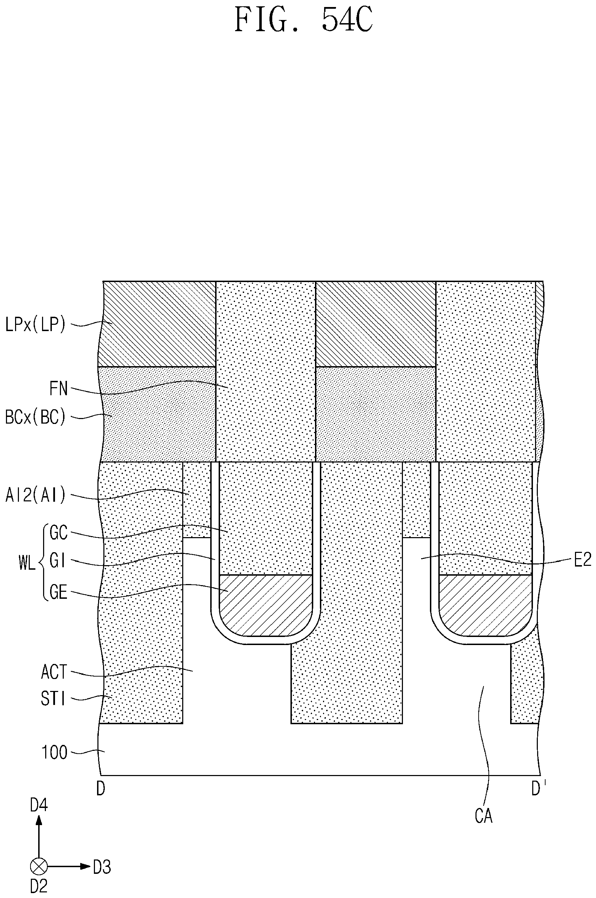

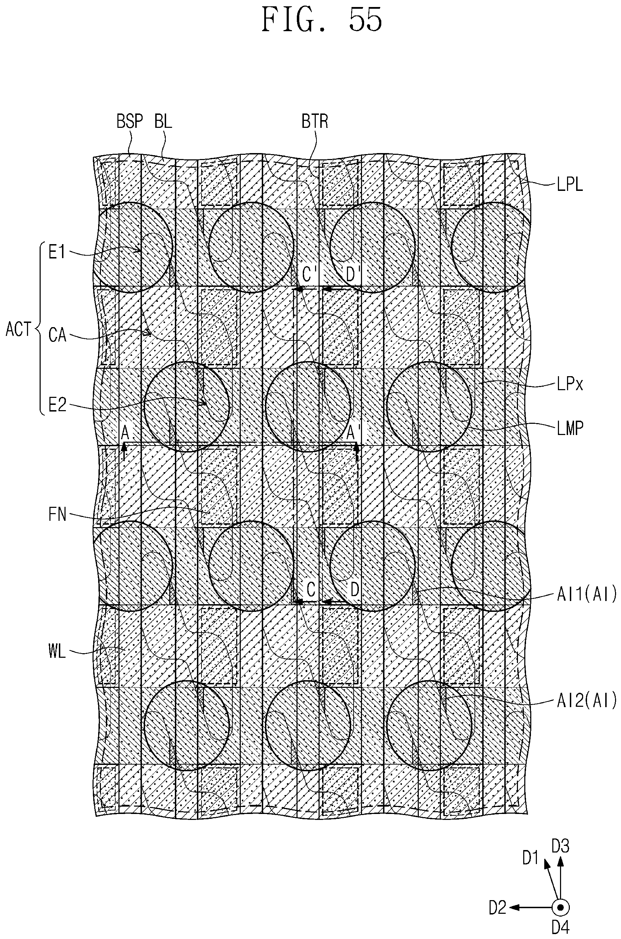

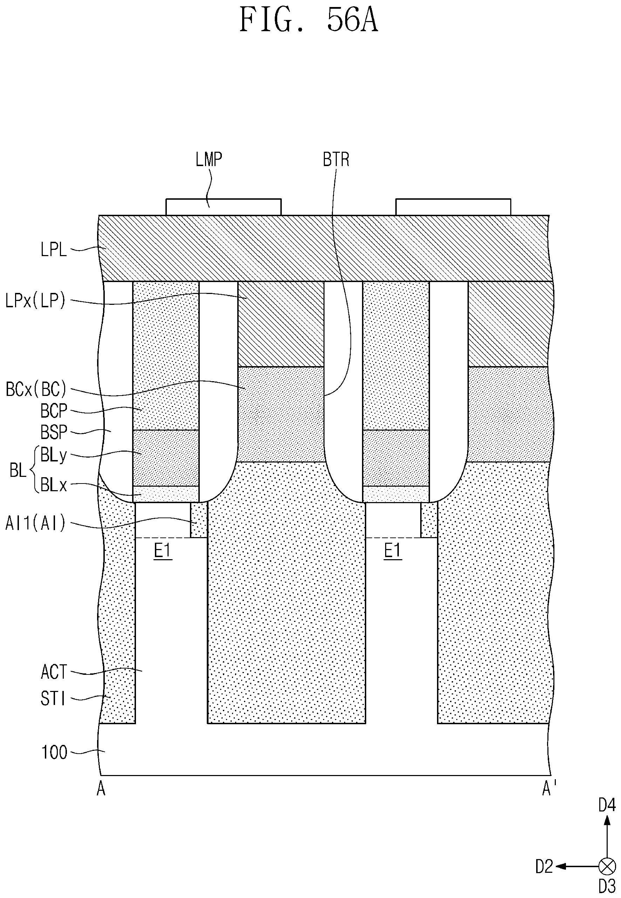

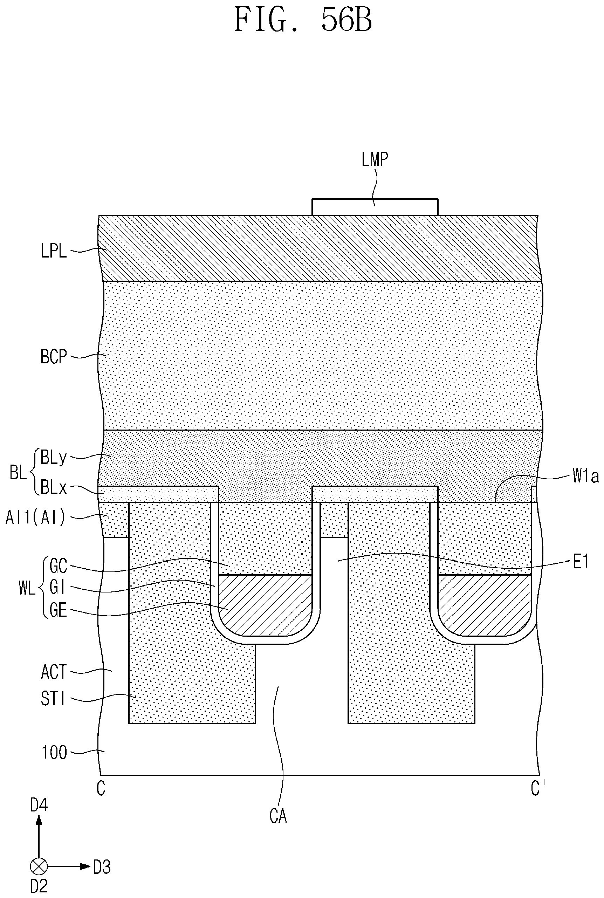

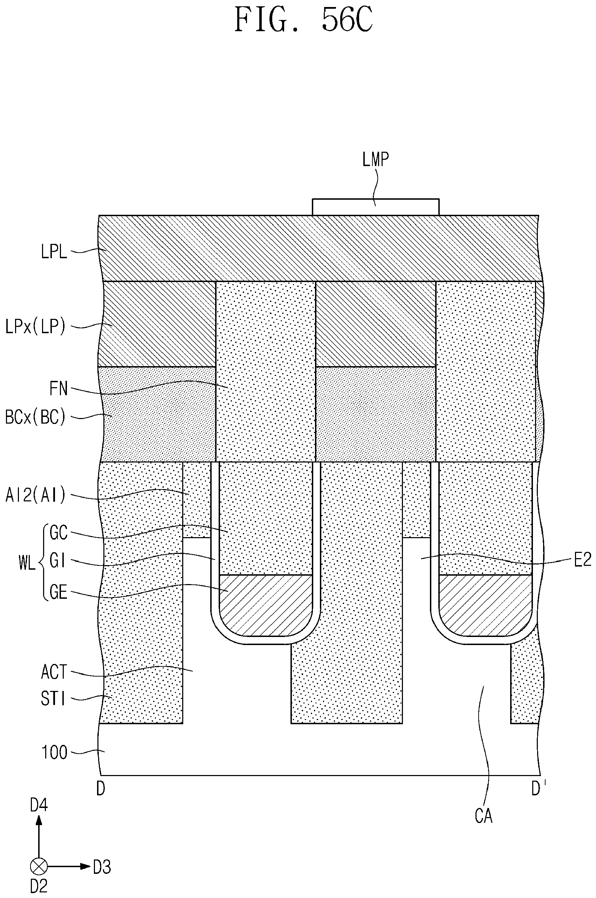

FIGS. 53 to 56C are diagrams illustrating a method of fabricating a semiconductor device, according to one or more embodiments of the disclosure. FIGS. 54A-54C are cross-sectional views taken along lines A-A', C-C' and D-D' of FIG. 53, respectively. FIGS. 56A-56C are cross-sectional views taken along lines A-A', C-C' and D-D' of FIG. 55, respectively.

Referring to FIGS. 53 to 54C, a lower storage node contact layer and a lower landing layer may be disposed, and sequentially stacked, on the substrate 100, after the formation of the word line WL described with reference to FIGS. 30 to 31E.

The fence pattern FN may be formed on the word line WL to extend in the second direction D2. The fence pattern FN may be formed to penetrate the lower storage node contact layer and the lower landing layer. Thus, the lower storage node contacts BCx may be formed to be spaced apart from each other in the third direction D3 and extend in the second direction D2, and the lower landing pads LPx may be formed to be spaced apart from each other in the third direction D3 and extend in the second direction D2.

Referring to FIGS. 55 to 56C, the process of forming the buffer pattern BP described with reference to FIGS. 32 to 33E may be omitted. The bit line trench region BTR, the bit line spacer BSP, the bit line BL, and the bit line capping pattern BCP may be sequentially formed, and the method of forming each of them may be similar to that in the embodiment described with reference to FIGS. 32 to 33E. During the formation of the bit line trench region BTR, each lower storage node contact BCx and each lower landing pad LPx may be respectively divided into the lower storage node contacts BCx, which are spaced apart from each other in the second direction D2, and into the lower landing pads LPx, which are spaced apart from each other in the second direction D2.

Thereafter, the process of forming the mold pattern MP described with reference to FIGS. 32 to 33E may be omitted. In addition, the process of forming the upper storage node contact BCy and the second silicide pattern SC described with reference to FIGS. 1A and 2A to 2E may be omitted.

An upper landing pad layer LPL may be formed to cover or at least partially cover the top surface of the substrate 100. Landing pad mask patterns LMP may be formed on the upper landing pad layer LPL. In a plan view, the arrangement of the landing pad mask patterns LMP may be similar to that of the contact holes CH described with reference to FIGS. 1A and 2A to 2E. The landing pad mask patterns LMP may be linearly arranged in the second direction D2 and may be arranged in a zigzag shape in the third direction D3.

Referring to FIGS. 15 to 16D, the upper landing pads LPy may be formed by etching the upper landing pad layer LPL using the landing pad mask patterns LMP as an etch mask.

Next, the filling pattern FIL may be formed by an empty region that is formed by removing the upper landing pad LPy. The filling pattern FIL may be formed to enclose each of the upper landing pads LPy. The data storage patterns DSP may be formed on the upper landing pads LPy, respectively.

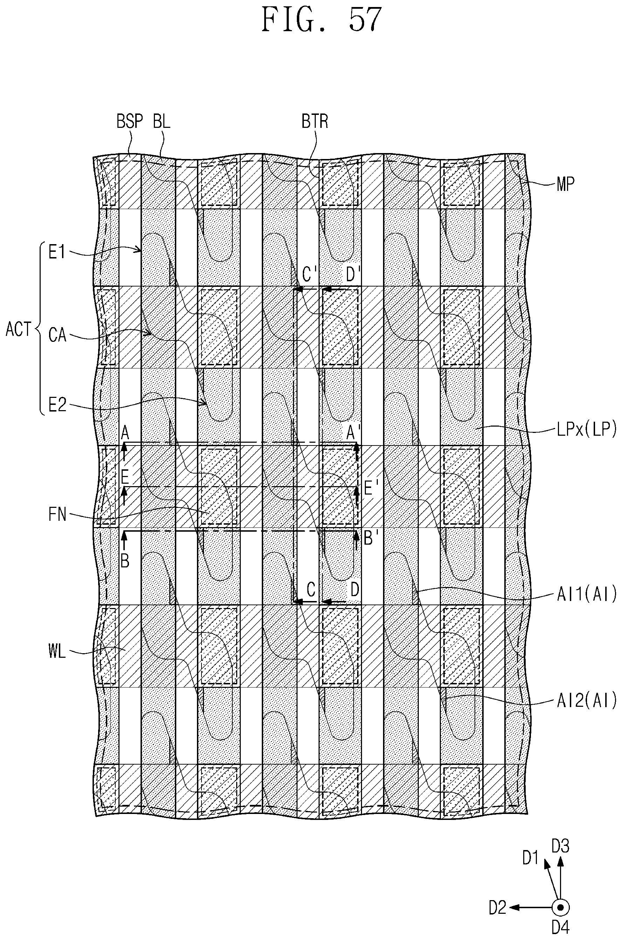

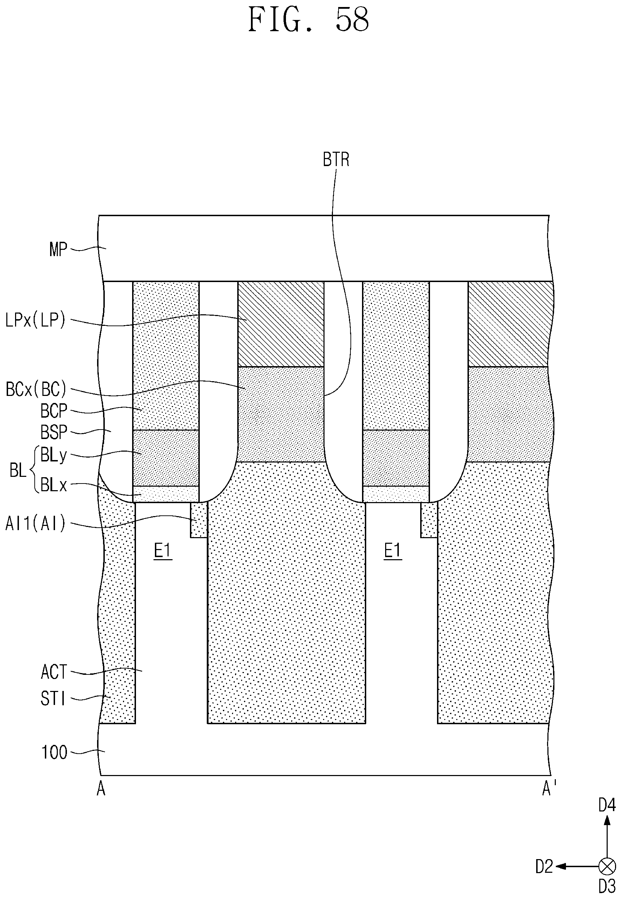

FIGS. 57 and 58 are diagrams illustrating a method of fabricating a semiconductor device, according to one or more embodiments of the disclosure. FIG. 58 is a cross-sectional view taken along line A-A' of FIG. 57.

Referring to FIGS. 57 and 58, the mold pattern MP may be formed on the substrate 100, after the formation of the bit line capping pattern BCP described with reference to FIGS. 55 to 56C.

Referring to FIGS. 17 and 18, the contact holes CH may be formed to penetrate the mold pattern MP. The formation of the contact holes CH may be similar to that in the embodiment described with reference to FIGS. 1A and 2A to 2E.

Thereafter, the process of forming the upper storage node contacts BCy and the second silicide patterns SC described with reference to FIGS. 1A and 2A to 2E may be omitted.

The upper landing pads LPy may be formed to fill respective remaining portions of the contact holes CH. The upper landing pad LPy may have a top surface that is located at substantially the same level as the top surface of the mold pattern MP and is coplanar with the top surface of the mold pattern MP. The data storage patterns DSP may be formed on the upper landing pads LPy, respectively.

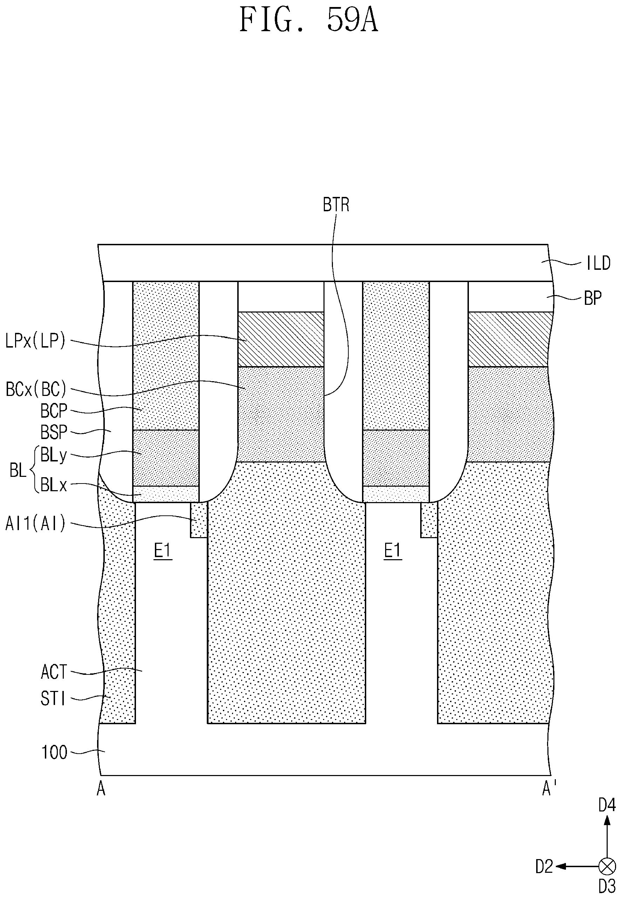

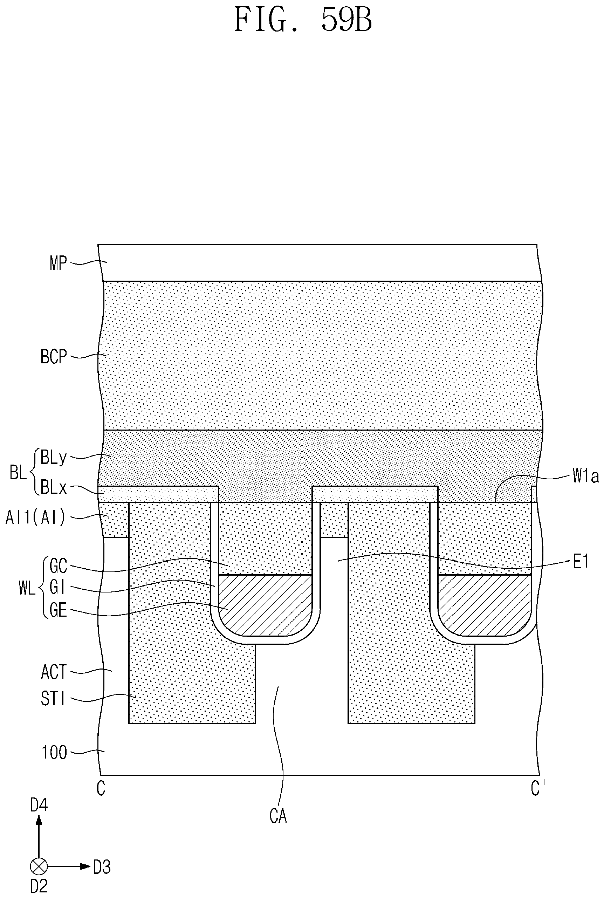

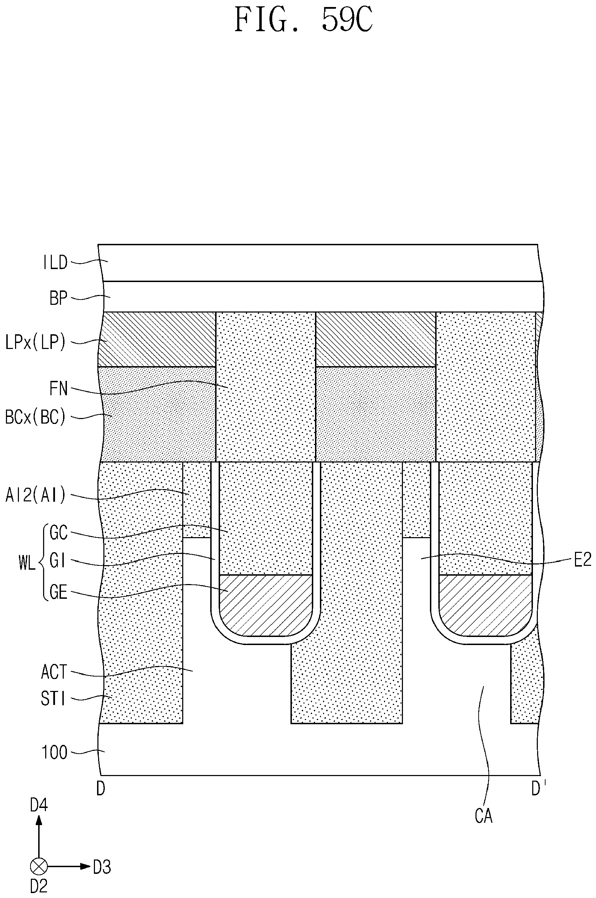

FIGS. 59A to 59C are diagrams illustrating a method of fabricating a semiconductor device, according to one or more embodiments of the disclosure. FIGS. 59A to 59C are cross-sectional views corresponding to lines A-A', C-C' and D-D' of FIG. 53, respectively.

Referring to FIGS. 53 and 59A to 59C, the buffer pattern BP may be formed on the lower landing pads LPx, after the formation of the lower landing pads LPx described with reference to FIGS. 53 to 54C.

The bit line trench region BTR, the bit line spacer BSP, the bit line BL, and the bit line capping pattern BCP may be sequentially formed, and the method of forming each of them may be similar to that in the embodiment described with reference to FIGS. 32 to 33E. The process of forming the mold pattern MP described with reference to FIGS. 32 to 33E may be omitted. Thereafter, the interlayer insulating layer ILD may be formed on the substrate 100.

Referring to FIGS. 18 to 19E, the contact holes CH may be formed to penetrate the interlayer insulating layer ILD. The formation of the contact holes CH may be similar to that in the embodiment described with reference to FIGS. 1A and 2A to 2E.

The process of forming each of the upper storage node contact BCy, the second silicide pattern SC, and the landing pad LP described with reference to FIGS. 1A and 2A to 2E may be omitted.

The bottom electrodes BE may be formed on the contact holes CH. The formation of the bottom electrodes BE may include forming a bottom electrode layer to fill the contact holes CH and cover or at least partially cover the top surface of the interlayer insulating layer ILD and removing a portion of the bottom electrode layer to form the bottom electrodes BE. The bottom electrode BE may include the lower and upper portions BEx and BEy.

The dielectric layer DL may be formed to conformally cover or at least partially cover the top surface of the interlayer insulating layer ILD and the upper portions BEy of the bottom electrodes BE. Thereafter, the top electrode TE may be formed between the upper portions BEy of the bottom electrodes BE and on the upper portions BEy of the bottom electrodes BE.

According to an embodiment of the disclosure, the disposition of elements in a semiconductor device may be simplified. Accordingly, a patterning process, which is performed to fabricate a semiconductor device, may be reduced in difficulty, and consequently the semiconductor device may be more easily fabricated. In addition, since the elements can be disposed in a relatively simple manner, an integration density of the semiconductor device may also be increased.

According to an embodiment of the disclosure, each of first and second edge portions of an active pattern may include a recessed region. Thus, the first edge portion may be placed relatively far from a storage node contact, and the second edge portion may be placed relatively far from a bit line. As a result, an electric interference issue between the first edge portion and the storage node contact and an electric interference issue between the second edge portion and the bit line may be prevented. Thus, the electrical and reliability characteristics of the semiconductor device may be improved.

Further embodiments are set out in the following clauses:
Clause 1. A semiconductor device, comprising:
   an active pattern comprising a first edge portion and a second edge portion spaced apart from the first edge portion in a first direction;
   a word line between the first edge portion and the second edge portion and extending in a second direction intersecting the first direction;
   a bit line on the first edge portion and extending in a third direction intersecting the first direction and the second direction; and
   a storage node contact on the second edge portion,
   wherein the first edge portion comprises a first side surface and a second side surface,
   wherein the second side surface of the first edge portion is closer to the second edge portion than the first side surface of the first edge portion,
   wherein the first side surface of the first edge portion has a linear profile, and
   wherein the second side surface of the first edge portion has a stepwise profile.
Clause 2. The semiconductor device of clause 1, wherein the first edge portion comprises a concave portion.
Clause 3. The semiconductor device of clause 1 or clause 2, further comprising a first active insulating pattern filling the concave portion of the first edge portion.
Clause 4. The semiconductor device of any of clauses 1-3, wherein the second edge portion comprises a first side surface and a second side surface,
   wherein the second side surface of the second edge portion is closer to the first edge portion than the first side surface of the second edge portion,
   wherein the first side surface of the second edge portion has a linear profile, and
   wherein the second side surface of the second edge portion has a stepwise profile.
Clause 5. A semiconductor device, comprising:
   a first active pattern comprising a first edge portion and a second edge portion spaced apart from the first edge portion in a first direction;
   a word line between the first edge portion and the second edge portion and extending in a second direction intersecting the first direction;
   a bit line on the first edge portion and extending in a third direction intersecting the first direction and the second direction; and
   a storage node contact on the second edge portion,
   wherein the first edge portion comprises an upper portion and a lower portion, and
   wherein the upper portion of the first edge portion is recessed in the second direction such that a width of the upper portion of the first edge portion in the second direction is less than a width of the lower portion of the first edge portion in the second direction.
Clause 6. The semiconductor device of clause 5, wherein the upper portion of the first edge portion and the lower portion of the first edge portion are directly connected without an interface therebetween.
Clause 7. The semiconductor device of clause 5 or clause 6, wherein the upper portion of the first edge portion contacts the lower portion of the first edge portion at a first level, and
   wherein the width of the upper portion of the first edge portion is smaller than the width of the lower portion of the first edge portion at the first level in the second direction.
Clause 8. The semiconductor device of any of clauses 5-7, wherein the first edge portion comprises a first side surface and a second side surface,
   wherein the second side surface of the first edge portion is closer to the second edge portion than the first side surface of the first edge portion,
   wherein the first side surface of the first edge portion has a linear profile, and
   wherein the second side surface of the first edge portion has a stepwise profile.
Clause 9. The semiconductor device of any of clauses 5-8, wherein the second edge portion comprises an upper portion and a lower portion, and
   wherein the upper portion of the second edge portion is recessed in a fourth direction opposite the second direction such that a width of the upper portion of the second edge portion in the fourth direction is less than a width of the lower portion of the second edge portion in the fourth direction.
Clause 10. The semiconductor device of clause 9, further comprising:
   a first active insulating pattern on a side surface of the upper portion of the first edge portion; and
   a second active insulating pattern on a side surface of the upper portion of the second edge portion.

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the scope of the following claims.

## Claims

1. A semiconductor device, comprising:
a first active pattern comprising a first edge portion and a second edge portion spaced apart from the first edge portion in a first direction;
a first word line between the first edge portion and the second edge portion and extending in a second direction intersecting the first direction;
a bit line on the first edge portion and extending in a third direction intersecting the first direction and the second direction; and
a storage node contact on the second edge portion,
wherein the first edge portion comprises a first top surface and a second top surface,
wherein the second top surface of the first edge portion is closer to the second edge portion than the first top surface of the first edge portion, and
wherein the first top surface of the first edge portion is at a level that is higher than a level of the second top surface of the first edge portion.

2. The semiconductor device of claim 1, wherein the second edge portion comprises a first top surface and a second top surface,
wherein the second top surface of the second edge portion is closer to the first edge portion than the first top surface of the second edge portion, and
wherein the first top surface of the second edge portion is at a level higher than a level of the second top surface of the second edge portion.

3. The semiconductor device of claim 2, wherein a bottom surface of the bit line is at a level lower than the level of the first top surface of the second edge portion.

4. The semiconductor device of claim 2 or claim 3, further comprising:
a first active insulating pattern on the second top surface of the first edge portion; and
a second active insulating pattern on the second top surface of the second edge portion.

5. The semiconductor device of any preceding claim, wherein the storage node contact is vertically above a portion of the bit line.

6. The semiconductor device of any preceding claim, wherein the first edge portion comprises an upper portion and a lower portion, and
wherein the upper portion of the first edge portion is recessed in the second direction such that a width of the upper portion of the first edge portion in the second direction is less than a width of the lower portion of the first edge portion in the second direction.

7. The semiconductor device of any preceding claim, wherein the first edge portion comprises a first side surface and a second side surface,
wherein the second side surface of the first edge portion is closer to the second edge portion than the first side surface of the first edge portion,
wherein the first side surface of the first edge portion has a linear profile, and
wherein the second side surface of the first edge portion has a stepwise profile.

8. The semiconductor device of any preceding claim, further comprising:
a second active pattern adjacent to the first active pattern in the second direction;
a third active pattern adjacent to the second active pattern in the third direction; and
a fourth active pattern adjacent to the first active pattern in the third direction,
wherein a second edge portion of the fourth active pattern, the first edge portion of the first active pattern, a second edge portion of the third active pattern, and a first edge portion of the second active pattern are sequentially arranged in the second direction.

9. The semiconductor device of claim 8, wherein the semiconductor device further comprises a second word line adjacent to the first word line in the third direction,
wherein the first word line crosses the first active pattern and the second active pattern, and
wherein the second word line crosses the third active pattern and the fourth active pattern.
